# EUROPEAN PATENT APPLICATION

(11) **EP 4 825 942 A1**
(43) Date of publication of application: **21.10.2026**
(21) Application number: 26172340.7
(22) Date of filing: 14.04.2026
(51) Int. Cl.: C09K 11/02, C01G 15/00, C09K 11/08, C09K 11/62, H10H 20/851, H10H 20/81

(54) **SEMICONDUCTOR NANOPARTICLE, METHOD OF PRODUCING THE SAME AND ELECTRONIC DEVICE INCLUDING THE SAME**

(30) Priority: 15.04.2025 KR 20250048886
(71) Applicant: Samsung Electronics Co., Ltd., Suwon-si, Gyeonggi-do 16677 (KR)
(72) Inventor: LIM, Mi Hye, 16678 Suwon-si (KR); WON, Nayoun, 16678 Suwon-si (KR); CHAE, Byeong Gyu, 16678 Suwon-si (KR); JO, A Ra, 16678 Suwon-si (KR); LEE, Junho, 16678 Suwon-si (KR); YUN, Dongjin, 16678 Suwon-si (KR); PARK, Sung Jun, 16678 Suwon-si (KR); KWON, Soo Kyung, 16678 Suwon-si (KR); WON, Jong Hoon, 16678 Suwon-si (KR); PARK, Hyokeun, 16678 Suwon-si (KR)
(74) Representative: Elkington and Fife LLP

(57) **Abstract**

A semiconductor nanoparticle, a method of preparing the semiconductor nanoparticle, and a display device including the semiconductor nanoparticle. The semiconductor nanoparticle includes silver, indium, gallium, and sulfur, and as a radial concentration distribution of silver, indium, and gallium is measured, the semiconductor nanoparticle exhibits a maximum value of a mole ratio of gallium to a total of indium and gallium in a first zone, and in the first zone, a mole ratio of silver to the total of indium and gallium is greater than or equal to about 0.18:1 and less than 1.5:1, and the semiconductor nanoparticle exhibits a quantum yield of greater than or equal to about 85%.

## Description

### FIELD OF THE INVENTION

A semiconductor nanoparticle, a method of producing the semiconductor nanoparticle, an ink composition including the semiconductor nanoparticle, a semiconductor nanoparticle composite, a display device including the semiconductor nanoparticle, and an electronic device including the semiconductor nanoparticle are disclosed.

### BACKGROUND OF THE INVENTION

A semiconductor nanoparticle may exhibit different aspects, characteristics, or properties compared to a corresponding bulk material having substantially the same composition. For example, the semiconductor nanoparticle may have different physical properties based on the nanostructure (e.g., bandgap energy, a luminescent property, or the like). The semiconductor nanoparticle may be configured to emit light upon excitation by incident light or an applied voltage. The luminescent nanostructure may find applicability in a variety of devices (e.g., a display panel or an electronic device including the display panel). From an environmental point of view, developing a luminescent nanoparticle that does not contain a harmful heavy metal such as cadmium, and still achieves comparable or an improvement in one or more luminescent or optical properties is of interest.

### SUMMARY OF THE INVENTION

An embodiment is directed to a semiconductor nanoparticle exhibiting an improved optical property.

An embodiment is directed to a method of manufacturing (making) the semiconductor nanoparticle or a population of the nanoparticles.

An embodiment is directed to a composition (e.g., an ink composition) or a composite including the semiconductor nanoparticle.

An embodiment is directed to a color conversion panel including the semiconductor nanoparticle or the semiconductor nanoparticle composite.

An embodiment is directed to an electronic device (e.g., a display device) including the semiconductor nanoparticle or the semiconductor nanoparticle composite or the color conversion panel.

In an embodiment, a semiconductor nanoparticle includes silver, indium, gallium, and sulfur, and the semiconductor nanoparticle exhibits a maximum value of a mole ratio of gallium to a total of indium and gallium (hereinafter, also referred to as Ga:(In+Ga)) in a first zone (e.g., spaced apart from a center thereof) as a concentration distribution of individual elements (e.g., silver, indium, and gallium) in a radial direction in the semiconductor nanoparticle is measured, and in the first zone, a mole ratio of silver to a total of indium and gallium (hereinafter, also referred to as Ag:(In+Ga)) is greater than or equal to about 0.18:1. The mole ratio of silver to a total of indium and gallium may be less than or equal to about 1.5:1. The semiconductor nanoparticle exhibits a quantum yield of greater than or equal to about 85%. The semiconductor nanoparticle may have a gradient concentration distribution of silver, indium, and/or gallium in a radial direction (for example, from a center portion of the semiconductor nanoparticle to a perimeter surface).

A maximum value of a mole ratio of gallium to a total of indium and gallium (Ga:(In+Ga)) in the first zone may be greater than or equal to about 0.75:1, greater than or equal to about 0.8:1, or greater than or equal to about 0.82:1. The maximum value of the mole ratio of gallium to a total of indium and gallium may be less than or equal to about 0.99:1 or less than or equal to about 0.95:1. The maximum value of the mole ratio of gallium to a total of indium and gallium (Ga:(In+Ga)) may be greater than or equal to about 0.8:1, or greater than or equal to about 0.82:1, and less than about 1:1, or less than or equal to about 0.98:1.

In the first zone, a mole ratio of silver to a total of indium and gallium may be greater than or equal to about 0.19:1, greater than or equal to about 0.2:1, or greater than or equal to about 0.25:1. The mole ratio of silver to a total of indium and gallium may be less than or equal to about 1.5:1, less than or equal to about 1.4:1, less than or equal to about 1.3:1, less than or equal to about 1.2:1, less than or equal to about 1:1, less than or equal to about 0.9:1, or less than or equal to about 0.5:1. In the first zone, the mole ratio of silver to a total of indium and gallium may be greater than or equal to about 0.19:1 and less than or equal to about 1:1. In the first zone, the mole ratio of silver to a total of indium and gallium may be greater than or equal to about 0.2:1 and less than or equal to about 0.9:1.

The mole ratio of silver to a total of indium and gallium in the first zone may be less than a mole ratio of silver to a total of indium and gallium at a center of the semiconductor nanoparticle.

A difference between a maximum value of a mole ratio of silver to a total of indium and gallium in the particle and a mole ratio of silver to a total of indium and gallium in the first zone may be greater than or equal to about 0.05:1, greater than or equal to about 0.1:1, greater than or equal to about 0.3:1, or greater than or equal to about 0.5:1. The difference between the maximum value of the mole ratio of silver to a total of indium and gallium in the particle and the mole ratio of silver to a total of indium and gallium in the first zone may be less than or equal to about 0.9:1, less than or equal to about 0.6:1, less than or equal to about 0.3:1, or less than or equal to about 0.1:1.

In the first zone, a difference between the mole ratio of Ag:(In+Ga) and the maximum value of Ga:(In+Ga) may be greater than or equal to about 0.1:1, greater than or equal to about 0.3:1, or greater than or equal to about 0.5:1. In the first zone, a difference between the maximum value of Ga:(In+Ga) and the mole ratio of Ag:(In+Ga) may be less than or equal to about 0.9:1, less than or equal to about 0.8:1, or less than or equal to about 0.6:1.

The semiconductor nanoparticle may include a core (including a first semiconductor nanocrystal) including silver, indium, gallium, and sulfur; and a semiconductor nanocrystal shell including (a second semiconductor nanocrystal including) silver, gallium, and sulfur, the semiconductor nanocrystal shell disposed on the core.

The core may have a radius that is greater than or equal to about 0.5 nanometers (nm), or greater than or equal to about 1 nm and less than or equal to about 2.5 nm, less than or equal to about 2 nm, or less than or equal to about 1.75 nm. In the core, a mole ratio of gallium to a total of indium and gallium may be greater than or equal to about 0.35:1, or greater than or equal to about 0.4:1 and less than or equal to about 0.8:1, or less than or equal to about 0.6:1.

The semiconductor nanoparticle may have a gradient concentration distribution of individual elements (silver, indium, and/or gallium) in a radial direction of the core. The semiconductor nanoparticle may have a gradient concentration distribution of silver, indium, and/or gallium in a radial direction (for example, from a center portion of the semiconductor nanoparticle to a perimeter surface).

As a radial concentration distribution of individual elements the core is measured, in the core, a minimum value of a mole ratio of gallium to a total of indium and gallium may be greater than or equal to about 0.1:1, greater than or equal to about 0.3:1, greater than or equal to about 0.5:1, or greater than or equal to about 0.6:1. In the core, the minimum value of the mole ratio of gallium to a total of indium and gallium may be less than or equal to about 0.85:1 or less than or equal to about 0.75:1. In the core, the minimum value of the mole ratio of gallium to a total of indium and gallium may exist in a portion having a radius of less than or equal to about 1 nm, less than or equal to about 0.5 nm, or less than or equal to about 0.3 nm from a center of the core.

In semiconductor nanocrystal shell, a mole ratio of gallium to a total of indium and gallium may be greater than or equal to about 0.6:1 or greater than or equal to about 0.7:1. In semiconductor nanocrystal shell, the mole ratio of gallium to a total of indium and gallium may be less than or equal to about 1:1 or less than or equal to about 0.99:1.

The semiconductor nanocrystal shell may have a thickness of greater than or equal to about 0.5 nm and less than or equal to about 4 nm.

The first zone may exist in the semiconductor nanocrystal shell.

In the semiconductor nanoparticle, a mole ratio of gallium to a total of indium and gallium may be greater than or equal to about 0.79:1, or greater than or equal to about 0.85:1 and less than or equal to about 0.99:1, or less than or equal to about 0.95:1.

In the semiconductor nanoparticle, a mole ratio of silver to a total of indium and gallium may be greater than or equal to about 0.5:1, greater than or equal to about 0.6:1, or greater than or equal to about 0.66:1, and less than or equal to about 1.5:1, less than or equal to about 1:1, or less than or equal to about 0.95:1.

In the semiconductor nanoparticle, a mole ratio of silver to a total of indium, gallium, and silver may be greater than or equal to about 0.4:1 and less than or equal to about 0.5:1.

The semiconductor nanoparticle may exhibit a quantum yield of greater than or equal to about 86% or greater than or equal to about 88%.

The semiconductor nanoparticle is configured to emit a first light, and the first light may have a peak emission wavelength of greater than or equal to about 500 nm and less than or equal to about 560 nm.

An emission spectrum of the first light may have a full width at half maximum of greater than or equal to about 5 nm and less than or equal to about 50 nm, or less than or equal to about 35 nm.

In an embodiment an ink composition may include the aforementioned semiconductor nanoparticle and a liquid vehicle. The semiconductor nanoparticle may be dispersed within the liquid vehicle. The liquid vehicle may include a polymerizable (or liquid) monomer, an organic solvent, or a combination thereof. The ink composition may be substantially free of a volatile organic solvent. The ink composition may further include a metal oxide nanoparticle.

In an aspect, a semiconductor nanoparticle composite may include a matrix and the semiconductor nanoparticle, wherein the semiconductor nanoparticle is dispersed in the matrix. The semiconductor nanoparticle composite may be a patterned film. The semiconductor nanoparticle composite may be a sheet in which first semiconductor nanoparticles emitting a first light and second semiconductor nanoparticles emitting a second light are mixed, wherein the first light and the second light may be different.

In an embodiment, the semiconductor nanoparticle composite may exhibit an internal quantum efficiency (IQE) or an external quantum efficiency (EQE) of greater than or equal to about 50% and the IQE and the EQE are defined by the following equations, respectively: $Internal quantum efficiency \left(IQE, %\right) = \left[A/\left(B-B′\right)\right] \times 100$ $External quantum efficiency \left(EQE, %\right) = \left[A/B\right] \times 100$ wherein:
A: amount of a first light emitted from the semiconductor nanoparticle or the semiconductor nanoparticle composite
B: amount of irradiated incident light provided to the semiconductor nanoparticle composite
B': amount of the irradiated incident light passing through the semiconductor nanoparticle composite.

The semiconductor nanoparticle composite may be configured such that an incident light absorbance defined by the following equation exhibits greater than or equal to about 90%: $Incident light absorbance = \left[\left(B-B′\right)/B\right] \times 100 \left(%\right)$
B: amount of irradiated incident light provided to the semiconductor nanoparticle composite
B': amount of the irradiated incident light passing through the semiconductor nanoparticle composite.

The semiconductor nanoparticle composite may be heat-treated at 180°C for 30 minutes, and a process maintenance percentage of the semiconductor nanoparticle composite obtained by the following equation may be greater than or equal to about 75%, or greater than or equal to about 80%: $Process maintenance percentage \left(%\right) = \left[QE2/QE1\right] \times 100 .$ wherein
QE1: quantum efficiency (e.g., the IQE or EQE) of the semiconductor nanoparticle composite before the heat treatment
QE2: quantum efficiency (e.g., the IQE or EQE) of the semiconductor nanoparticle composite after the heat treatment.

The quantum efficiency may be the IQE or the EQE.

The process maintenance percentage may be greater than or equal to about 77% to about 130%, greater than or equal to about 81% to about 100%, or a range of any combinations thereof.

An embodiment provides a color conversion layer or a color conversion structure (hereinafter, abbreviated as a color conversion layer) including the semiconductor nanoparticle or a color conversion region including the same.

In an embodiment, a color conversion panel includes a color conversion layer including a color conversion region, and the color conversion region includes a first region corresponding to a first pixel and including a semiconductor nanoparticle, the semiconductor nanoparticle including silver, indium, gallium, and sulfur, and as a concentration distribution of individual elements (e.g., silver, indium, and gallium) in a radial direction in the semiconductor nanoparticle is measured, the semiconductor nanoparticle exhibits a maximum value of a mole ratio of gallium to a total of indium and gallium (hereinafter, also referred to as Ga:(In+Ga)) in a first zone (e.g., spaced apart from a center thereof), and in the first zone, a mole ratio of silver to a total of indium and gallium (hereinafter, also referred to as Ag:(In+Ga)) is greater than or equal to about 0.18:1. The semiconductor nanoparticle may exhibit a quantum yield of greater than or equal to about 85%. The Ag:(In+Ga) may be less than or equal to about 1.5:1.

The first region may include a first composite configured to emit a first light, and the first composite may include a matrix and the semiconductor nanoparticle dispersed in the matrix.

Details of the semiconductor nanoparticle are as described herein.

In an embodiment, a display device (or a display panel) includes the semiconductor nanoparticle (or a composite including the same, a color conversion layer, a color conversion panel, or the like). The display device may further include a light source (or a light emitting panel). The display device may further include a light transmitting layer (or an optical element) between the light source (or the light emitting panel) and the color conversion layer (or the color conversion panel).

The light emitting panel (or the light source) may be configured to provide incident light to the color conversion layer (or the color conversion panel). The incident light may include blue light and optionally green light. The blue light may have a peak wavelength in a range of 440 nm to 460 nm or 450 nm to 455 nm.

The light source may include an organic light emitting diode (OLED), a micro LED, a mini LED, a nanorod-containing LED, or a combination thereof.

In an embodiment, an electronic device (or a display device) includes the color conversion panel or the display panel.

In an embodiment, the electronic device or the display device may include a display device for augmented reality/virtual reality device, a mobile terminal device, a monitor, a notebook, a television, an electronic signboard, a camera, or an in-vehicle electronic component.

The semiconductor nanoparticle of an embodiment may be provided in a form of a composite while having improved optical property (e.g., luminous efficiency). The semiconductor nanoparticle of an embodiment may contribute to providing a color conversion panel or a display device capable of realizing improved quality (e.g., display quality).

### BRIEF DESCRIPTION OF THE DRAWINGS

The above and other aspects, features, and advantages of certain exemplary embodiments will be more apparent from the following detailed description taken in conjunction with the accompanying drawings.
FIG. 1A is a flowchart showing pattern formation process (e.g., photolithography method) using the ink composition of an embodiment.
FIG. 1B is a flowchart showing a pattern forming process (inkjet method) using the ink composition of an embodiment.
FIG. 2A is a schematic cross-sectional representation of a color conversion panel according to an embodiment.
FIG. 2B is a cross-sectional representation of an electronic device (or display device) including a color conversion panel according to an embodiment.
FIG. 3A is a perspective representation illustrating a display panel including a color conversion panel according to an embodiment.
FIG. 3B is an exploded representation of a display device according to an embodiment.
FIG. 3C is a cross-sectional representation of the display panel of FIG. 3A.
FIG. 4 is an exploded representation of a display panel according to an embodiment.
FIG. 5A is a plan view illustrating a pixel arrangement of the display panel of FIG.3A.
FIGS. 5B, 5C, 5D, and 5E are cross-sectional representations showing light emitting devices, respectively, according to an embodiment.
FIG. 6 is a cross-sectional representation of the display panel of FIG. 5A taken along line IV-IV.
FIG. 7A is a schematic cross-sectional representation of a display device (e.g., a liquid crystal display device) according to an embodiment.
FIG. 7B is a schematic cross-sectional representation of an electronic device (e.g., a light emitting device) according to an embodiment.
FIG. 8A, FIG. 8B, and FIG. 8C show results of APT analysis of a semiconductor nanoparticle (QD1) prepared in Example 1.
FIG. 9A, FIG. 9B, and FIG. 9C show results of APT analysis of a semiconductor nanoparticle (QD2) prepared in Example 1.
FIG. 10A shows a result of EELS analysis of a semiconductor nanoparticle prepared in Example 1.
FIG. 10B shows a result of EELS analysis of a semiconductor nanoparticle prepared in Example 2.
FIG. 11 shows a result of EELS analysis of a semiconductor nanoparticle prepared in Comparative Example 1.

### DETAILED DESCRIPTION

Advantages and features of the techniques described hereinafter, and methods of achieving them, will become apparent with reference to the exemplary embodiments described below in further detail in conjunction with the accompanying drawings. However, the embodiments should not be construed as being limited to the exemplary embodiments set forth herein. If not defined otherwise, all terms (including technical and scientific terms) as used herein may be defined as commonly understood by one having ordinary skill in the art. The terms defined in a generally-used dictionary may not be interpreted ideally or exaggeratedly unless clearly defined.

In addition, unless explicitly described to the contrary, the word "comprise" and variations such as "comprises" or "comprising," or "including" will be understood to imply the inclusion of stated elements, e.g., stated features, regions, integers, steps, operations, elements, and/or components, but not the exclusion of any other elements.

It will be understood that when an element such as a layer, film, region, or substrate is referred to as being "on" another element, it can be directly on the other element or intervening elements may also be present. In contrast, when an element is referred to as being "directly on" another element, there are no intervening elements present.

As used herein, the singular forms "a," "an," and "the" are intended to include the plural forms, including "at least one," unless the context clearly indicates otherwise. For example, the wording "semiconductor nanoparticle" may refer to a single semiconductor nanoparticle or may refer to a plurality of semiconductor nanoparticles. "At least one" is not to be construed as being limited to "a" or "an." "Or" means "and/or." As used herein, the term "and/or" includes any and all combinations of one or more of the associated listed items.

It will be understood that, although the terms "first," "second," "third" etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, "a first element," "component," "region," "layer", or "section" discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

**In** the drawings, the thickness of layers, films, panels, regions, etc., are exaggerated for clarity. Like reference numerals designate like elements throughout the specification.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 10%, 5%, or 3% of the stated value.

As used herein, the expression "not including cadmium (or other harmful heavy metal)" may refer to the case in which a concentration of cadmium (or other harmful heavy metal) may be less than or equal to about 100 parts per million by weight (ppmw), less than or equal to about 50 ppmw, less than or equal to about 10 ppmw, less than or equal to about 1 ppmw, less than or equal to about 0.1 ppmw, less than or equal to about 0.01 ppmw, or about zero. In an embodiment, substantially no amount of cadmium (or other harmful heavy metal) may be present or, if present, an amount of cadmium (or other harmful heavy metal) may be less than or equal to a detection limit or as an impurity level of a given analysis tool.

Hereinafter, as used herein, when a definition is not otherwise provided, "substituted" refers to replacement of at least one hydrogen of a compound by a substituent selected from a C1 to C30 alkyl group, a C2 to C30 alkenyl group, a C2 to C30 alkynyl group, a C6 to C30 aryl group, a C7 to C30 alkylaryl group, a C7 to C30 arylalkyl group, a C6 to C30 aryloxy group, a C6 to C30 arylthio group, a C1 to C30 alkoxy group, a C1 to C30 alkylthio group, a C1 to C30 heteroalkyl group, a C3 to C30 heteroalkylaryl group, a C2 to C30 alkylheteroaryl group, a C2 to C30 heteroarylalkyl group, a C1 to C30 heteroaryloxy group, a C1 to C30 heteroarylthio group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or -I), a hydroxy group (-OH), a nitro group (-NO₂), a cyano group (-CN), an amino group or an amine group (-NRR' wherein R and R' are each independently hydrogen or a C1 to C6 alkyl group), an azido group (-N₃), an amidino group (-C(=NH)NH₂), a hydrazino group (-NHNH₂), a hydrazono group (=N(NH₂)), an aldehyde group (-C(=O)H), a carbamoyl group (-C(O)NH₂), a thiol group (-SH), an ester group (-C(=O)OR, wherein R is a C1 to C6 alkyl group or a C6 to C12 aryl group), a carboxyl group (-COOH) or a salt thereof (-C(=O)OM, wherein M is an organic or inorganic cation, a sulfonic acid group (-SO₃H) or a salt thereof (-SO₃M, wherein M is an organic or inorganic cation), a phosphoric acid group (-PO₃H₂) or a salt thereof (-PO₃MH or -PO₃M₂, wherein M is an organic or inorganic cation), or a combination thereof. The specified number or range of carbon atoms in a group is exclusive of any substituents.

In addition, when a definition is not otherwise provided below, "hetero" means a case including 1 to 3 heteroatoms such as N, O, P, Si, S, Se, Ge, or B.

In addition, the term "aliphatic hydrocarbon group" as used herein refers to a C1 to C30 linear or branched alkyl group, a C1 to C30 linear or branched alkenyl group, or a C1 to C30 linear or branched alkynyl group, and the term "aromatic organic group" as used herein refers to a C6 to C30 aryl group or a C2 to C30 heteroaryl group.

As used herein, the term "(meth)acrylate" refers to acrylate and/or methacrylate.

As used herein, the term "Group" refers to a Group of Periodic Table.

As used herein, the terms "a nanoparticle" and "a nanostructure" refer to a structure having at least one region or characteristic dimension with a nanoscale dimension. In an embodiment, the dimension of the nanoparticle or the nanostructure may be less than about 500 nm, less than about 300 nm, less than about 250 nm, less than about 150 nm, less than about 100 nm, less than about 50 nm, or less than about 30 nm. The nanoparticle or nanostructure may have any shape, such as a nanowire, a nanorod, a nanotube, a multipod type shape having two or more pods, a nanodot, or the like, but embodiments are not limited thereto. The nanoparticle or nanostructure may be, for example, substantially crystalline, substantially monocrystalline, polycrystalline, amorphous, or a combination thereof.

A quantum dot may be, for example, a semiconductor-containing nanocrystal particle that can exhibit a quantum confinement or exciton confinement effect, and is a type of a luminescent nanostructure (e.g., capable of emitting light by energy excitation). Herein, a shape of the "quantum dot" or the nanoparticle is not limited unless otherwise expressly defined.

As used herein, the term "dispersion" refers to a dispersion in which a dispersed phase is a solid, and a continuous medium includes a liquid or a solid different from the dispersed phase. It is to be understood that the "dispersion" may be a colloidal dispersion in which the dispersed phase has a dimension of greater than or equal to about 1 nm, for example, greater than or equal to about 2 nm, greater than or equal to about 3 nm, or greater than or equal to about 4 nm and less than or equal to several micrometers (µm), (e.g., less than or equal to about 2 µm, less than or equal to about 1 µm, less than or equal to about 900 nm, less than or equal to about 800 nm, less than or equal to about 700 nm, less than or equal to about 600 nm, or less than or equal to about 500 nm).

Herein, a dimension (a size, a diameter, or a thickness, etc.) may be a value for a single entity or an average value for a plurality of nanoparticles. As used herein, the term "average" (e.g., an average size of the quantum dot) may be a mean value or a median value. In an embodiment, the average may be "mean" average.

As used herein, the term "maximum emission wavelength (or peak emission wavelength)" is the wavelength at which a given emission spectrum of the light reaches its maximum.

In an embodiment, a quantum efficiency may be readily and reproducibly determined using commercially available equipment (e.g., from Hitachi or Hamamatsu, etc.) and referring to manuals provided by, for example, respective equipment manufacturers. The quantum efficiency (which can be interchangeably used with the term "quantum yield" (QY)) may be measured in a solution state or a solid state (i.e., in a composite). In an embodiment, the quantum efficiency (or the quantum yield) is the ratio of photons emitted to photons absorbed by the nanostructure or population thereof. In an embodiment, the quantum efficiency may be measured by any method. For example, there may be two methods for measuring the fluorescence quantum yield or efficiency: the absolute method and the relative method. The quantum efficiency measured by the absolute method may be referred to as an absolute quantum efficiency.

In the absolute method, the quantum efficiency may be obtained by detecting the fluorescence of all samples through an integrating sphere. In the relative method, the quantum efficiency of the unknown sample may be calculated by comparing the fluorescence intensity of a standard dye (a standard sample) with the fluorescence intensity of the unknown sample. Coumarin 153, Coumarin 545, Rhodamine 101 inner salt, Anthracene and Rhodamine 6G may be used as standard dyes according to their photoluminescence (PL) wavelengths, but embodiments are not limited thereto.

A full width at half maximum (FWHM) and a peak emission (e.g., photoluminescence (PL) or electroluminescence (EL)) wavelength may be measured, for example, from a luminescence spectrum (for example, a photoluminescence spectrum or an electroluminescent spectrum) obtained by a spectrophotometer such as a fluorescence spectrophotometer or the like.

As used herein, the term "first absorption peak wavelength" refers to a wavelength at which a main peak first appears in a lowest energy region in the ultraviolet-visible (UV-Vis) absorption spectrum.

A semiconductor nanoparticle may be used in various electronic devices, for example, also in a color conversion panel (or an emissive color filter). A liquid crystal display device may include a white light-emitting backlight unit and an absorptive color filter, and the backlight unit may include a quantum dot sheet. In a display device including a quantum dot-based color conversion panel or an emissive color filter, a quantum dot layer as an emission material is disposed at the front of the device, and blue light (excitation light) provided from a light source is converted into green light or red light by the quantum dot layer. In the color conversion panel, the color conversion of incident light may occur at a relatively front portion of the device, and a wide viewing angle may be implemented by omnidirectional scattering of light. The emissive color filter may realize a reduction in light loss. The color conversion panel may be an electronic device including a color conversion layer or a color conversion structure.

In the display device including the color conversion panel, properties (e.g., an optical property, stability, or the like) of a luminescent nanostructure may have a direct effect on display quality of the device. It may be desired for the luminescent material included in the color conversion panel disposed in a relatively front portion of the device to exhibit not only relatively high luminous efficiency but also relatively high absorbance with respect to incident light. When a patterned film (e.g., a color filter) is used in the display device, a decreased absorbance to the incident light may be a direct cause of a blue light leakage, having an adverse effect on a color reproducibility (e.g., DCI match rate) of the device. An adoption of an absorption type color filter for preventing a blue light leakage problem may lead to an additional decrease in luminous efficiency. Such a lowered absorbance of the semiconductor nanoparticle may result in a reduced luminance in a device including the semiconductor nanoparticle.

Semiconductor nanoparticles may exhibit properties (e.g., optical properties and/or stability) that may be applicable to a device, but many of them may include cadmium-containing compounds (e.g., a cadmium chalcogenide). The cadmium causes a serious environment/health problem and thus is one of the restricted elements in many countries. Therefore, in order to develop cadmium-free environment-friendly nanoparticles, in-depth research on nanocrystals based on Group III-V compounds has been conducted. However, cadmium-free nanoparticles including a Group Ill-V compound (e.g., indium phosphide) may come across a technological limit in the incident light absorbance and the full width at half maximum. Accordingly, there remains a technological need to develop an environmentally friendly nanoparticle that can exhibit a higher absorbance, a narrower the full width at half maximum, and a higher luminous efficiency in comparison with a cadmium-free nanoparticle based on a Group III-V compound, such as an indium phosphide.

The semiconductor nanoparticle of an embodiment may achieve a desired emission property (e.g., an increased quantum yield with reduced full width at half maximum) without including cadmium, and may exhibit enhanced stability.

In an embodiment, the semiconductor nanoparticle may not contain cadmium. The semiconductor nanoparticle may not contain mercury, lead, or a combination thereof.

In an embodiment, the semiconductor nanoparticle includes silver, indium, gallium, and sulfur (a group 11-13-16 compound including the same). The semiconductor nanoparticle based on the group 11-13-16 compound according to an embodiment may achieve improved optical property (e.g., increased luminous efficiency) by controlling an internal structure of the particle together with a composition thereof as described herein.

A semiconductor nanoparticle including Ag, In, Ga, and S may realize increased absorbance. The semiconductor nanoparticle may further include a gallium sulfide-based semiconductor nanocrystal on a surface of the particle to improve optical property. In connection with the semiconductor nanoparticle, the present inventors have found that controlling or setting a composition (e.g., concentration distribution) of certain elements within the semiconductor nanoparticle may additionally affect optical property (e.g., luminous efficiency) of the nanoparticle. In the semiconductor nanoparticle of an embodiment, for example, as confirmed according to a method described herein, an amount/location of individual elements (or a concentration profile) certain selected elements) within the particle may be set or controlled. In the semiconductor nanoparticle of an embodiment, an indium-rich semiconductor nanocrystal based on silver, indium, gallium, and sulfur may be disposed, e.g., in an inner zone (or portion) of the nanoparticle (hereinafter, may at time be referred to as a core), and a gallium-rich nanocrystal including silver, indium, gallium, and sulfur may be disposed near a surface of the particle (hereinafter, may be referred to as a shell).

In an embodiment, in the semiconductor nanoparticle, an amount and/or a concentration distribution of individual elements or certain elements within the nanoparticle in a radial direction (e.g., from a center portion toward a surface of the nanoparticle) may be determined by a suitable analytical method (e.g., a known analytical quantitative method), for example, atom probe tomography (APT) analysis, electron energy-loss spectroscopy (EELS) analysis, electron microscopy analysis, X-ray photoelectron spectroscopy (XPS) analysis, or a combination thereof (e.g., electron microscopy analysis and APT analysis, or electron microscopy analysis and EELS analysis).

The semiconductor nanoparticle of an embodiment may exhibit a gradient alloy composition that changes along a radial direction of the particle and may exhibit an enhanced or increased optical property (e.g., luminous efficiency). The semiconductor nanoparticle of an embodiment may exhibit, as approaching a surface of the particle from a center thereof, based on a total of indium and gallium, an increase in a content mole ratio of gallium and a decrease in a content mole ratio of silver.

In an embodiment, as an amount or a concentration distribution of individual elements or certain elements, e.g., silver, indium, and gallium, in the semiconductor nanoparticle is measured in a radial direction thereof, the semiconductor nanoparticle exhibits a maximum value of a mole ratio of gallium to a total of indium and gallium (hereinafter, also referred to as Ga:(In+Ga)) in a first zone. The first zone may be spaced apart from a center (or a core) of the semiconductor nanoparticle. In the semiconductor nanoparticle, in the first zone, a mole ratio of silver to a total of indium and gallium (hereinafter, also referred to as Ag:(In+Ga)) is greater than or equal to about 0.18:1. The mole ratio of silver to a total of indium and gallium may be less than or equal to about 1.5:1. The semiconductor nanoparticle of an embodiment may have a quantum yield of greater than or equal to about 85%.

Measuring an amount of an individual element in a radial direction from a center of the semiconductor nanoparticle may be performed by APT analysis, EELS analysis, XPS analysis, and/or electron microscopy analysis (e.g., TEM analysis). The radial direction refers to a direction from a center or a center portion of a particle (e.g., a nanoparticle) toward a surface thereof. The center or the center portion may be determined reproducibly depending on the measurement method and/or the structure of the semiconductor nanoparticle. For example, the center or the center portion may correspond to a position or a region at which a mole ratio of indium to gallium in the semiconductor nanoparticle is at a maximum, or at which a mole ratio of gallium to a sum of indium and gallium is at a minimum.

Atom Probe Tomography (APT or 3D Atom Probe) is a material analysis technique capable of three-dimensionally analyzing a chemical composition and a structure of a sample at an atomic level. In an embodiment, the APT may have a spatial resolution of about 0.1 nm to about 0.3 nm in a depth direction and about 0.3 nm to about 0.5 nm in a lateral direction. The APT may simultaneously provide atomic identification as well as positional information, thereby enabling quantitative analysis of a microstructure, an interface, and/or a distribution characteristic (a concentration distribution) within a sample (e.g., a nanoparticle). The APT may provide information on a concentration distribution/amount of individual elements according to a radial direction (e.g., a concentration or a change in concentration according to the radial direction) in the semiconductor nanoparticle of an embodiment. In an embodiment, for the APT analysis, the semiconductor nanoparticles may form a needle-shaped structure. A preparation manner of a sample is not particularly limited and, according to a manual provided by a manufacturer of an APT analysis apparatus, may be easily performed to clearly confirm an internal structure of a nanoparticle and to provide reproducible results. For example, the preparation method of the sample may include preparing through electropolishing or a focused ion beam (FIB) process, but is not limited thereto.

An APT analysis of a given semiconductor nanoparticle may include fixing a sample to a specimen mount, inserting the sample into an ultra-high vacuum (UHV) system, and, for example, cooling to a low temperature of about 20 K to about 100 K. Thereafter, the analysis may be initiated while a standing positive voltage is applied to the sample (mount) in combination with a short laser pulse or a voltage pulse of less than or equal to about one nanosecond.

An APT apparatus may collect a very large number of ions (e.g., thousands or hundreds of millions) per each analysis to achieve a relatively high detection rate. In such an analysis (e.g., under a high vacuum state), after cooling the sample to a cryogenic temperature of about 20 K to about 100 K, a high voltage (about 3 kV to about 15 kV) may be applied to a sample tip, and a laser or voltage pulse is periodically applied thereto, whereby atoms are field-evaporated one by one from a surface of the sample tip. At this time, a small radius of curvature of the tip and the high voltage are combined to form a high electric field of tens of V/nm on the surface of the sample, thereby providing precise evaporation conditions at an atomic level.

The evaporated atoms can be in an almost 100% ionized state and can be accelerated by the electric field and delivered to a position sensitive detector (PSD). The detector (for example, the position sensitive detector) simultaneously can measure a time-of-flight (TOF) of ions and a collision position (XY coordinates), thereby reconstructing a mass-to-charge ratio (m/q) of each ion and original positional information within the sample. A time point at which the laser or voltage pulse is generated is defined as t(pulse), and a time point at which the ion reaches the detector is defined as t(event), and the TOF of the ion can be determined by measuring a difference between the two times. By repeating the field evaporation and the detection processes, atoms are sequentially removed from the sample tip, and mass and positional information of each ion are accumulated. APT analysis data may identify individual peaks in a mass spectrum according to an isotope ratio through dedicated software, and based on obtained results, by defining a region-of-interest (ROI), reconstruct a spatial distribution of each element (e.g., a one-dimensional concentration profile (1D concentration profile)), and precisely visualize a microstructure (e.g., a three-dimensional structure) and a composition of the sample.

Electron Energy Loss Spectroscopy (EELS) is a spectroscopic technique that, in conjunction with a transmission electron microscope (TEM), irradiates a sample with a high-speed electron beam and measures an energy loss amount of electrons interacting with the sample, thereby analyzing information of an elemental composition, a bonding state, and an electronic structure of the sample.

The EELS can be used to collect, from a detector, an energy-loss distribution of electrons that have undergone inelastic scattering among electrons passing through a sample, and based thereon, to perform quantitative and qualitative analyses on presence and a spatial distribution of elements in the sample, a chemical environment, and the like. In an embodiment, an electron beam may have an energy of tens to hundreds of keV, and may cause various inelastic interactions with atoms in the sample while transmitting through a thin sample. Such interactions include phonon excitation, inter- and intra-band transitions, plasmon excitation, inner-shell ionization, and Cherenkov radiation. Among them, inner-shell ionization may have an inherent energy-loss value corresponding to an energy level unique to each element, and thus, elemental identification and quantitative analysis are possible therefrom. For example, an energy loss of about 285 eV corresponds to an energy required to remove an electron from a K-shell (1s shell) of a carbon atom, and thus, when this energy-loss peak is clearly observed, it indicates that carbon is present in the sample.

The EELS analysis may be performed using a commercially available measurement apparatus. Preparation of a sample for the EELS analysis may follow a manual provided from a manufacturer of the measurement apparatus. In an embodiment, the sample may be obtained by dispersing the semiconductor nanoparticles in an organic solvent to obtain a dispersion and applying (e.g., by a drop-casting method) and drying the dispersion on, for example, a TEM grid having a carbon support film. Through an EELS detection system (e.g., Gatan Quantum 966 ERS) mounted on a transmission electron microscope (TEM), an electron beam may be scanned over a two-dimensional region (e.g., 64×64 pixels) of the sample, and a spectrum may be collected for a predetermined dwell time (e.g., 0.01 ms/pixel) for each pixel. After acquiring a plurality of frames (e.g., 20 frames) and cumulatively averaging the data to remove noise, an elemental map may be generated by extracting a peak or an edge corresponding to a specific energy-loss value, and spatial distribution and relative concentration information may be reconstructed.

Edge extraction for each element may be based on an inherent energy range corresponding to shells such as K, L, and M, and an edge signal of a specific element may be integrated from a collected spectrum image and visualized as a two-dimensional map. Analysis conditions (an acceleration voltage of the TEM, an electron beam current, a convergence angle, and a collection angle, etc.) may be appropriately selected according to a manual provided by a manufacturer of the apparatus.

By the EELS analysis, an amount of an element included in the semiconductor nanoparticle of an embodiment in a radial direction, and the like, may be readily and reproducibly obtained. EELS mapping in a high-resolution STEM mode linked with TEM enables high-spatial-resolution analysis of a chemical structure and an electronic property of a sample.

X-ray Photoelectron Spectroscopy (XPS) is a surface analysis technique capable of quantitatively analyzing an elemental composition and a chemical state, an electronic structure, and the like, present on a surface of a sample by irradiating the sample with X-rays and measuring kinetic energy of photoelectrons emitted from the sample. XPS may be performed within a range corresponding to a depth of about 1 nanometer to about 10 nanometers from the surface of the sample, for example, the surfaces of semiconductor nanoparticles, and may have a sensitivity capable of detecting a difference in binding energy at an atomic level. When X-rays having a predetermined energy are irradiated to a sample, atoms in the sample emit electrons by a photoelectric effect. In this case, when kinetic energy of the emitted electrons is measured, an energy state to which the electron was bound, i.e., binding energy, may be back-calculated. Because the binding energy is determined according to inherent characteristics of an element, a type of an element included in a sample may be identified by analyzing energy of emitted electrons. In addition, a fine difference in binding energy occurs according to a difference in a chemical bonding state or an oxidation state, and thus, information on a chemical environment of atoms in the sample may also be obtained by analyzing a shift or a shape change of a peak position. XPS analysis may be readily and reproducibly performed using a commercially available apparatus.

In an embodiment, XPS analysis may be performed using an XPS apparatus (e.g., Quantera II) using an aluminum Kα X-ray source having a predetermined energy (e.g., 1486.6 eV). In an embodiment, XPS analysis may use an accelerator-based synchrotron XPS apparatus. In an embodiment, an X-ray energy may be variously adjusted to be greater than or equal to about 460 eV, for example, about 610 eV, about 750 eV, about 900 eV, or about 1050 eV, to stepwise control an information acquisition depth.

In an embodiment, XPS analysis may be performed under an ultra-high vacuum (UHV) condition (a base pressure of about 10⁻⁸ Torr or a base pressure of about 10⁻⁹ Torr) with a predetermined pass energy (e.g., less than or equal to about 60 eV, or about 55 eV to about 20 eV, or about 15 eV), but is not limited thereto. Preparation of a sample may include spin-coating a diluted semiconductor nanoparticle (QD) solution on a silicon wafer and drying the same, wherein a spin speed may be in a range of about 500 rpm to about 1500 rpm, and a thickness of an obtained film may be about 20 nm to about 30 nm. The analysis may be performed by irradiating X-rays having a predetermined energy onto a surface of the sample and measuring an intensity of a peak appearing at a binding energy position corresponding to a specific orbital among electrons emitted in response the X-rays. By analyzing a position, a size, and a ratio of peaks for each element, information on presence or absence of main constituent elements in the sample, a composition ratio, and a chemical bonding state may be obtained. XPS analysis is a precise analysis technique capable of quantitatively interpreting a chemical composition and an electronic structure of a sample surface in a non-destructive manner and has been effectively used for composition analysis and chemical state confirmation in samples.

Given the many known analytical techniques just described, a relative mole ratio of different elements in a particle, e.g., a nanoparticle, as described herein may be determined by, for example, using any one or more of TEM analysis, APT analysis, EELS analysis, or XPS analysis (e.g., TEM analysis, APT analysis, EELS analysis, XPS analysis, or two or more analyses thereof).

In an embodiment, as determined by the APT analysis or by the EELS analysis, in the first zone of the semiconductor nanoparticle, a maximum value of a mole ratio of gallium to a total of indium and gallium (Ga:(In+Ga)) may be greater than or equal to about 0.7:1, greater than or equal to about 0.72:1, greater than or equal to about 0.74:1, greater than or equal to about 0.75:1, greater than or equal to about 0.76:1, greater than or equal to about 0.78:1, greater than or equal to about 0.8:1 greater than or equal to about 0.82:1, or greater than or equal to about 0.86:1. The maximum value of the mole ratio of gallium to a total of indium and gallium may be less than or equal to about 1:1, less than or equal to about 0.99:1, less than or equal to about 0.98:1, less than or equal to about 0.97:1, less than or equal to about 0.96:1, less than or equal to about 0.95:1, less than or equal to about 0.94:1, less than or equal to about 0.93:1, less than or equal to about 0.92:1, or less than or equal to about 0.91:1.

The semiconductor nanoparticle of an embodiment may include silver in relatively greater amount in the first zone. In the first zone, a mole ratio of silver to a total of indium and gallium may be, for example, as determined by the APT analysis or by the EELS analysis, greater than or equal to about 0.19:1, greater than or equal to about 0.2:1, greater than or equal to about 0.21:1, greater than or equal to about 0.22:1, greater than or equal to about 0.23:1, greater than or equal to about 0.24:1, greater than or equal to about 0.25:1, or greater than or equal to about 0.3:1; less than or equal to about 1.5:1, less than or equal to about 1.4:1, less than or equal to about 1.3:1, less than or equal to about 1.2:1, less than or equal to about 1:1, less than or equal to about 0.95:1, less than or equal to about 0.9:1, less than or equal to about 0.85:1, less than or equal to about 0.8:1, less than or equal to about 0.75:1, less than or equal to about 0.7:1, less than or equal to about 0.65:1, less than or equal to about 0.6:1, less than or equal to about 0.55:1, or less than or equal to about 0.5:1; or a range of any two mole ratio values above.

In the first zone, a difference between the Ga:(In+Ga) and the Ag:(In+Ga) may be greater than or equal to about 0.1:1, greater than or equal to about 0.2:1, greater than or equal to about 0.3:1, greater than or equal to about 0.4:1, or greater than or equal to about 0.5:1. In the first zone, the difference between the Ga:(In+Ga) and the Ag:(In+Ga) may be less than or equal to about 0.9:1, less than or equal to about 0.85:1, less than or equal to about 0.8:1, less than or equal to about 0.75:1, less than or equal to about 0.7:1, less than or equal to about 0.65:1, less than or equal to about 0.6:1, less than or equal to about 0.55:1, less than or equal to about 0.5:1, less than or equal to about 0.45:1, less than or equal to about 0.4:1, less than or equal to about 0.35:1, less than or equal to about 0.25:1, or less than or equal to about 0.15:1.

The mole ratio of silver to a total of indium and gallium in the first zone may be less than a mole ratio of silver to a total of indium and gallium in a central portion (e.g., a core) of the semiconductor nanoparticle. In the semiconductor nanoparticle of an embodiment, for example, as determined by the APT analysis or by the EELS analysis, a difference between a maximum value of a mole ratio of silver to a total of indium and gallium and the mole ratio of silver to a total of indium and gallium in the first zone may be greater than or equal to about 0.05:1, greater than or equal to about 0.1:1, greater than or equal to about 0.15:1, greater than or equal to about 0.2:1, greater than or equal to about 0.25:1, greater than or equal to about 0.3:1, greater than or equal to about 0.35:1, greater than or equal to about 0.4:1, greater than or equal to about 0.45:1, or greater than or equal to about 0.5:1; less than or equal to about 0.9:1, less than or equal to about 0.85:1, less than or equal to about 0.8:1, less than or equal to about 0.75:1, less than or equal to about 0.7:1, less than or equal to about 0.65:1, less than or equal to about 0.6:1, less than or equal to about 0.55:1, less than or equal to about 0.5:1, less than or equal to about 0.45:1, less than or equal to about 0.4:1, less than or equal to about 0.35:1, less than or equal to about 0.3:1, less than or equal to about 0.25:1, less than or equal to about 0.2:1, less than or equal to about 0.15:1, or less than or equal to about 0.1:1; or a range of any two mole ratio values above.

In an embodiment, the semiconductor nanoparticle may have a core-shell structure. The semiconductor nanoparticle or the core-shell structure may include a core including a first semiconductor nanocrystal including silver, indium, gallium, and sulfur, and a semiconductor nanocrystal shell disposed on the core.

The first semiconductor nanocrystal may include silver, a Group 13 element, and a chalcogen element or may include a Group 11-13-16 compound including silver, a Group 13 element, and a chalcogen element. The first semiconductor nanocrystal may further include or may not include zinc. The first semiconductor nanocrystal may further include or may not include copper. The Group 13 element may include indium, gallium, or a combination thereof. The chalcogen element may include sulfur, and optionally selenium. The first semiconductor nanocrystal may include a quaternary alloy semiconductor material based on a Group 11-13-16 compound including silver (Ag), indium, gallium, and sulfur.

In an embodiment, the first semiconductor nanocrystal may include silver indium gallium sulfide, for example, a compound represented by Ag(InₓGa₁₋ₓ)S_{y} (where x is greater than 0 and less than 1, or less than or equal to about 0.5, and y is a real number greater than 0, for example, less than or equal to about 5, or less than or equal to about 2). In the first semiconductor nanocrystal, a mole ratio among respective components may be adjusted so that a final semiconductor nanoparticle exhibits a desired composition and optical property (e.g., a peak emission wavelength).

The core may have a radius of greater than or equal to about 0.5 nm, greater than or equal to about 0.6 nm, greater than or equal to about 0.7 nm, greater than or equal to about 0.8 nm, greater than or equal to about 0.9 nm, greater than or equal to about 1 nm, greater than or equal to about 1.1 nm, greater than or equal to about 1.2 nm, greater than or equal to about 1.3 nm, greater than or equal to about 1.4 nm, greater than or equal to about 1.5 nm, greater than or equal to about 1.6 nm, or greater than or equal to about 1.75 nm. The core may have a radius of less than or equal to about 2.5 nm, less than or equal to about 2.4 nm, less than or equal to about 2.3 nm, less than or equal to about 2.2 nm, less than or equal to about 2.1 nm, less than or equal to about 2 nm, less than or equal to about 1.9 nm, less than or equal to about 1.8 nm, less than or equal to about 1.75 nm, less than or equal to about 1.7 nm, less than or equal to about 1.65 nm, less than or equal to about 1.6 nm, less than or equal to about 1.55 nm, less than or equal to about 1.5 nm, or less than or equal to about 1.45 nm.

In an embodiment, as determined by ICP analysis, XPS analysis, APT analysis, or EELS analysis, in the core, a mole ratio of gallium to a total of indium and gallium (Ga/(In+Ga)) may be greater than 0, or greater than or equal to about 0.1:1, greater than or equal to about 0.2:1, greater than or equal to about 0.25:1, greater than or equal to about 0.3:1, greater than or equal to about 0.35:1, greater than or equal to about 0.4:1, greater than or equal to about 0.45:1, greater than or equal to about 0.5:1, greater than or equal to about 0.55:1, greater than or equal to about 0.6:1, greater than or equal to about 0.65:1, greater than or equal to about 0.7:1, greater than or equal to about 0.75:1, greater than or equal to about 0.8:1, greater than or equal to about 0.85:1, or greater than or equal to about 0.9:1; less than or equal to about 0.9:1, less than or equal to about 0.85:1, less than or equal to about 0.8:1, less than or equal to about 0.75:1, less than or equal to about 0.7:1, less than or equal to about 0.65:1, less than or equal to about 0.6:1, or less than or equal to about 0.55:1; or a range of any two mole ratio values above.

In the core, a minimum value of the mole ratio of gallium to a total of indium and gallium may exist within a range from less than or equal to about 1.5 nm, less than or equal to about 1.3 nm, less than or equal to about 1.2 nm, less than or equal to about 1 nm, less than or equal to about 0.9 nm, or less than or equal to about 0.5 nm to 0 nm from a center of the semiconductor nanoparticle. In an embodiment, a minimum value of Ga/(In+Ga) of the core may substantially exist at a center portion of the semiconductor nanoparticle.

In an embodiment, as determined by ICP analysis, XPS analysis, APT analysis, or EELS analysis, in the core, a mole ratio of silver to a total of indium and gallium (Ag/(In+Ga)) may be greater than or equal to about 0.35:1, greater than or equal to about 0.4:1, greater than or equal to about 0.45:1, greater than or equal to about 0.5:1, greater than or equal to about 0.55:1, greater than or equal to about 0.6:1, greater than or equal to about 0.65:1, greater than or equal to about 0.7:1, greater than or equal to about 0.75:1, greater than or equal to about 0.8:1, greater than or equal to about 0.85:1, greater than or equal to about 0.9:1, greater than or equal to about 0.95:1, greater than or equal to about 1:1, greater than or equal to about 1.1:1, or greater than or equal to about 1.2:1; less than or equal to about 2:1, less than or equal to about 1.8:1, less than or equal to about 1.5:1, less than or equal to about 1.3:1, less than or equal to about 1:1, less than or equal to about 0.9:1, less than or equal to about 0.85:1, less than or equal to about 0.8:1, less than or equal to about 0.75:1, less than or equal to about 0.7:1, less than or equal to about 0.65:1, or less than or equal to about 0.6:1; or a range of any two mole ratio values above.

The semiconductor nanocrystal shell may include a second semiconductor nanocrystal including silver, gallium, and sulfur. The second semiconductor nanocrystal may further include or may not include indium. The second semiconductor nanocrystal may include a ternary alloy semiconductor material including silver, gallium, and sulfur; a quaternary alloy semiconductor material including silver, indium, gallium, and sulfur; or a combination thereof.

The second semiconductor nanocrystal may cover at least a portion of the first semiconductor nanocrystal. A bandgap energy of the second semiconductor nanocrystal may be different from a bandgap energy of the first semiconductor nanocrystal. The bandgap energy of the second semiconductor nanocrystal may be greater than a bandgap energy of the first semiconductor nanocrystal. The bandgap energy of the second semiconductor nanocrystal may be less than a bandgap energy of the first semiconductor nanocrystal.

In an embodiment, the semiconductor nanocrystal shell or the second semiconductor nanocrystal (hereinafter, referred to as a semiconductor nanocrystal shell) may have a thickness of greater than or equal to about 0.1 nm, greater than or equal to about 0.2 nm, greater than or equal to about 0.3 nm, greater than or equal to about 0.4 nm, greater than or equal to about 0.5 nm, greater than or equal to about 0.6 nm, greater than or equal to about 0.7 nm, greater than or equal to about 0.8 nm, greater than or equal to about 0.9 nm, greater than or equal to about 1 nm, greater than or equal to about 1.2 nm, greater than or equal to about 1.3 nm, greater than or equal to about 1.4 nm, greater than or equal to about 1.5 nm, greater than or equal to about 1.6 nm, greater than or equal to about 1.7 nm, greater than or equal to about 1.8 nm, greater than or equal to about 1.9 nm, greater than or equal to about 2 nm, greater than or equal to about 2.2 nm, greater than or equal to about 2.3 nm, greater than or equal to about 2.4 nm, greater than or equal to about 2.5 nm, greater than or equal to about 2.6 nm, greater than or equal to about 2.7 nm, greater than or equal to about 2.8 nm, greater than or equal to about 2.9 nm, or greater than or equal to about 3 nm. The semiconductor nanocrystal shell may have a thickness of less than or equal to about 4 nm, less than or equal to about 3.9 nm, less than or equal to about 3.8 nm, less than or equal to about 3.7 nm, less than or equal to about 3.6 nm, less than or equal to about 3.5 nm, less than or equal to about 3.4 nm, less than or equal to about 3.3 nm, less than or equal to about 3.2 nm, less than or equal to about 3.1 nm, less than or equal to about 3 nm, less than or equal to about 2.6 nm, less than or equal to about 2.3 nm, less than or equal to about 2 nm, less than or equal to about 1.7 nm, less than or equal to about 1.5 nm, less than or equal to about 1 nm, less than or equal to about 0.8 nm, or less than or equal to about 0.6 nm. The semiconductor nanocrystal shell may be defined by a thickness as a range of any thickness values above.

In the semiconductor nanoparticle of an embodiment, the first region may exist in the semiconductor nanocrystal shell.

For example, as determined by ICP analysis, XPS analysis, APT analysis, or EELS analysis, in the semiconductor nanocrystal shell or the first region, a mole ratio of gallium to a total of indium and gallium (Ga:(In+Ga)) may be greater than or equal to about 0.5:1, greater than or equal to about 0.55:1, greater than or equal to about 0.6:1, greater than or equal to about 0.65:1, greater than or equal to about 0.7:1, or greater than or equal to about 0.75:1; less than or equal to about 1:1, less than or equal to about 0.99:1, less than or equal to about 0.98:1, less than or equal to about 0.97:1, less than or equal to about 0.96:1, less than or equal to about 0.95:1, less than or equal to about 0.94:1, less than or equal to about 0.93:1, less than or equal to about 0.92:1, less than or equal to about 0.91:1, less than or equal to about 0.9:1, less than or equal to about 0.89:1, less than or equal to about 0.88:1, less than or equal to about 0.87:1, less than or equal to about 0.86:1, less than or equal to about 0.85:1, less than or equal to about 0.84:1, or less than or equal to about 0.83:1; or a range of any two mole ratio values above.

For example, as determined by ICP analysis, XPS analysis, APT analysis, or EELS analysis, in the semiconductor nanocrystal shell or the first region, a mole ratio of silver to a total of indium and gallium (Ag:(In+Ga)) may be greater than or equal to about 0.18:1, greater than or equal to about 0.19:1, greater than or equal to about 0.2:1, greater than or equal to about 0.21:1, greater than or equal to about 0.22:1, greater than or equal to about 0.23:1, greater than or equal to about 0.24:1, greater than or equal to about 0.25:1, greater than or equal to about 0.26:1, greater than or equal to about 0.27:1, greater than or equal to about 0.28:1, greater than or equal to about 0.29:1, greater than or equal to about 0.3:1, greater than or equal to about 0.31:1, greater than or equal to about 0.32:1, greater than or equal to about 0.33:1, greater than or equal to about 0.34:1, greater than or equal to about 0.35:1, greater than or equal to about 0.36:1, greater than or equal to about 0.37:1, greater than or equal to about 0.38:1, greater than or equal to about 0.39:1, greater than or equal to about 0.4:1, greater than or equal to about 0.41:1, greater than or equal to about 0.42:1, greater than or equal to about 0.43:1, greater than or equal to about 0.44:1, greater than or equal to about 0.45:1, greater than or equal to about 0.46:1, greater than or equal to about 0.47:1, greater than or equal to about 0.48:1, or greater than or equal to about 0.49:1; less than or equal to about 1.5:1, less than or equal to about 1.45:1, less than or equal to about 1.4:1, less than or equal to about 1.35:1, less than or equal to about 1.3:1, less than or equal to about 1.25:1, less than or equal to about 1.2:1, less than or equal to about 1.15:1, less than or equal to about 1.1:1, less than or equal to about 1.05:1, less than or equal to about 1:1, less than or equal to about 0.95:1, less than or equal to about 0.9:1, less than or equal to about 0.85:1, less than or equal to about 0.8:1, less than or equal to about 0.75:1, less than or equal to about 0.7:1, less than or equal to about 0.65:1, less than or equal to about 0.6:1, less than or equal to about 0.55:1, less than or equal to about 0.5:1, less than or equal to about 0.45:1, or less than or equal to about 0.4:1; and/or a range of any two mole ratio values above.

A semiconductor nanoparticle with such a gradient alloy composition (i.e., a controlled distribution of certain elements along a radial direction of a particle) as a whole particle, may exhibit a mole ratio among elements as described herein. In an embodiment, a mole ratio among elements in the whole particle may be confirmed by a suitable analysis means (for example, inductively coupled plasma-atomic emission spectroscopy (ICP-AES), X-ray photoelectron spectroscopy (XPS), transmission electron microscopy-energy dispersive spectroscopy (TEM-EDX), scanning electron microscopy-energy dispersive spectroscopy (SEM-EDX), X-ray fluorescence (XRF), or the like).

In the semiconductor nanoparticle of an embodiment, a mole ratio of gallium to a total of indium and gallium (Ga:(In+Ga)) may be greater than or equal to about 0.5:1, greater than or equal to about 0.6:1, greater than or equal to about 0.7:1, greater than or equal to about 0.75:1, greater than or equal to about 0.79:1, greater than or equal to about 0.8:1, greater than or equal to about 0.81:1, greater than or equal to about 0.82:1, greater than or equal to about 0.83:1, greater than or equal to about 0.84:1, or greater than or equal to about 0.85:1; less than or equal to about 0.99:1, less than or equal to about 0.98:1, less than or equal to about 0.97:1, less than or equal to about 0.96:1, less than or equal to about 0.95:1, less than or equal to about 0.94:1, less than or equal to about 0.93:1, less than or equal to about 0.92:1, less than or equal to about 0.91:1, less than or equal to about 0.9:1, less than or equal to about 0.89:1, less than or equal to about 0.88:1, less than or equal to about 0.87:1, less than or equal to about 0.86:1, or less than or equal to about 0.85:1; and/or a range of any two mole ratio values above.

In the semiconductor nanoparticle, a mole ratio of silver to a total of indium and gallium may be greater than or equal to about 0.5:1, greater than or equal to about 0.55:1, greater than or equal to about 0.6:1, greater than or equal to about 0.65:1, greater than or equal to about 0.66:1, greater than or equal to about 0.67:1, greater than or equal to about 0.68:1, greater than or equal to about 0.69:1, greater than or equal to about 0.7:1, greater than or equal to about 0.71:1, greater than or equal to about 0.72:1, or greater than or equal to about 0.73:1; less than or equal to about 1.5:1, less than or equal to about 1.3:1, less than or equal to about 1.2:1, less than or equal to about 1:1, less than or equal to about 0.99:1, less than or equal to about 0.98:1, less than or equal to about 0.97:1, less than or equal to about 0.96:1, less than or equal to about 0.95:1, less than or equal to about 0.94:1, less than or equal to about 0.93:1, less than or equal to about 0.92:1, or less than or equal to about 0.91:1; and/or a range of any two mole ratio values above.

In the semiconductor nanoparticle of an embodiment, a mole ratio of silver to indium (Ag:In) may be greater than or equal to about 3:1, greater than or equal to about 3.2:1, greater than or equal to about 3.26:1, greater than or equal to about 3.5:1, greater than or equal to about 4:1, greater than or equal to about 4.9:1, greater than or equal to about 5:1, greater than or equal to about 5.1:1, greater than or equal to about 5.2:1, greater than or equal to about 5.5:1, greater than or equal to about 5.7:1, greater than or equal to about 5.9:1, greater than or equal to about 6:1, greater than or equal to about 6.5:1, greater than or equal to about 7:1, greater than or equal to about 7.5:1, greater than or equal to about 8:1, greater than or equal to about 8.5:1, greater than or equal to about 9:1, greater than or equal to about 9.5:1, greater than or equal to about 10:1, greater than or equal to about 10.4:1, greater than or equal to about 11:1, greater than or equal to about 11.5:1, greater than or equal to about 11.8:1, greater than or equal to about 12:1, greater than or equal to about 12.5:1, greater than or equal to about 13:1, greater than or equal to about 13.2:1, greater than or equal to about 13.5:1, greater than or equal to about 13.7:1, greater than or equal to about 13.9:1, greater than or equal to about 14:1, greater than or equal to about 14.5:1, greater than or equal to about 15:1, greater than or equal to about 15.1:1, greater than or equal to about 15.2:1, greater than or equal to about 15.3:1, greater than or equal to about 16:1, greater than or equal to about 16.5:1, greater than or equal to about 17:1, greater than or equal to about 17.5:1, greater than or equal to about 18:1, greater than or equal to about 18.5:1, greater than or equal to about 19:1, greater than or equal to about 19.5:1, or greater than or equal to about 20:1; less than or equal to about 30:1, less than or equal to about 29.5:1, less than or equal to about 29:1, less than or equal to about 28:1, less than or equal to about 27:1, less than or equal to about 26:1, less than or equal to about 25:1, less than or equal to about 24:1, less than or equal to about 23:1, less than or equal to about 22:1, less than or equal to about 21:1, less than or equal to about 20:1, less than or equal to about 19.4:1, less than or equal to about 18.2:1, less than or equal to about 17.3:1, less than or equal to about 16.2:1, less than or equal to about 15.6:1, less than or equal to about 15.4:1, less than or equal to about 14.8:1, less than or equal to about 14.4:1, less than or equal to about 13.8:1, less than or equal to about 13.2:1, less than or equal to about 13:1, less than or equal to about 12.4:1, less than or equal to about 12.2:1, less than or equal to about 11.9:1, less than or equal to about 11.6:1, less than or equal to about 11.4:1, less than or equal to about 10.5:1, or less than or equal to about 10.3:1; and/or a range of any two mole ratio values above.

In the semiconductor nanoparticle, a mole ratio of sulfur to indium (S:In) may be greater than or equal to about 7:1, greater than or equal to about 7.5:1, greater than or equal to about 8:1, greater than or equal to about 8.5:1, greater than or equal to about 8.7:1, greater than or equal to about 8.77:1, greater than or equal to about 14.55:1, greater than or equal to about 20:1, greater than or equal to about 25:1, greater than or equal to about 27:1, greater than or equal to about 29:1, greater than or equal to about 30:1, greater than or equal to about 30.5:1, greater than or equal to about 31:1, greater than or equal to about 33:1, greater than or equal to about 35:1, greater than or equal to about 36:1, greater than or equal to about 36.5:1, greater than or equal to about 37:1, greater than or equal to about 37.3:1, greater than or equal to about 37.5:1, greater than or equal to about 38:1, or greater than or equal to about 39:1; less than or equal to about 48:1, less than or equal to about 45:1, less than or equal to about 42:1, less than or equal to about 41:1, less than or equal to about 40:1, less than or equal to about 39:1, less than or equal to about 38.5:1, less than or equal to about 37.7:1, less than or equal to about 36.3:1, less than or equal to about 35.2:1, less than or equal to about 34:1, less than or equal to about 32:1, or less than or equal to about 31.5:1; and/or a range of any two mole ratio values above.

In the semiconductor nanoparticle, a mole ratio of indium to sulfur (In:S) may be greater than or equal to about 0.01:1, greater than or equal to about 0.015:1, greater than or equal to about 0.02:1, greater than or equal to about 0.025:1, or greater than or equal to about 0.03:1; less than or equal to about 0.1:1, less than or equal to about 0.07:1, less than or equal to about 0.05:1, or less than or equal to about 0.04:1; and/or a range of any two mole ratio values above.

In the semiconductor nanoparticle, a mole ratio of gallium to sulfur (Ga:S) may be greater than or equal to about 0.4:1, greater than or equal to about 0.44:1, greater than or equal to about 0.45:1, greater than or equal to about 0.47:1, greater than or equal to about 0.48:1, greater than or equal to about 0.49:1, greater than or equal to about 0.51:1, greater than or equal to about 0.52:1, greater than or equal to about 0.53:1, greater than or equal to about 0.54:1, greater than or equal to about 0.55:1, greater than or equal to about 0.56:1, greater than or equal to about 0.57:1, greater than or equal to about 0.58:1, greater than or equal to about 0.59:1, greater than or equal to about 0.6:1, greater than or equal to about 0.63:1, greater than or equal to about 0.65:1, greater than or equal to about 0.67:1, greater than or equal to about 0.69:1, greater than or equal to about 0.7:1, greater than or equal to about 0.72:1, greater than or equal to about 0.74:1, greater than or equal to about 0.76:1, or greater than or equal to about 0.78:1; less than or equal to about 1:1, less than or equal to about 0.95:1, less than or equal to about 0.9:1, less than or equal to about 0.85:1, less than or equal to about 0.8:1, less than or equal to about 0.79:1, less than or equal to about0.78:1, less than or equal to about 0.77:1, less than or equal to about 0.75:1, less than or equal to about 0.73:1, less than or equal to about 0.71:1, less than or equal to about 0.7:1, less than or equal to about 0.69:1, less than or equal to about 0.68:1, less than or equal to about 0.65:1, less than or equal to about 0.64:1, less than or equal to about 0.61:1, less than or equal to about 0.6:1, less than or equal to about 0.56:1, less than or equal to about 0.54:1, less than or equal to about 0.52:1, or less than or equal to about 0.5:1; and/or a range of any two mole ratio values above.

In the semiconductor nanoparticle, a mole ratio of silver to sulfur (Ag:S) may be greater than or equal to about 0.33:1, greater than or equal to about 0.35:1, greater than or equal to about 0.355:1, greater than or equal to about 0.37:1, greater than or equal to about 0.375:1, greater than or equal to about 0.38:1, greater than or equal to about 0.39:1, greater than or equal to about 0.4:1, or greater than or equal to about 0.41:1; less than or equal to about 0.5:1, less than or equal to about 0.45:1, less than or equal to about 0.44:1, less than or equal to about 0.43:1, less than or equal to about 0.42:1, less than or equal to about 0.41:1, less than or equal to about 0.4:1, less than or equal to about 0.39:1, less than or equal to about 0.38:1, less than or equal to about 0.36:1, or less than or equal to about 0.34:1; and/or a range of any two mole ratio values above.

In the semiconductor nanoparticle, a mole ratio of gallium to silver (Ga:Ag) may be greater than or equal to about 1:1, greater than or equal to about 1.1:1, greater than or equal to about 1.15:1, greater than or equal to about 1.19:1, greater than or equal to about 1.2:1, greater than or equal to about 1.25:1, greater than or equal to about 1.28:1, greater than or equal to about 1.29:1, greater than or equal to about 1.3:1, greater than or equal to about 1.35:1, greater than or equal to about 1.38:1, greater than or equal to about 1.4:1, greater than or equal to about 1.45:1, greater than or equal to about 1.5:1, greater than or equal to about 1.55:1, greater than or equal to about 1.6:1, greater than or equal to about 1.65:1, greater than or equal to about 1.7:1, greater than or equal to about 1.75:1, greater than or equal to about 1.8:1, greater than or equal to about 1.85:1, greater than or equal to about 1.9:1, greater than or equal to about 1.95:1, greater than or equal to about 2:1, or greater than or equal to about 2.05:1; less than or equal to about 3:1, less than or equal to about 2.9:1, less than or equal to about 2.8:1, less than or equal to about 2.7:1, less than or equal to about 2.6:1, less than or equal to about 2.5:1, less than or equal to about 2.4:1, less than or equal to about 2.3:1, less than or equal to about 2.2:1, less than or equal to about 2.1:1, less than or equal to about 2:1, less than or equal to about 1.9:1, less than or equal to about 1.8:1, less than or equal to about 1.75:1, less than or equal to about 1.7:1, less than or equal to about 1.65:1, less than or equal to about 1.6:1, less than or equal to about 1.58:1, less than or equal to about 1.56:1, less than or equal to about 1.52:1, less than or equal to about 1.48:1, less than or equal to about 1.46:1, less than or equal to about 1.44:1, or less than or equal to about 1.42:1; and/or a range of any two mole ratio values above.

In the semiconductor nanoparticle, a mole ratio of indium to a total of indium and gallium (In:(In+Ga)) may be less than or equal to about 0.2:1, less than or equal to about 0.12:1, less than or equal to about 0.1:1, less than or equal to about 0.09:1, less than or equal to about 0.05:1, less than or equal to about 0.049:1, less than or equal to about 0.048:1, less than or equal to about 0.047:1, less than or equal to about 0.046:1, less than or equal to about 0.045:1, less than or equal to about 0.04:1, less than or equal to about 0.035:1, or less than or equal to about 0.03:1; greater than or equal to about 0.01:1, greater than or equal to about 0.011:1, greater than or equal to about 0.015:1, greater than or equal to about 0.02:1, greater than or equal to about 0.023:1, greater than or equal to about 0.025:1, greater than or equal to about 0.026:1, greater than or equal to about 0.027:1, greater than or equal to about 0.028:1, greater than or equal to about 0.029:1, greater than or equal to about 0.03:1, greater than or equal to about 0.035:1, greater than or equal to about 0.04:1, or greater than or equal to about 0.041:1; and/or a range of any two mole ratio values above.

In the semiconductor nanoparticle, a mole ratio of a total of indium and gallium to silver ((In+Ga):Ag) may be greater than or equal to about 1.2:1, greater than or equal to about 1.3:1, greater than or equal to about 1.35:1, greater than or equal to about 1.4:1, greater than or equal to about 1.41:1, greater than or equal to about 1.43:1, greater than or equal to about 1.45:1, greater than or equal to about 1.46:1, greater than or equal to about 1.47:1, greater than or equal to about 1.48:1, greater than or equal to about 1.49:1, greater than or equal to about 1.5:1, greater than or equal to about 1.53:1, greater than or equal to about 1.54:1, greater than or equal to about 1.57:1, greater than or equal to about 1.58:1, greater than or equal to about 1.59:1, greater than or equal to about 1.6:1, greater than or equal to about 1.63:1, greater than or equal to about 1.65:1, greater than or equal to about 1.68:1, greater than or equal to about 1.7:1, greater than or equal to about 1.83:1, greater than or equal to about 1.9:1, greater than or equal to about 1.94:1, greater than or equal to about 2:1, greater than or equal to about 2.1:1, greater than or equal to about 2.15:1, or greater than or equal to about 2.19:1; less than or equal to about 3.5:1, less than or equal to about 3:1, less than or equal to about 2.4:1, less than or equal to about 2.37:1, less than or equal to about 2.3:1, less than or equal to about 2.25:1, less than or equal to about 2.2:1, less than or equal to about 2:1, less than or equal to about 1.96:1, less than or equal to about 1.95:1, less than or equal to about 1.9:1, less than or equal to about 1.7:1, or less than or equal to about 1.62:1; and/or a range of any two mole ratio values above.

In the semiconductor nanoparticle, a mole ratio of a total of indium and gallium to sulfur ((In+Ga):S) may be greater than or equal to about 0.3:1, greater than or equal to about 0.4:1, greater than or equal to about 0.45:1, greater than or equal to about 0.5:1, greater than or equal to about 0.52:1, greater than or equal to about 0.53:1, greater than or equal to about 0.54:1, greater than or equal to about 0.55:1, greater than or equal to about 0.56:1, greater than or equal to about 0.57:1, greater than or equal to about 0.58:1, greater than or equal to about 0.59:1, greater than or equal to about 0.6:1, greater than or equal to about 0.62:1, greater than or equal to about 0.64:1, greater than or equal to about 0.68:1, greater than or equal to about 0.7:1, greater than or equal to about 0.72:1, greater than or equal to about 0.75:1, greater than or equal to about 0.77:1, greater than or equal to about 0.78:1, greater than or equal to about 0.79:1, or greater than or equal to about 0.81:1; less than or equal to about 0.9:1, less than or equal to about 0.88:1, less than or equal to about 0.86:1, less than or equal to about 0.84:1, less than or equal to about 0.82:1, less than or equal to about 0.78:1, less than or equal to about 0.73:1, less than or equal to about 0.71:1, less than or equal to about 0.69:1, less than or equal to about 0.67:1, less than or equal to about 0.66:1, or less than or equal to about 0.65:1; and/or a range of any two mole ratio values above.

In the semiconductor nanoparticle, a mole ratio of silver to a total of silver, indium, and gallium (Ag:(Ag+In+Ga)) may be greater than or equal to about 0.31:1, greater than or equal to about 0.33:1, greater than or equal to about 0.34:1, greater than or equal to about 0.35:1, greater than or equal to about 0.37:1, greater than or equal to about 0.38:1, greater than or equal to about 0.39:1, greater than or equal to about 0.4:1, greater than or equal to about 0.41:1, greater than or equal to about 0.42:1, greater than or equal to about 0.43:1, or greater than or equal to about 0.44:1; less than or equal to about 0.55:1, less than or equal to about 0.5:1, less than or equal to about 0.45:1, less than or equal to about 0.42:1, less than or equal to about 0.4:1, less than or equal to about 0.36:1, less than or equal to about 0.33:1, less than or equal to about 0.32:1, or less than or equal to about 0.28:1; and/or a range of any two mole ratio values above.

In the semiconductor nanoparticle, a mole ratio of gallium to a total of gallium, indium, and silver (Ga:(Ga+In+Ag)) may be greater than or equal to about 0.45:1, greater than or equal to about 0.46:1, greater than or equal to about 0.47:1, greater than or equal to about 0.48:1, greater than or equal to about 0.49:1, greater than or equal to about 0.5:1, greater than or equal to about 0.51:1, greater than or equal to about 0.52:1, greater than or equal to about 0.53:1, greater than or equal to about 0.54:1, greater than or equal to about 0.55:1, greater than or equal to about 0.56:1, greater than or equal to about 0.57:1, greater than or equal to about 0.58:1, greater than or equal to about 0.59:1, greater than or equal to about 0.595:1, greater than or equal to about 0.6:1, greater than or equal to about 0.61:1, greater than or equal to about 0.63:1, greater than or equal to about 0.64:1, or greater than or equal to about 0.65:1; less than or equal to about 0.85:1, less than or equal to about 0.8:1, less than or equal to about 0.77:1, less than or equal to about 0.74:1, less than or equal to about 0.73:1, less than or equal to about 0.72:1, less than or equal to about 0.71:1, less than or equal to about 0.69:1, less than or equal to about 0.67:1, less than or equal to about 0.658:1, less than or equal to about 0.64:1, less than or equal to about 0.62:1, less than or equal to about 0.61:1, less than or equal to about 0.59:1, less than or equal to about 0.56:1, less than or equal to about 0.54:1, less than or equal to about 0.53:1, less than or equal to about 0.49:1, or less than or equal to about 0.485:1; and/or a range of any two mole ratio values above.

In the semiconductor nanoparticle, a mole ratio of sulfur to a total of silver, indium, and gallium (S:(Ag+In+Ga)) may be greater than or equal to about 0.85:1, greater than or equal to about 0.87:1, greater than or equal to about 0.88:1, greater than or equal to about 0.89:1, greater than or equal to about 0.9:1, greater than or equal to about 0.92:1, greater than or equal to about 0.95:1, greater than or equal to about 1:1, greater than or equal to about 1.02:1, greater than or equal to about 1.03:1, greater than or equal to about 1.04:1, greater than or equal to about 1.05:1, greater than or equal to about 1.06:1, greater than or equal to about 1.07:1, greater than or equal to about 1.08:1, greater than or equal to about 1.09:1, greater than or equal to about 1.1:1, greater than or equal to about 1.12:1, or greater than or equal to about 1.2:1; less than or equal to about 1.5:1, less than or equal to about 1.45:1, less than or equal to about 1.35:1, less than or equal to about 1.15:1, less than or equal to about 1.13:1, less than or equal to about 1.12:1, less than or equal to about 1.11:1, less than or equal to about 1.1:1, less than or equal to about 1.09:1, less than or equal to about 1.08:1, less than or equal to about 0.9:1, or less than or equal to about 0.89:1; and/or a range of any two mole ratio values above.

The semiconductor nanoparticle may have a charge balance value obtained by the following equation of greater than or equal to about 0.95, greater than or equal to about 0.98, greater than or equal to about 1, or greater than or equal to about 1.01, and less than or equal to about 1.45, less than or equal to about 1.4, less than or equal to about 1.35, less than or equal to about 1.3, less than or equal to about 1.25, less than or equal to about 1.2, less than or equal to about 1.15, less than or equal to about 1.1, less than or equal to about 1.09, less than or equal to about 1.08, less than or equal to about 1.07, less than or equal to about 1.06, or less than or equal to about 1.05:$charge balance value = \left\{\left[Ag\right]+3x\left(\left[In\right]+\left[Ga\right]\right)\right\} / \left(2x\left[S\right]\right)$
wherein [Ag], [In], [Ga], and [S] are mole amounts of silver, indium, gallium, and sulfur, respectively, in the semiconductor nanoparticle.

The semiconductor nanoparticle may further include a halogen (e.g., chlorine, bromine, or a combination thereof).

In the semiconductor nanoparticle, an amount of the halogen (e.g., chlorine, bromine, or a combination thereof) may be greater than or equal to about 0.4 mole% to less than or equal to about 3200 mole% based on indium, that is, greater than or equal to about 0.004 moles to less than or equal to about 32 moles of the halogen (chlorine, bromine, or a total thereof) per 1 mole of indium.

In the semiconductor nanoparticle, an amount of the halogen (e.g., chlorine, bromine, or a combination thereof) based on indium (or relative to indium or per 1 mole of indium) may be greater than or equal to about 0.01 mole% (for example, greater than or equal to about 0.0001 moles), greater than or equal to about 0.03 mole%, greater than or equal to about 0.05 mole%, greater than or equal to about 0.08 mole%, greater than or equal to about 0.1 mole%, greater than or equal to about 0.15 mole%, greater than or equal to about 0.25 mole%, greater than or equal to about 0.3 mole%, greater than or equal to about 0.35 mole%, greater than or equal to about 0.4 mole%, greater than or equal to about 0.45 mole%, greater than or equal to about 0.5 mole%, greater than or equal to about 0.6 mole%, greater than or equal to about 0.7 mole%, greater than or equal to about 0.8 mole%, greater than or equal to about 0.9 mole%, greater than or equal to about 1 mole%, greater than or equal to about 1.5 mole%, greater than or equal to about 2 mole%, greater than or equal to about 2.5 mole%, greater than or equal to about 3 mole%, greater than or equal to about 3.5 mole%, greater than or equal to about 4 mole%, greater than or equal to about 4.5 mole%, greater than or equal to about 5 mole%, greater than or equal to about 5.5 mole%, greater than or equal to about 6 mole%, greater than or equal to about 6.5 mole%, greater than or equal to about 7 mole%, greater than or equal to about 7.5 mole%, greater than or equal to about 8 mole%, greater than or equal to about 8.5 mole%, greater than or equal to about 9 mole%, greater than or equal to about 10 mole%, greater than or equal to about 13 mole%, greater than or equal to about 15 mole%, greater than or equal to about 17 mole%, greater than or equal to about 20 mole%, greater than or equal to about 25 mole%, greater than or equal to about 30 mole%, greater than or equal to about 35 mole%, greater than or equal to about 40 mole%, greater than or equal to about 45 mole%, greater than or equal to about 50 mole%, greater than or equal to about 60 mole%, greater than or equal to about 70 mole%, greater than or equal to about 80 mole%, greater than or equal to about 90 mole%, greater than or equal to about 100 mole%, greater than or equal to about 150 mole%, greater than or equal to about 200 mole%, greater than or equal to about 250 mole%, greater than or equal to about 300 mole%, greater than or equal to about 350 mole%, greater than or equal to about 400 mole%, or greater than or equal to about 450 mole%. The amount of the halogen (e.g., chlorine, bromine, or a combination thereof) may be less than or equal to about 3200 mole% (for example, less than or equal to about 32 moles) (Br:In about 32:1), less than or equal to about 3000 mole%, less than or equal to about 2500 mole%, less than or equal to about 2000 mole%, less than or equal to about 1500 mole%, less than or equal to about 1000 mole%, less than or equal to about 900 mole%, less than or equal to about 800 mole%, less than or equal to about 700 mole%, less than or equal to about 600 mole%, less than or equal to about 500 mole%, less than or equal to about 380 mole%, less than or equal to about 230 mole%, less than or equal to about 120 mole%, less than or equal to about 110 mole%, less than or equal to about 100 mole%, less than or equal to about 85 mole%, less than or equal to about 75 mole%, less than or equal to about 65 mole%, less than or equal to about 55 mole%, less than or equal to about 44 mole%, less than or equal to about 42 mole%, less than or equal to about 37 mole%, less than or equal to about 23 mole%, less than or equal to about 19 mole%, less than or equal to about 14 mole%, less than or equal to about 7.2 mole%, less than or equal to about 6.8 mole%, less than or equal to about 4.3 mole%, less than or equal to about 3.9 mole%, or less than or equal to about 2.3 mole%.

In an embodiment, the semiconductor nanoparticle may further include a layer (an additional shell layer) including an additional semiconductor nanocrystal on the semiconductor nanocrystal shell. The semiconductor nanocrystal may have a core-multishell structure, and may further include, on the semiconductor nanocrystal layer (e.g., a first shell layer), a second shell layer including a third semiconductor nanocrystal, and/or a third shell layer including a fourth semiconductor nanocrystal. In an embodiment, the third semiconductor nanocrystal may include zinc, gallium, and sulfur, and/or the fourth semiconductor nanocrystal may include zinc and sulfur. The third semiconductor nanocrystal may include a zinc gallium sulfide. The fourth semiconductor nanocrystal may include a zinc sulfide. A bandgap energy of the additional semiconductor nanocrystal (e.g., the third semiconductor nanocrystal or the fourth semiconductor nanocrystal) may be greater than a bandgap energy of the second semiconductor nanocrystal. A bandgap energy of the additional semiconductor nanocrystal (e.g., the third semiconductor nanocrystal or the fourth semiconductor nanocrystal) may be greater than a bandgap energy of the first semiconductor nanocrystal. A layer including the third semiconductor nanocrystal or the fourth semiconductor nanocrystal may be an outermost layer of the semiconductor nanoparticle.

In an embodiment, the semiconductor nanoparticle may have a core-shell structure or a core-multishell structure such as AgInGaS/AgGaS, AgInGaS/AgGaS/ZnGaS, AgInGaS/AgGaS/ZnS, AgInGaS/AgGaS/ZnGaS/ZnS, or the like.

The semiconductor nanoparticle of an embodiment may be prepared by a method described herein. In an embodiment, a method of preparing the semiconductor nanoparticle includes preparing a first medium including a sulfur precursor and an organic ligand in an organic solvent; heating the first medium to a first temperature; adding a first gallium halide to the heated first medium and maintaining for a first time to obtain a mixture; and adding, to the mixture, a first semiconductor nanocrystal including silver, indium, gallium, and sulfur, a silver compound, and an organic ligand, and heating to a first reaction temperature to obtain a particle including the first semiconductor nanocrystal and a second semiconductor nanocrystal including silver, gallium, and sulfur, e.g., an intermediate particle or a semiconductor nanoparticle.

The first gallium halide may include gallium bromide. Herein, when formation of the second semiconductor nanocrystal proceeds in a plurality of steps in the method of an embodiment, the intermediate particle refers to a particle isolated during formation of the semiconductor nanoparticle having a desired composition and size. The descriptions provided for the semiconductor nanoparticle may also be applied to the intermediate particle.

Details of the first semiconductor nanocrystal is as described herein. The first semiconductor nanocrystal includes silver (Ag), indium, gallium, and sulfur. A method of preparing the first semiconductor nanocrystal is not particularly limited and may be appropriately selected. In an embodiment, the first semiconductor nanocrystal may be obtained by contacting (or reacting) precursors required according to composition, e.g., a silver precursor, an indium precursor, a gallium precursor, and a sulfur precursor, in a solution including an organic ligand and an organic solvent at a predetermined core formation reaction temperature (e.g., 180 °C to 300 °C or 200 °C to 280 °C) for a predetermined time, and separating.

In an embodiment, the prepared first semiconductor nanocrystal may be separated and optionally washed. The separation and washing may be performed by the method described herein.

In the method of an embodiment, the core formation reaction temperature may be greater than or equal to about 120 °C, greater than or equal to about 180 °C, greater than or equal to about 190 °C, greater than or equal to about 200 °C, greater than or equal to about 205 °C, greater than or equal to about 210 °C, greater than or equal to about 220 °C, greater than or equal to about 230 °C, greater than or equal to about 240 °C, greater than or equal to about 245 °C, greater than or equal to about 250 °C, greater than or equal to about 255 °C, greater than or equal to about 260 °C, greater than or equal to about 265 °C, greater than or equal to about 270 °C, greater than or equal to about 275 °C, greater than or equal to about 280 °C, greater than or equal to about 285 °C, greater than or equal to about 290 °C, greater than or equal to about 295 °C, greater than or equal to about 300 °C, greater than or equal to about 305 °C, greater than or equal to about 310 °C, greater than or equal to about 315 °C, greater than or equal to about 320 °C, greater than or equal to about 330 °C, greater than or equal to about 335 °C, greater than or equal to about 340 °C, or greater than or equal to about 345 °C to less than or equal to about 380 °C, less than or equal to about 375 °C, less than or equal to about 370 °C, less than or equal to about 365 °C, less than or equal to about 360 °C, less than or equal to about 355 °C, less than or equal to about 350 °C, less than or equal to about 340 °C, less than or equal to about 330 °C, less than or equal to about 320 °C, less than or equal to about 310 °C, less than or equal to about 300 °C, less than or equal to about 290 °C, less than or equal to about 280 °C, less than or equal to about 270 °C, less than or equal to about 260 °C, or less than or equal to about 250 °C.

A core formation reaction time is not particularly limited, and may be appropriately selected in consideration of a desired size of the first semiconductor nanocrystal, an emission wavelength of the first semiconductor nanocrystal or the final semiconductor nanoparticle, reactivity of a precursor, and a reaction temperature. The core formation reaction time may be greater than or equal to about 1 minute, greater than or equal to about 3 minutes, greater than or equal to about 5 minutes, greater than or equal to about 10 minutes, greater than or equal to about 20 minutes, or greater than or equal to about 30 minutes. The core formation reaction time may be about 1 minute to about 2 hours, about 5 minutes to about 90 minutes, about 10 minutes to about 70 minutes, or a combination thereof.

In the method, the first medium may be pretreated (e.g., under vacuum). The first medium including a first sulfur precursor may be pretreated under a vacuum state. A pretreatment temperature may be lower than the first reaction temperature. The pretreatment temperature may be, for example, greater than or equal to about 20 °C, greater than or equal to about 25 °C, greater than or equal to about 80 °C, greater than or equal to about 100 °C, or greater than or equal to about 120 °C and less than or equal to about 200 °C, or less than or equal to about 180 °C.

In the method of an embodiment, the first medium including a first organic solvent and the first sulfur precursor is heated to a first temperature, and the first gallium halide is added to the heated first medium and maintained for a first time to provide a mixture.

A first semiconductor nanocrystal, a silver compound, and optionally an organic ligand are added to the mixture, and the mixture is heated to a reaction temperature to allow the reaction to proceed for a predetermined reaction time. The first semiconductor nanocrystal and the silver compound may be dispersed in an appropriate organic solvent and added to the reaction medium but are not limited thereto.

In the method of an embodiment, activating the gallium halide by adding the gallium halide to the reaction medium first may contribute to enabling the formed semiconductor nanoparticle to exhibit a concentration gradient of elements described herein and, for example, to have increased luminous efficiency.

The first temperature may be greater than or equal to about 120 °C, greater than or equal to about 190 °C, greater than or equal to about 200 °C, greater than or equal to about 210 °C, greater than or equal to about 220 °C, greater than or equal to about 230 °C, greater than or equal to about 240 °C, or greater than or equal to about 250 °C. The first injection temperature may be less than or equal to about 280 °C, less than or equal to about 275 °C, less than or equal to about 270 °C, less than or equal to about 265 °C, less than or equal to about 260 °C, less than or equal to about 255 °C, less than or equal to about 250 °C, less than or equal to about 240 °C, less than or equal to about 230 °C, less than or equal to about 220 °C, less than or equal to about 210 °C, less than or equal to about 200 °C, less than or equal to about 190 °C, less than or equal to about 180 °C, less than or equal to about 170 °C, less than or equal to about 160 °C, or less than or equal to about 150 °C.

The first time may be greater than or equal to about 1 minute, greater than or equal to about 3 minutes, greater than or equal to about 5 minutes, greater than or equal to about 7 minutes, greater than or equal to about 9 minutes, greater than or equal to about 10 minutes, or greater than or equal to about 15 minutes; and less than or equal to about 1 hour, less than or equal to about 50 minutes, less than or equal to about 30 minutes, less than or equal to about 25 minutes, less than or equal to about 20 minutes, less than or equal to about 15 minutes, or less than or equal to about 10 minutes.

The first temperature may be less than or equal to the reaction temperature. A difference between the first temperature and the reaction temperature may be greater than or equal to about 5 °C, greater than or equal to about 10 °C, greater than or equal to about 15 °C, greater than or equal to about 20 °C, greater than or equal to about 30 °C, greater than or equal to about 40 °C, greater than or equal to about 50 °C, greater than or equal to about 60 °C, greater than or equal to about 70 °C, greater than or equal to about 80 °C, or greater than or equal to about 90 °C; and less than or equal to about 200 °C, less than or equal to about 150 °C, less than or equal to about 100 °C, less than or equal to about 80 °C, or less than or equal to about 40 °C.

The reaction temperature may be greater than or equal to about 210 °C, greater than or equal to about 220 °C, greater than or equal to about 230 °C, greater than or equal to about 240 °C, greater than or equal to about 245 °C, greater than or equal to about 250 °C, greater than or equal to about 255 °C, greater than or equal to about 260 °C, greater than or equal to about 265 °C, greater than or equal to about 270 °C, greater than or equal to about 275 °C, greater than or equal to about 280 °C, greater than or equal to about 285 °C, greater than or equal to about 290 °C, greater than or equal to about 295 °C, greater than or equal to about 300 °C, greater than or equal to about 305 °C, greater than or equal to about 310 °C, greater than or equal to about 315 °C, greater than or equal to about 320 °C, greater than or equal to about 330 °C, greater than or equal to about 335 °C, greater than or equal to about 340 °C, or greater than or equal to about 345 °C; less than or equal to about 380 °C, less than or equal to about 375 °C, less than or equal to about 370 °C, less than or equal to about 365 °C, less than or equal to about 360 °C, less than or equal to about 355 °C, less than or equal to about 350 °C, less than or equal to about 340 °C, less than or equal to about 330 °C, less than or equal to about 320 °C, less than or equal to about 310 °C, less than or equal to about 300 °C, less than or equal to about 290 °C, less than or equal to about 280 °C, less than or equal to about 270 °C, less than or equal to about 260 °C, or less than or equal to about 250 °C; or a combination thereof. The first reaction temperature may be adjusted within the temperature range.

The predetermined reaction time may be appropriately controlled in consideration of precursors and a reaction temperature, and a desired size (or a peak emission wavelength, etc.) of an intermediate particle or a final semiconductor nanoparticle. In an embodiment, the reaction time may be greater than or equal to about 10 minutes, greater than or equal to about 15 minutes, greater than or equal to about 20 minutes, greater than or equal to about 30 minutes, greater than or equal to about 35 minutes, greater than or equal to about 40 minutes, greater than or equal to about 45 minutes, greater than or equal to about 50 minutes, greater than or equal to about 55 minutes, greater than or equal to about 60 minutes, greater than or equal to about 65 minutes, greater than or equal to about 70 minutes, greater than or equal to about 75 minutes, greater than or equal to about 80 minutes, greater than or equal to about 90 minutes, greater than or equal to about 2 hours, greater than or equal to about 150 minutes, greater than or equal to about 3 hours, greater than or equal to about 190 minutes, greater than or equal to about 200 minutes, greater than or equal to about 210 minutes, greater than or equal to about 220 minutes, greater than or equal to about 230 minutes, greater than or equal to about 4 hours, greater than or equal to about 250 minutes, greater than or equal to about 260 minutes, greater than or equal to about 270 minutes, or greater than or equal to about 280 minutes. The reaction time may be less than or equal to about 10 hours, less than or equal to about 6 hours, less than or equal to about 5 hours, less than or equal to about 4 hours, or less than or equal to about 3 hours. In an embodiment, the reaction time may be greater than or equal to about 1 hour and less than or equal to about 5 hours, greater than or equal to about 2 hours and less than or equal to about 4 hours, or greater than or equal to about 3 hours and less than or equal to about 3 hours and 30 minutes.

The first gallium halide may include gallium chloride, gallium bromide, or gallium chloride and gallium bromide. In an embodiment, the first gallium halide may include gallium chloride. In an embodiment, the first gallium halide may include gallium bromide and optionally gallium chloride. In an embodiment, an amount of gallium chloride relative to 1 mole of gallium bromide in the first gallium halide may be greater than or equal to about 0 moles, greater than or equal to about 0.005 moles, greater than or equal to about 0.01 moles, greater than or equal to about 0.05 moles, greater than or equal to about 0.1 moles, or greater than or equal to about 0.15 moles. In an embodiment, the amount of gallium chloride relative to 1 mole of gallium bromide in the first gallium halide may be less than or equal to about 0.2 moles. Without wishing to be bound by any theory, in the method of an embodiment, employing gallium bromide as a gallium precursor (and optionally adding a silver compound as described below) is believed to contribute to controlling the composition of the final semiconductor nanoparticle as described herein (for example, when using GaBr₃, an excessive amount of Ag on the surface may be removed to suppress a trap ratio), and accordingly, the final nanoparticle thus obtained may exhibit enhanced stability and a suppressed trap ratio compared with a semiconductor nanoparticle prepared by a conventional technique.

The first gallium halide may be dispersed in an appropriate organic solvent (e.g., an aromatic solvent such as toluene, octadecene, an aliphatic, aromatic phosphine compound such as TOP, or an aliphatic or aromatic phosphine oxide compound such as TOPO) and added to the first reaction medium but is not limited thereto.

An amount of the silver compound may be greater than or equal to about 0.01 mole% (that is, greater than or equal to about 0.0001 moles), greater than or equal to about 0.1 mole% (that is, greater than or equal to about 0.001 moles), greater than or equal to about 0.5 mole%, greater than or equal to about 0.7 mole%, greater than or equal to about 0.9 mole%, greater than or equal to about 1 mole% (that is, greater than or equal to about 0.01 moles), or greater than or equal to about 3 mole% relative to the first gallium halide (for example, per 1 mole of the first gallium halide). The amount of the silver compound may be greater than or equal to about 1 mole%, greater than or equal to about 1.5 mole%, greater than or equal to about 2 mole%, greater than or equal to about 2.5 mole%, greater than or equal to about 3 mole%, greater than or equal to about 3.5 mole%, greater than or equal to about 4 mole%, greater than or equal to about 4.5 mole%, greater than or equal to about 5 mole%, greater than or equal to about 5.5 mole%, greater than or equal to about 6 mole%, greater than or equal to about 6.5 mole%, greater than or equal to about 7 mole%, greater than or equal to about 7.5 mole%, greater than or equal to about 8 mole%, greater than or equal to about 8.5 mole%, greater than or equal to about 9 mole%, greater than or equal to about 9.5 mole%, greater than or equal to about 10 mole%, greater than or equal to about 11 mole%, greater than or equal to about 12 mole%, greater than or equal to about 13 mole%, greater than or equal to about 14 mole%, or greater than or equal to about 15 mole% relative to the first gallium halide. The amount of the silver compound may be less than or equal to about 50 mole%, less than or equal to about 30 mole%, less than or equal to about 25 mole%, less than or equal to about 20 mole%, less than or equal to about 18 mole%, less than or equal to about 17 mole%, less than or equal to about 16 mole%, less than or equal to about 15 mole%, less than or equal to about 14 mole%, less than or equal to about 13 mole%, less than or equal to about 12 mole%, less than or equal to about 11 mole%, less than or equal to about 10 mole%, less than or equal to about 9 mole%, less than or equal to about 8 mole%, less than or equal to about 7 mole%, less than or equal to about 6 mole%, less than or equal to about 5 mole%, less than or equal to about 4 mole%, or less than or equal to about 3 mole% relative to the first gallium halide. The amount of the silver compound may be greater than or equal to about 1 mole%, or greater than or equal to about 4.2 mole% and less than or equal to about 12 mole%, or less than or equal to about 8 mole% relative to the first gallium halide.

The silver compound may include a silver powder, an alkylated silver compound, a silver alkoxide, a silver carboxylate, a silver acetylacetonate, a silver nitrate, a silver sulfate, a silver halide, a silver cyanide, a silver hydroxide, a silver oxide, a silver peroxide, a silver carbonate, or a combination thereof. The first silver compound may include a silver nitrate, a silver acetate, a silver acetylacetonate, a silver chloride, a silver bromide, a silver fluoride, or a combination thereof.

A manner of adding the silver compound to the first reaction medium (e.g., an order of addition or a form of addition) is not particularly limited. The first silver compound may be added in a state dissolved in an appropriate organic solvent (e.g., an organic solvent described herein, for example, an amine-based solvent such as oleyl amine, or a phosphine-based solvent such as trioctylphosphine). A timing of adding the first silver compound is not particularly limited and may be appropriately selected. The first silver compound may be added to the first reaction medium before addition of the first semiconductor nanocrystal, simultaneously with the addition thereof, or after the addition thereof.

An amount of the first gallium halide used relative to the first sulfur precursor may be appropriately adjusted in consideration of a composition of the final semiconductor nanoparticle, a type of precursor, and a reaction temperature. According to the method of an embodiment, the amount of the first gallium halide relative to the first sulfur precursor may be greater than or equal to about 0.5 moles, greater than or equal to about 0.55 moles, greater than or equal to about 0.6 moles, greater than or equal to about 0.65 moles, greater than or equal to about 0.7 moles, greater than or equal to about 0.71 moles, greater than or equal to about 0.75 moles, greater than or equal to about 0.77 moles, greater than or equal to about 0.8 moles, greater than or equal to about 0.85 moles, greater than or equal to about 0.9 moles, greater than or equal to about 0.95 moles, greater than or equal to about 1 mole, greater than or equal to about 1.05 moles, greater than or equal to about 1.1 moles, greater than or equal to about 1.12 moles, greater than or equal to about 1.15 moles, greater than or equal to about 1.2 moles, greater than or equal to about 1.25 moles, greater than or equal to about 1.3 moles, greater than or equal to about 1.35 moles, greater than or equal to about 1.4 moles, or greater than or equal to about 1.45 moles per 1 mole of the first sulfur precursor; less than or equal to about 10 moles, less than or equal to about 9.5 moles, less than or equal to about 9 moles, less than or equal to about 8.5 moles, less than or equal to about 8 moles, less than or equal to about 7.5 moles, less than or equal to about 7 moles, less than or equal to about 6.5 moles, less than or equal to about 6 moles, less than or equal to about 5.5 moles, less than or equal to about 5 moles, less than or equal to about 4.5 moles, less than or equal to about 4 moles, less than or equal to about 3.5 moles, less than or equal to about 3 moles, less than or equal to about 2.5 moles, less than or equal to about 2 moles, less than or equal to about 1.5 moles, less than or equal to about 1.3 moles, less than or equal to about 1 mole, or less than or equal to about 0.98 moles per 1 mole of the first sulfur precursor; and/or a range of any two values above.

By the reaction, a particle including a second semiconductor nanocrystal including silver, gallium, and sulfur on the first semiconductor nanocrystal, for example, an intermediate particle or a semiconductor nanoparticle, may be obtained.

In the method of an embodiment, formation of the second semiconductor nanocrystal may proceed in multiple steps. Accordingly, the method may further include separating the formed intermediate particle; preparing a second medium (or a second reaction medium) including a sulfur precursor and an organic ligand in an organic solvent; heating the second medium to a reaction temperature; and adding the separated intermediate particle, a second gallium halide, and a silver compound to the second medium and maintaining at the reaction temperature.

In an embodiment, the separated intermediate particle may be washed with a washing solvent before being added to the second medium. The washing solvent may include a polar organic solvent (e.g., a C1 to C10 alcohol solvent, a C3 to C30 ketone solvent, a nitrile solvent) or a mixture thereof. When a semiconductor nanoparticle is prepared through a subsequent reaction from the intermediate particle subjected to such separation and optional washing, even at an increased gallium mole ratio, desired optical property (e.g., an emission wavelength, increased quantum efficiency, suppressed trap emission, a significantly reduced full width at half maximum) and improved process stability upon forming a composite may be exhibited.

The separated intermediate particle, a second gallium halide, and a silver compound may be added to the second medium. A manner of addition (e.g., an order of addition or a form of addition) is not particularly limited. The separated intermediate particle may be dispersed in an appropriate organic solvent and added to the second reaction medium, but is not limited thereto.

In the method, the second medium may be pretreated. The second medium (e.g., including a second sulfur precursor) may be pretreated under vacuum before addition of the separated intermediate particle or the second gallium halide. Details of the pretreatment may refer to those described above.

The separated intermediate particle may be combined (or contacted) with a sulfur precursor, a gallium precursor, and a silver compound in the second medium, and the second medium may be heated to a second reaction temperature (e.g., for a second reaction time) to obtain a final semiconductor nanoparticle in which a second semiconductor nanocrystal is further formed on the intermediate particle. By the heating, a reaction between the sulfur precursor, the second gallium halide, and the silver compound may be performed in the presence of the intermediate particle.

The method of an embodiment may include heating the second medium to an injection temperature under vacuum or under an inert atmosphere, and adding the intermediate particle, the second gallium halide, the silver compound, or a combination thereof to the second medium heated to the injection temperature. The method of an embodiment may include heating a reaction mixture including the intermediate particle, the second gallium halide, the second sulfur precursor, and the second silver compound to a reaction temperature. For the injection temperature, reference may be made to the details of the first temperature described above, and the reaction temperature is the same as described herein.

Details of a type, an amount, and a manner of addition of the second gallium halide may refer to those described above with respect to the first gallium halide.

An amount of the second gallium halide used relative to the sulfur precursor may be appropriately adjusted in consideration of a composition of the final semiconductor nanoparticle, a type of precursor, and a reaction temperature. According to the method of an embodiment, the amount of the second gallium halide relative to the sulfur precursor may be greater than or equal to about 0.5 moles, greater than or equal to about 0.55 moles, greater than or equal to about 0.6 moles, greater than or equal to about 0.65 moles, greater than or equal to about 0.7 moles, greater than or equal to about 0.75 moles, greater than or equal to about 0.8 moles, greater than or equal to about 0.85 moles, greater than or equal to about 0.9 moles, greater than or equal to about 0.95 moles, greater than or equal to about 1 mole, greater than or equal to about 1.05 moles, greater than or equal to about 1.1 moles, greater than or equal to about 1.12 moles, greater than or equal to about 1.15 moles, greater than or equal to about 1.2 moles, greater than or equal to about 1.25 moles, greater than or equal to about 1.3 moles, greater than or equal to about 1.35 moles, greater than or equal to about 1.4 moles, or greater than or equal to about 1.45 moles per 1 mole of the sulfur precursor; less than or equal to about 10 moles, less than or equal to about 9.5 moles, less than or equal to about 9 moles, less than or equal to about 8.5 moles, less than or equal to about 8 moles, less than or equal to about 7.5 moles, less than or equal to about 7 moles, less than or equal to about 6.5 moles, less than or equal to about 6 moles, less than or equal to about 5.5 moles, less than or equal to about 5 moles, less than or equal to about 4.5 moles, less than or equal to about 4 moles, less than or equal to about 3.5 moles, less than or equal to about 3 moles, less than or equal to about 2.5 moles, less than or equal to about 2 moles, less than or equal to about 1.5 moles, less than or equal to about 1 mole, or less than or equal to about 0.98 moles per 1 mole of the sulfur precursor ; and/or a range of any two values above.

In an embodiment, a mole ratio of the first gallium halide to the second gallium halide may be 1:0.1 to 1:10, 1:0.3 to 1:3, 1:0.4 to 1:2.5, 1:0.5 to 1:2, 1:0.6 to 1:1.8, 1:0.65 to 1:1.3, 1:0.7 to 1:1.2, 1:0.8 to 1:1.1, or a combination thereof, but is not limited thereto. In the method of an embodiment, a mole ratio of the second gallium halide to the first gallium halide (second gallium halide:first gallium halide) may be greater than or equal to about 0.1:1, greater than or equal to about 0.15:1, greater than or equal to about 0.2:1, greater than or equal to about 0.25:1, greater than or equal to about 0.3:1, greater than or equal to about 0.35:1, greater than or equal to about 0.4:1, greater than or equal to about 0.45:1, greater than or equal to about 0.5:1, greater than or equal to about 0.55:1, greater than or equal to about 0.6:1, greater than or equal to about 0.64:1, greater than or equal to about 0.7:1, greater than or equal to about 0.76:1, greater than or equal to about 0.8:1, greater than or equal to about 0.81:1, greater than or equal to about 0.9:1, greater than or equal to about 0.91:1, greater than or equal to about 0.94:1, greater than or equal to about 1:1, greater than or equal to about 1.07:1, greater than or equal to about 1.1:1, greater than or equal to about 1.15:1, greater than or equal to about 1.2:1, greater than or equal to about 1.25:1, greater than or equal to about 1.3:1, greater than or equal to about 1.35:1, greater than or equal to about 1.4:1, greater than or equal to about 1.46:1, or greater than or equal to about 1.5:1.

Relative to 1 mole of an indium precursor added in synthesis of the first semiconductor nanocrystal (or core), a total amount of the first gallium halide and the second gallium halide may be greater than or equal to about 10 moles, greater than or equal to about 20 moles, greater than or equal to about 30 moles, greater than or equal to about 40 moles, greater than or equal to about 50 moles, greater than or equal to about 100 moles, greater than or equal to about 150 moles, greater than or equal to about 200 moles, greater than or equal to about 250 moles, greater than or equal to about 300 moles, greater than or equal to about 310 moles, greater than or equal to about 350 moles, greater than or equal to about 400 moles, greater than or equal to about 450 moles, greater than or equal to about 500 moles, greater than or equal to about 550 moles, greater than or equal to about 600 moles, greater than or equal to about 650 moles, greater than or equal to about 700 moles, greater than or equal to about 750 moles, greater than or equal to about 800 moles, greater than or equal to about 850 moles, greater than or equal to about 900 moles, greater than or equal to about 950 moles, greater than or equal to about 1000 moles, greater than or equal to about 1050 moles, greater than or equal to about 1100 moles, greater than or equal to about 1150 moles, or greater than or equal to about 1200 moles. Relative to 1 mole of the indium precursor added in synthesis of the first semiconductor nanocrystal (or core), the total amount of the first gallium halide and the second gallium halide may be less than or equal to about 5000 moles, less than or equal to about 3000 moles, less than or equal to about 2000 moles, less than or equal to about 1800 moles, less than or equal to about 1500 moles, less than or equal to about 1080 moles, or less than or equal to about 1000 moles.

Formation of an additional semiconductor nanocrystal layer (e.g., including a third or fourth semiconductor nanocrystal)

In an embodiment, the method may further include:
preparing an additional reaction medium including an organic solvent and an organic ligand; heating the additional reaction medium; and
contacting (reacting), for example at a reaction temperature, a zinc precursor, a gallium precursor, and a sulfur precursor in the additional reaction medium in the presence of a first semiconductor nanocrystal including indium, gallium, silver, and sulfur or a particle including the same (e.g., the semiconductor nanoparticle) to form a third semiconductor nanocrystal. The third semiconductor nanocrystal may include zinc gallium sulfide (ZnGaS). Details of the third semiconductor nanocrystal are as described herein.

The method may further include preparing an additional reaction medium including an organic ligand in an organic solvent; heating the additional reaction medium; and, in the presence of the formed semiconductor nanoparticle, contacting (e.g., reacting) a zinc precursor and a chalcogen precursor (e.g., a sulfur precursor), for example at a reaction temperature, to provide a fourth semiconductor nanocrystal including zinc chalcogenide or an outer layer including the same on a surface of the semiconductor nanoparticle. Details of the fourth semiconductor nanocrystal are as described herein.

In an embodiment, a reaction temperature for formation of the third semiconductor nanocrystal or the fourth semiconductor nanocrystal may be greater than or equal to about 120 °C, greater than or equal to about 130 °C, greater than or equal to about 150 °C, greater than or equal to about 180 °C, greater than or equal to about 200 °C, greater than or equal to about 205 °C, greater than or equal to about 208 °C, and less than or equal to about 240 °C, less than or equal to about 230 °C, less than or equal to about 225 °C, or less than or equal to about 215 °C.

A time for the reaction for formation of the third semiconductor nanocrystal or the fourth semiconductor nanocrystal may be greater than or equal to about 10 minutes, greater than or equal to about 30 minutes, greater than or equal to about 40 minutes, greater than or equal to about 1 hour, greater than or equal to about 80 minutes, or greater than or equal to about 90 minutes, and less than or equal to about 5 hours, less than or equal to about 4 hours, less than or equal to about 3 hours, less than or equal to about 2 hours, less than or equal to about 90 minutes, or less than or equal to about 70 minutes.

In the method of an embodiment, a manner of adding a precursor to the (e.g., heated) reaction medium may include shot addition (e.g., syringe addition), dropwise addition, or a combination thereof.

A type of a silver precursor (e.g., for formation of a core) is not particularly limited and may be appropriately selected. The silver precursor or the silver compound may include silver powder, an alkylated silver compound, a silver alkoxide, a silver carboxylate, silver acetylacetonate, silver nitrate, silver sulfate, a silver halide, silver cyanide, silver hydroxide, silver oxide, silver peroxide, silver carbonate, or a combination thereof. The silver precursor may include silver nitrate, silver acetate, silver acetylacetonate, or a combination thereof.

A type of an indium precursor (e.g., for formation of a core) is not particularly limited and may be appropriately selected. The indium precursor may include indium powder, an alkylated indium compound, an indium alkoxide, an indium carboxylate, indium nitrate, indium perchlorate, indium sulfate, indium acetylacetonate, an indium halide, indium cyanide, indium hydroxide, indium oxide, indium peroxide, indium carbonate, or a combination thereof. The indium precursor may include an indium carboxylate such as indium oleate, indium myristate, or indium acetate, indium hydroxide, indium chloride, indium bromide, indium iodide, or a combination thereof.

A type of a sulfur precursor is not particularly limited and may be appropriately selected. The sulfur precursor may include a dispersion or a reaction product of sulfur in an organic solvent (for example, octadecene sulfide (S-ODE), trioctylphosphine sulfide (STOP), tributylphosphine sulfide (S-TBP), triphenylphosphine sulfide (S-TPP), trioctylamine sulfide (S-TOA)), a trimethylsilyl alkyl sulfide, a trimethylsilyl sulfide, mercaptopropyl silane, ammonium sulfide, sodium sulfide, a C1 to C30 thiol compound (for example, alpha-toluenethiol, octanethiol, dodecanethiol, octadecenethiol, or the like), an isothiocyanate compound (e.g., cyclohexyl isothiocyanate), an alkylene trithiocarbonate (e.g., ethylene trithiocarbonate), allyl mercaptan, a thiourea compound (for example, dimethyl thiourea, diethyl thiourea, ethylmethyl thiourea, dipropyl thiourea, that is, a dialkyl thiourea having a C1 to C40 alkyl group), or a combination thereof. The sulfur precursor may include a thiol compound, an isothiocyanate compound, a thiourea compound, or a combination thereof.

A type of a zinc precursor is not particularly limited and may be appropriately selected. For example, the zinc precursor may include Zn metal powder, an alkylated Zn compound, a Zn alkoxide, a Zn carboxylate, Zn nitrate, Zn perchlorate, Zn sulfate, Zn acetylacetonate, a Zn halide, Zn cyanide, Zn hydroxide, Zn oxide, Zn peroxide, or a combination thereof. The zinc precursor may include dimethylzinc, diethylzinc, zinc acetate, zinc acetylacetonate, zinc iodide, zinc bromide, zinc chloride, zinc fluoride, zinc carbonate, zinc cyanide, zinc nitrate, zinc oxide, zinc peroxide, zinc perchlorate, zinc sulfate, or the like. In an embodiment, upon formation of the second semiconductor nanocrystal, the zinc precursor may include a Zn halide.

A type of a gallium precursor used in preparation of the first semiconductor nanocrystal or the additional semiconductor nanocrystal is not particularly limited and may be appropriately selected. The gallium precursor may include gallium powder, an alkylated gallium compound, a gallium alkoxide, a gallium carboxylate, gallium nitrate, gallium perchlorate, gallium sulfate, gallium acetylacetonate, a gallium halide, gallium cyanide, gallium hydroxide, gallium oxide, gallium peroxide, gallium carbonate, or a combination thereof. The gallium precursor may include gallium chloride, gallium iodide, gallium bromide, gallium acetate, gallium acetylacetonate, gallium oleate, gallium palmitate, gallium stearate, gallium myristate, gallium hydroxide, or a combination thereof.

The organic ligand may include RCOOH, RNH₂, R₂NH, R₃N, RSH, RH₂PO, R₂HPO, R₃PO, RH₂P, R₂HP, R₃P, ROH, RCOOR', RPO(OH)₂, RHPOOH, R₂POOH, or a combination thereof, where R and R' are each independently a substituted or unsubstituted C1 to C40 (or C3 to C24) aliphatic hydrocarbon group (e.g., an alkyl group, an alkenyl group, or an alkynyl group), a substituted or unsubstituted C6 to C40 (or C6 to C24) aromatic hydrocarbon group (e.g., a C6 to C20 aryl group), or a combination thereof. The organic ligand may be bound to the surface of the formed nanoparticle. The organic ligand may include methanethiol, ethanethiol, propanethiol, butanethiol, pentanethiol, hexanethiol, heptanethiol, octanethiol, nonanethiol, decanethiol, dodecanethiol, hexadecanethiol, octadecanethiol, benzylthiol; methylamine, ethylamine, propylamine, butylamine, pentylamine, hexylamine, octylamine, dodecylamine, hexadecylamine, octadecylamine, dimethylamine, diethylamine, dipropylamine; methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, benzoic acid; substituted or unsubstituted methylphosphine (e.g., trimethylphosphine, methyldiphenylphosphine), substituted or unsubstituted ethylphosphine (e.g., triethylphosphine, ethyldiphenylphosphine), substituted or unsubstituted propylphosphine, butylphosphine, pentylphosphine, octylphosphine (e.g., trioctylphosphine (TOP)); substituted or unsubstituted methylphosphine oxide (e.g., trimethylphosphine oxide, methyldiphenylphosphine oxide), ethylphosphine oxide (e.g., triethylphosphine oxide, ethyldiphenylphosphine oxide), propylphosphine oxide, butylphosphine oxide, octylphosphine oxide (e.g., trioctylphosphine oxide (TOPO)); diphenylphosphine, triphenylphosphine compound, or an oxide thereof; phosphonic acid, hexylphosphonic acid, octylphosphonic acid, dodecylphosphonic acid, tetradecylphosphonic acid, hexadecylphosphonic acid, octadecylphosphonic acid, a C5 to C20 alkylphosphonic acid, or a combination thereof. The organic ligand may be used alone or as a mixture of two or more.

The organic solvent may be at least one of an amine solvent (e.g., a C1 to C50 aliphatic amine), a nitrogen-includingheterocyclic compound such as pyridine; a C6 to C40 aliphatic hydrocarbon (e.g., an alkane, alkene, or alkyne) such as hexadecane, octadecane, octadecene, or squalane; a C6 to C30 aromatic hydrocarbon such as phenyldodecane, phenyltetradecane, or phenylhexadecane; a phosphine substituted with a C6 to C22 alkyl group such as trioctylphosphine; a phosphine oxide substituted with a C6 to C22 alkyl group such as trioctylphosphine oxide; a C12 to C22 aromatic ether such as phenyl ether or benzyl ether; or a combination thereof. The amine solvent may be a compound having one or more (e.g., two or three) C1 to C50, C2 to C45, C3 to C40, C4 to C35, C5 to C30, C6 to C25, C7 to C20, C8 to C15, or C6 to C22 aliphatic hydrocarbon groups (alkyl, alkenyl, or alkynyl). In an embodiment, the amine solvent may include a C6 to C22 primary amine such as hexadecylamine or oleylamine; a C6 to C22 secondary amine such as dioctylamine; a C6 to C22 tertiary amine such as trioctylamine; or a combination thereof.

The amount of the organic ligand and each precursor in the reaction medium may be appropriately selected in consideration of the type of solvent, the types of the organic ligand and each precursor, and the desired size and composition of the particle. The mole ratio among the respective precursors may be appropriately selected in view of the desired mole ratio in the final nanoparticles and the reactivity among the respective precursors. The method of adding each precursor is not particularly limited. Each precursor may be injected in portions one or more times, for example, two or more times and up to ten times. Each precursor may be added simultaneously or sequentially. The reaction may be carried out under an inert gas atmosphere, in air, or under vacuum, but is not limited thereto.

As a nonsolvent is added to the final reaction solution after completion of the reaction, nanoparticles (e.g., coordinated with the organic ligand) may be separated (e.g., precipitated). The nonsolvent may be a polar solvent that is miscible with the solvent used in the reaction but cannot disperse the nanocrystals. The nonsolvent may be selected depending on the solvent used in the reaction and may be for example, acetone, ethanol, butanol, isopropanol, ethanediol, water, tetrahydrofuran (THF), dimethylsulfoxide (DMSO), diethylether, formaldehyde, acetaldehyde, a solvent having a similar solubility parameter to the foregoing solvents, or a combination thereof. The separation may be performed by centrifugation, precipitation, chromatography, or distillation. Separated nanocrystals may be washed by adding to a washing solvent as needed. The washing solvent is not particularly limited, and a solvent having a solubility parameter similar to that of the organic solvent or ligand may be used. The nonsolvent or washing solvent may be alcohols; alkane solvents, such as hexane, heptane, octane, or the like; aromatic solvents, such as toluene, benzene, or the like; halogenated solvent, such as chloroform or the like; or a combination thereof, but is not limited thereto.

The semiconductor nanoparticle thus prepared may be dispersed in a dispersion solvent. The semiconductor nanoparticle thus prepared may form an organic solvent dispersion. The organic solvent dispersion may not include water and/or an organic solvent miscible with water. The dispersion solvent may be appropriately selected. The dispersion solvent may include the aforementioned organic solvent. The dispersion solvent may include a substituted or unsubstituted C1 to C40 aliphatic hydrocarbon, a substituted or unsubstituted C6 to C40 aromatic hydrocarbon, or a combination thereof.

In an embodiment, the semiconductor nanoparticle may be configured to emit green light. A peak emission wavelength of the green light or the semiconductor nanoparticle may be greater than or equal to about 500 nm, or greater than or equal to about 505 nm and less than or equal to about 580 nm, or less than or equal to about 550 nm. The peak emission wavelength of the green light or the semiconductor nanoparticle may be greater than or equal to about 500 nm, greater than or equal to about 505 nm, greater than or equal to about 510 nm, greater than or equal to about 514 nm, greater than or equal to about 515 nm, greater than or equal to about 517 nm, greater than or equal to about 519 nm, greater than or equal to about 520 nm, greater than or equal to about 525 nm, greater than or equal to about 530 nm, greater than or equal to about 535 nm, greater than or equal to about 540 nm, or greater than or equal to about 545 nm; and less than or equal to about 580 nm, less than or equal to about 575 nm, less than or equal to about 570 nm, less than or equal to about 565 nm, less than or equal to about 560 nm, less than or equal to about 555 nm, less than or equal to about 550 nm, less than or equal to about 545 nm, less than or equal to about 540 nm, less than or equal to about 535 nm, less than or equal to about 530 nm, less than or equal to about 525 nm, less than or equal to about 520 nm, or less than or equal to about 515 nm.

In an embodiment, the semiconductor nanoparticle may be configured to emit red light. A peak emission wavelength of the red light or the semiconductor nanoparticle may be greater than or equal to about 600 nm, greater than or equal to about 605 nm, greater than or equal to about 610 nm, and less than or equal to about 650 nm, or less than or equal to about 640 nm, or less than or equal to about 630 nm.

In an embodiment, the semiconductor nanoparticle may exhibit a quantum yield (e.g., an absolute quantum yield) of greater than or equal to about 70%. The quantum yield may be an absolute quantum yield. The (e,g, absolute) quantum yield may be greater than or equal to about 70%, greater than or equal to about 71%, greater than or equal to about 72%, greater than or equal to about 73%, greater than or equal to about 74%, greater than or equal to about 75%, greater than or equal to about 76%, greater than or equal to about 77%, greater than or equal to about 78%, greater than or equal to about 79%, greater than or equal to about 80%, greater than or equal to about 81%, greater than or equal to about 82%, greater than or equal to about 83%, greater than or equal to about 84%, greater than or equal to about 85%, greater than or equal to about 86%, greater than or equal to about 87%, greater than or equal to about 88%, greater than or equal to about 89%, greater than or equal to about 90%, greater than or equal to about 91%, greater than or equal to about 92%, greater than or equal to about 93%, greater than or equal to about 94%, or greater than or equal to about 95%; and may be less than or equal to about 100%, less than or equal to about 99.5%, less than or equal to about 99%, less than or equal to about 98%, or less than or equal to about 97%.

The light (e.g., the first light) emitted by the semiconductor nanoparticle or the green light may have a full width at half maximum (FWHM) that is greater than or equal to about 5 nm, greater than or equal to about 10 nm, greater than or equal to about 15 nm, greater than or equal to about 20 nm, greater than or equal to about 25 nm, or greater than or equal to about 30 nm. The light (e.g., the first light) emitted by the semiconductor nanoparticle or the green light may have a full width at half maximum (FWHM) that is less than or equal to about 70 nm, less than or equal to about 65 nm, less than or equal to about 60 nm, less than or equal to about 55 nm, less than or equal to about 50 nm, less than or equal to about 45 nm, less than or equal to about 40 nm, less than or equal to about 38 nm, less than or equal to about 36 nm, less than or equal to about 35 nm, less than or equal to about 34 nm, less than or equal to about 33 nm, less than or equal to about 32 nm, less than or equal to about 31 nm, less than or equal to about 30 nm, less than or equal to about 29 nm, less than or equal to about 28 nm, less than or equal to about 27 nm, less than or equal to about 26 nm, or less than or equal to about 25 nm.

In an embodiment, the first light (e.g., a green light or a red light) may include band-edge emission. In an embodiment, the light emitted from the semiconductor nanoparticle may further include defect site emission or trap emission. The band-edge emission may be centered at a higher energy (lower wavelength) with a smaller offset from the absorption onset energy compared to the trap emission. The band-edge emission may have a narrower wavelength distribution than the trap emission. The band-edge emission may have a normal (e.g., Gaussian) wavelength distribution.

A shape of the produced semiconductor nanoparticle is not particularly limited and may include, for example, a spherical shape, a polyhedral shape, a pyramidal shape, a multipod shape, a cubic shape, a nanotube, a nanowire, a nanofiber, a nanosheet, or a combination thereof, but is not limited thereto.

In an embodiment, a size or an average size (hereinafter simply referred to as "size") of the semiconductor nanoparticle may be greater than or equal to about 1 nm, greater than or equal to about 1.5 nm, greater than or equal to about 2 nm, greater than or equal to about 2.5 nm, greater than or equal to about 3 nm, greater than or equal to about 3.5 nm, greater than or equal to about 4 nm, greater than or equal to about 4.5 nm, greater than or equal to about 5 nm, greater than or equal to about 5.5 nm, greater than or equal to about 6 nm, greater than or equal to about 6.5 nm, greater than or equal to about 7 nm, greater than or equal to about 7.5 nm, greater than or equal to about 8 nm, greater than or equal to about 8.5 nm, greater than or equal to about 9 nm, greater than or equal to about 9.5 nm, greater than or equal to about 10 nm, or greater than or equal to about 10.5 nm. The size of the semiconductor nanoparticle may be less than or equal to about 50 nm, less than or equal to about 48 nm, less than or equal to about 46 nm, less than or equal to about 44 nm, less than or equal to about 42 nm, less than or equal to about 40 nm, less than or equal to about 35 nm, less than or equal to about 30 nm, less than or equal to about 25 nm, less than or equal to about 20 nm, less than or equal to about 18 nm, less than or equal to about 16 nm, less than or equal to about 14 nm, less than or equal to about 12 nm, less than or equal to about 11 nm, less than or equal to about 10 nm, less than or equal to about 8 nm, less than or equal to about 7 nm, less than or equal to about 6 nm, or less than or equal to about 4 nm; or a range of a combinations thereof..

In an embodiment, the size of the semiconductor nanoparticle may be a particle diameter. The size of the semiconductor nanoparticle may be obtained from an image identified by an electron microscopy (e.g., transmission electron microscopy) analysis. The size (e.g., diameter) of the semiconductor nanoparticle may be an equivalent diameter obtained by a calculation involving converting the two-dimensional area of a particle obtained from an electron microscopy image into a circle. Such particle size can be reproducibly and easily obtained using various image processing programs (e.g., ImageJ or an in-house program created using a coding language) from microscope images.

The produced semiconductor nanoparticle may include an organic ligand and/or an organic solvent on its surface. The organic ligand and/or the organic solvent may be bound to the surface of the semiconductor nanoparticle of an embodiment. The organic ligand and the organic solvent are as described herein.

In an embodiment, a semiconductor nanoparticle composite may include a matrix; and the semiconductor nanoparticle described herein, wherein the semiconductor nanoparticle may be dispersed in the matrix. The semiconductor nanoparticle composite (hereinafter, can be referred to as "composite") may further contain a metal oxide fine particle. The composite or the semiconductor nanoparticle may be configured to emit first light (e.g., green light or red light). In an embodiment, the composite may be in the form of a patterned film. The composite may further include a semiconductor nanoparticle configured to emit second light different from the first light. In an embodiment, the composite may have a sheet form. The sheet may further include a semiconductor nanoparticle (e.g., an additional semiconductor nanoparticle) configured to emit second light different from the first light.

The semiconductor nanoparticle described herein or the composite including the semiconductor nanoparticle may exhibit an increased level of blue light absorbance (e.g., an improved incident light absorbance) and/or improved optical properties (e.g., an increased luminescent efficiency and a narrower full width at half maximum), and may emit light of a desired wavelength (e.g., first light).

The composite may include the semiconductor nanoparticle or a population thereof (e.g., in a predetermined amount) and exhibit increased light absorbance. An incident light absorbance (e.g., blue light absorbance) of the composite may be greater than or equal to about 70%, greater than or equal to about 73%, greater than or equal to about 75%, greater than or equal to about 77%, greater than or equal to about 80%, greater than or equal to about 83%, greater than or equal to about 85%, greater than or equal to about 87%, greater than or equal to about 90%, greater than or equal to about 93%, greater than or equal to about 94%, greater than or equal to about 95%, greater than or equal to about 96%, greater than or equal to about 97%, greater than or equal to about 98%, or greater than or equal to about 99%. The incident light absorbance (e.g., blue light absorbance) of the composite may be about 70% to about 100%, about 80% to about 98%, about 95% to about 99%, about 96% to about 98%, or a combination thereof.

The incident light absorbance of the composite may be calculated according to the following equation: $incident light absorbance = \left[\left(B-B′\right)/B\right] \times 100 %$ wherein,
B is an amount of incident light provided to the composite, and
B' is an amount of incident light passing through the composite.

A light conversion efficiency (CE) (e.g., an external quantum efficiency or an internal quantum efficiency) of the composite calculated according to the following equations may be greater than or equal to about 20%, greater than or equal to about 25%, greater than or equal to about 30%, greater than or equal to about 35%, greater than or equal to about 40%, greater than or equal to about 45%, greater than or equal to about 50%, greater than or equal to about 55%, greater than or equal to about 60%, greater than or equal to about 65%, greater than or equal to about 70%, or greater than or equal to about 75%: $Internal quantum efficiency \left(%\right) = \left[A/\left(B-B′\right)\right] \times 100$ $External quantum efficiency \left(%\right) = \left[A/B\right] \times 100$ wherein:
A: amount of the first light emitted from the composite
B: amount of the irradiated incident light
B': amount of the incident light passing through the composite.

A composite including the semiconductor nanoparticle of an embodiment may have a process retention rate (i.e., process maintenance percentage), as defined by the following Equation, that is greater than or equal to about 70%, greater than or equal to about 75%, greater than or equal to about 80%, greater than or equal to about 85%, greater than or equal to about 90%, or greater than or equal to about 100%: $Process retention rate \left(%\right) = \left[QE2/QE1\right] \times 100 .$

In the above equation, QE1 is the internal quantum efficiency or external quantum efficiency of the semiconductor nanoparticle-polymer composite before heat treatment after polymerization, and QE2 is the internal quantum efficiency or external quantum efficiency of the semiconductor nanoparticle-polymer composite after heat treatment.

The process retention rate (process maintenance percentage) may be in a range of about 10% to about 150%, about 20% to about 130%, about 25% to about 100%, about 30% to about 99%, about 68% to about 95%, about 70% to about 85%, or a combination thereof.

In an embodiment, the composite may be prepared from an ink composition. The ink composition may include a liquid vehicle; and a plurality of the semiconductor nanoparticles of an embodiment. The semiconductor nanoparticle may be dispersed in the liquid vehicle.

The liquid vehicle may include a liquid monomer, an organic solvent, or a combination thereof. The ink composition may further include a volatile organic solvent, or may not substantially include the same. The ink composition may further include a metal oxide nanoparticle or metal oxide nanoparticles (e.g., dispersed in the liquid vehicle). The ink composition may further include a dispersant (for dispersion of the semiconductor nanoparticles and/or the metal oxide nanoparticle). The dispersant may include a carboxylic acid group-containing organic compound (a monomer or a polymer). The liquid vehicle may not include an (e.g., volatile) organic solvent. The ink composition may be a solvent-free system.

The liquid monomer may include a (photo)polymerizable monomer including a carbon-carbon double bond. The composition may optionally further include a (thermal or photo) initiator. The polymerization of the composition may be initiated by light or heat.

Details of the nanoparticle(s) in the composition (or composite) are as described herein. An amount of the semiconductor nanoparticle in the composition (or composite) may be appropriately adjusted in consideration of a desired end use (e.g., a color filter, or the like). In an embodiment, an amount of the semiconductor nanoparticle in the composition (or composite) may be greater than or equal to about 1 weight percent (wt%), for example, greater than or equal to about 2 wt%, greater than or equal to about 3 wt%, greater than or equal to about 4 wt%, greater than or equal to about 5 wt%, greater than or equal to about 6 wt%, greater than or equal to about 7 wt%, greater than or equal to about 8 wt%, greater than or equal to about 9 wt%, greater than or equal to about 10 wt%, greater than or equal to about 15 wt%, greater than or equal to about 20 wt%, greater than or equal to about 25 wt%, greater than or equal to about 30 wt%, greater than or equal to about 35 wt%, or greater than or equal to about 40 wt% based on the solid content of the composition or composite (hereinafter, the solid content may be a solid content of the composition or a solid content of the composite). The amount of the semiconductor nanoparticle may be less than or equal to about 70 wt%, for example, less than or equal to about 65 wt%, less than or equal to about 60 wt%, less than or equal to about 55 wt%, or less than or equal to about 50 wt%, based on the solid content of the composition or composite. A weight percentage of a given component with respect to a total solid content in a composition may represent an amount of the given component in the composite described herein.

In an embodiment, an ink composition may be a semiconductor nanoparticle-including photoresist composition applicable in a photolithography manner. In an embodiment, an ink composition may be a semiconductor nanoparticle-including composition capable of providing a pattern in a printing manner (e.g., a droplet discharging method such as an inkjet printing). The composition according to an embodiment may not include a conjugated (or conductive) polymer (except for a cardo binder to be described herein). The composition according to an embodiment may include a conjugated polymer. Herein, the conjugated polymer refers to a polymer (e.g., polyphenylenevinylene, or the like) having a conjugated double bond in the main chain.

In the composition according to an embodiment, the dispersant may ensure dispersibility of the nanoparticle (e.g., the semiconductor nanoparticle). In an embodiment, the dispersant may be a binder (or a binder polymer). The binder may include a carboxylic acid group (e.g., in the repeating unit). The binder may be an insulating polymer. The binder may be a carboxylic acid group-including compound (a monomer or a polymer).

In the composition (or the composite), an amount of the dispersant may be greater than or equal to about 0.5 wt%, for example, greater than or equal to about 1 wt%, greater than or equal to about 5 wt%, greater than or equal to about 10 wt%, greater than or equal to about 15 wt%, or greater than or equal to about 20 wt%, based on the total solid content of the composition (or composite). The amount of the dispersant may be less than or equal to about 55 wt%, less than or equal to about 35 wt%, less than or equal to about 33 wt%, or less than or equal to about 30 wt%, based on the total solid content of the composition (or composite).

In the composition (or the liquid vehicle), a liquid monomer or a polymerizable (e.g., photopolymerizable) monomer (hereinafter, referred to as a monomer) including the carbon-carbon double bond may include a (e.g., photopolymerizable) (meth)acryl-including monomer. The monomer may be a precursor for an insulating polymer.

An amount of the (photopolymerizable) monomer, based on a total weight or a total solid content of the composition, may be greater than or equal to about 0.5 wt%, for example, greater than or equal to about 1 wt%, greater than or equal to about 2 wt%, greater than or equal to about 3 wt%, greater than or equal to about 5 wt%, or greater than or equal to about 10 wt%. An amount of the (photopolymerizable) monomer, based on a total weight or a total solid content of the composition, may be less than or equal to about 30 wt%, for example, less than or equal to about 28 wt%, less than or equal to about 25 wt%, less than or equal to about 23 wt%, less than or equal to about 20 wt%, less than or equal to about 18 wt%, less than or equal to about 17 wt%, less than or equal to about 16 wt%, or less than or equal to about 15 wt%.

The (photo)initiator included in the composition may be used for (photo)polymerization of the aforementioned monomer. The initiator is a compound accelerating a radical reaction (e.g., radical polymerization of monomer) by producing radical chemical species under a mild condition (e.g., by heat or light). The initiator may be a thermal initiator or a photoinitiator. The initiator is not particularly limited and may be appropriately selected.

In the composition, an amount of the initiator may be appropriately adjusted considering types and amounts of the polymerizable monomers. In an embodiment, the amount of the initiator may be greater than or equal to about 0.01 wt%, for example, greater than or equal to about 1 wt%, and less than or equal to about 10 wt%, for example, less than or equal to about 9 wt%, less than or equal to about 8 wt%, less than or equal to about 7 wt%, less than or equal to about 6 wt%, or less than or equal to about 5 wt%, based on the total weight (or the total solid content) of the composition, but is not limited thereto.

The composition (or composite) may further include a (multi- or monofunctional) thiol compound having at least one thiol group at the terminal end (or a moiety derived therefrom, such as a moiety produced by a reaction between a thiol and a carbon-carbon double bond, for example, a sulfide group), metal oxide particulate, or a combination thereof.

The metal oxide particulate (e.g., metal oxide nanoparticle) may include TiO₂, SiO₂, BaTiO₃, Ba₂TiO₄, ZnO, or a combination thereof. In the composition (or composite), an amount of the metal oxide particulates may be greater than or equal to about 1 wt%, greater than or equal to about 2 wt%, greater than or equal to about 3 wt%, greater than or equal to about 5 wt%, or greater than or equal to about 10 wt% and less than or equal to about 50 wt%, less than or equal to about 40 wt%, less than or equal to about 30 wt%, less than or equal to about 25 wt%, less than or equal to about 20 wt%, less than or equal to about 15 wt%, less than or equal to about 10 wt%, less than or equal to about 7 wt%, less than or equal to about 5 wt%, or less than or equal to about 3 wt%, based on the total solid content.

A diameter of the metal oxide particulate is not particularly limited, and may be appropriately selected. The diameter of the metal oxide particulates may be greater than or equal to about 100 nm, for example greater than or equal to about 150 nm, or greater than or equal to about 200 nm and less than or equal to about 1000 nm, or less than or equal to about 800 nm.

The polythiol compound may be a dithiol compound, a trithiol compound, a tetrathiol compound, or a combination thereof. For example, the thiol compound may be ethylene glycol bis(3-mercaptopropionate), ethylene glycol dimercapto acetate, trimethylolpropane tris(3-mercaptopropionate), pentaerythritol tetrakis(3-mercaptopropionate), pentaerythritol tetrakis(2-mercaptoacetate), 1,6-hexanedithiol, 1,3-propanedithiol, 1,2-ethanedithiol, polyethylene glycol dithiol including 1 to 10 ethylene glycol repeating units, or a combination thereof.

An amount of the thiol compound (or moieties derived therefrom) may be less than or equal to about 50 wt%, less than or equal to about 40 wt%, less than or equal to about 30 wt%, less than or equal to about 20 wt%, less than or equal to about 10 wt%, less than or equal to about 9 wt%, less than or equal to about 8 wt%, less than or equal to about 7 wt%, less than or equal to about 6 wt%, or less than or equal to about 5 wt%, based on the total solid content. The amount of the thiol compound (or moieties derived therefrom) may be greater than or equal to about 0.1 wt%, for example, greater than or equal to about 0.5 wt%, greater than or equal to about 1 wt%, greater than or equal to about 5 wt%, greater than or equal to about 10 wt%, greater than or equal to about 15 wt%, greater than or equal to about 18 wt%, or greater than or equal to about 20 wt%, based on the total solid content.

The composition or the liquid vehicle may include an organic solvent. In an embodiment, the composition or the liquid vehicle may not include an organic solvent. If present, the type of organic solvent that may be used is not particularly limited. The type and amount of the organic solvent is appropriately determined in consideration of the types and amounts of the aforementioned main components (i.e., nanoparticles, dispersants, polymerizable monomers, initiators, thiol compounds, or the like, if present) and other additives to be described herein. The composition may include a solvent in a residual amount except for a desired amount of the (non-volatile) solid. In an embodiment, examples of the organic solvent may be an ethylene glycols, such as ethylene glycol, diethylene glycol, polyethylene glycol, and the like; a glycol ether solvent, such as ethylene glycol monomethylether, ethylene glycol monoethyl ether, diethylene glycol monomethyl ether, ethylene glycol diethyl ether, diethylene glycol dimethyl ether, or the like; a glycol ether acetate solvent, such as ethylene glycol acetate, ethylene glycol monoethyl ether acetate, diethylene glycol monoethyl ether acetate, diethylene glycol monobutyl ether acetate, or the like; a propylene glycol solvent, such as propylene glycol, or the like; a propylene glycol ether solvent, such as propylene glycol monomethyl ether, propylene glycol monoethyl ether, propylene glycol monopropyl ether, propylene glycol monobutyl ether, propylene glycol dimethyl ether, dipropylene glycol dimethyl ether, propylene glycol diethyl ether, dipropylene glycol diethyl ether, or the like; a propylene glycol ether acetate solvent, such as propylene glycol monomethyl ether acetate, dipropylene glycol monoethyl ether acetate, or the like; an amide solvent, such as N-methylpyrrolidone, dimethyl formamide, dimethyl acetamide, or the like; a ketone solvent, such as methylethylketone (MEK), methylisobutylketone (MIBK), cyclohexanone, or the like; a petroleum solvent, such as toluene, xylene, solvent naphtha, or the like; an ester solvent, such as ethyl acetate, butyl acetate, ethyl lactate, ethyl 3-ethoxy propionate, or the like; an ether solvent, such as diethyl ether, dipropyl ether, dibutyl ether, or the like; chloroform, a C1 to C40 aliphatic hydrocarbon solvent (e.g., alkane, alkene, or alkyne), a halogen (e.g., chloro) substituted C1 to C40 aliphatic hydrocarbon solvent (e.g., dichloroethane, trichloromethane, or the like), a C6 to C40 aromatic hydrocarbon solvent (e.g., toluene, xylene, or the like), a halogen (e.g., chloro) substituted C6 to C40 aromatic hydrocarbon solvent; or a combination thereof.

In addition to the aforementioned components, the composition (or composite) of an embodiment may further include an additive such as a light diffusing agent, a leveling agent, a coupling agent, or a combination thereof. Components (binder, monomer, solvent, additives, thiol compound, cardo binder, or the like) included in the composition of an embodiment may be appropriately selected, and for specific details thereof, for example, US-2017-0052444-A1 may be referred to.

In the preparation of the composition according to an embodiment, each of the above-described components may be manufactured sequentially or simultaneously mixed, and the order thereof is not particularly limited.

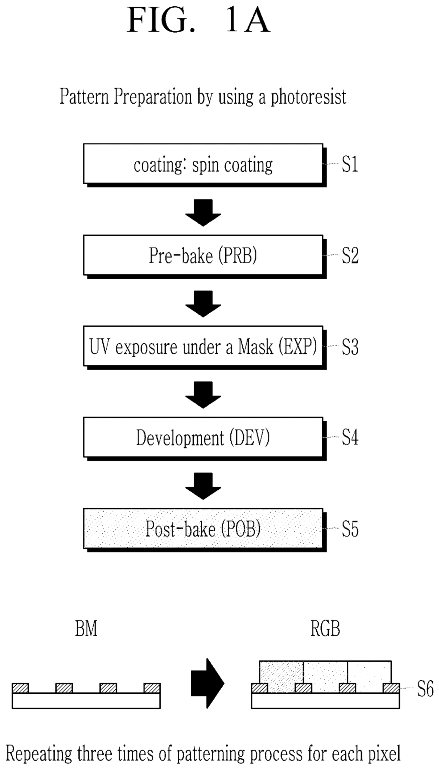

The composition may provide a color conversion layer (or a patterned film of the composite) by (e.g., radical) polymerization. The color conversion layer (or the patterned film of the composite) may be produced using a photoresist composition. Referring to FIG. 1A, this method may include forming a film of the aforementioned composition on a substrate (S1); prebaking the film according to selection (S2); exposing a selected region of the film to light (e.g., having a wavelength of less than or equal to about 400 nm) (S3); and developing the exposed film with an alkali developing solution to obtain a pattern of a quantum dot-polymer composite (S4).

Referring to FIG. 1A, the aforementioned composition may be applied to a predetermined thickness on a substrate using an appropriate method such as spin coating or slit coating to form a film. The formed film may be optionally subjected to a pre-baking (PRB) step. The pre-baking may be performed by selecting an appropriate condition from known conditions of a temperature, time, an atmosphere, or the like.

The formed (or optionally prebaked) film may be exposed to light having a predetermined wavelength under a mask having a predetermined pattern (EXP). A wavelength and intensity of the light may be selected considering types and amounts of the photoinitiator, types, and amounts of the quantum dots, or the like.

The exposed film may then be treated with an alkali developing solution (e.g., dipping or spraying) to dissolve an unexposed region and obtain a desired pattern (DEV). The obtained pattern may be, optionally, post-exposure baked (POB) to improve crack resistance and solvent resistance of the pattern, for example, at a temperature of about 150°C to about 230°C for a predetermined time (e.g., greater than or equal to about 10 minutes, or greater than or equal to about 20 minutes) (S5).

When the color conversion layer or the patterned film of the nanoparticle composite has a plurality of repeating sections (that is, color conversion regions), each repeating section may be formed by preparing a plurality of compositions including quantum dots (e.g., red light emitting quantum dots, green light emitting quantum dots, or optionally, blue light emitting quantum dots) having desired luminous properties (photoluminescence peak wavelength or the like) and repeating the aforementioned pattern-forming process as many times as necessary (e.g., 2 times or more, or 3 times or more) for each composition, resultantly obtaining a nanoparticle-polymer composite having a desired pattern (S6). For example, the nanoparticle-polymer composite may have a pattern of at least two repeating color sections (e.g., RGB color sections). This nanoparticle-polymer composite pattern may be used as a photoluminescence type color filter in a display device.

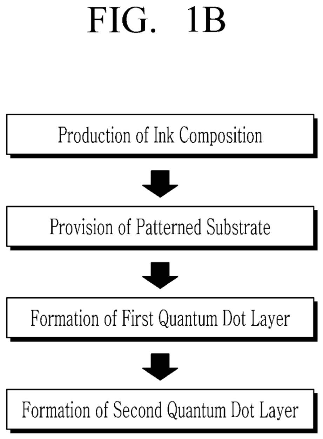

The color conversion layer or patterned film of the semiconductor nanoparticle composite may be produced using an ink composition configured to form a pattern in an inkjet manner. Referring to FIG. 1B, such a method may include preparing an ink composition according to an embodiment, providing a substrate (e.g., with pixel areas patterned by electrodes and optionally banks or trench-type partition walls, or the like), and depositing an ink composition on the substrate (or the pixel area) to form, for example, a first composite layer (or first region). The method may include depositing an ink composition on the substrate (or the pixel area) to form, for example, a second composite layer (or second region). The first and second composite layers may be first and second quantum dot layers, respectively. The forming of the first composite layer and forming of the second composite layer may be simultaneously or sequentially performed.

The depositing of the ink composition may be performed using an appropriate liquid crystal discharger, for example an inkjet or nozzle printing system (having an ink storage and at least one print head). The deposited ink composition may provide a (first or second) composite layer through the solvent removal and polymerization by the heating. The method may provide a highly precise nanoparticle-polymer composite film or patterned film for a short time by the simple method.

In the semiconductor nanoparticle-polymer composite (e.g., first composite) of an embodiment, the (polymer) matrix may include the components described herein with respect to the composition. In the composite, an amount of the matrix, based on a total weight of the composite, may be greater than or equal to about 10 wt%, greater than or equal to about 20 wt%, greater than or equal to about 30 wt%, greater than or equal to about 40 wt%, greater than or equal to about 50 wt%, or greater than or equal to about 60 wt%. The amount of the matrix may be, based on a total weight of the composite, less than or equal to about 95 wt%, less than or equal to about 90 wt%, less than or equal to about 80 wt%, less than or equal to about 70 wt%, less than or equal to about 60 wt%, or less than or equal to about 50 wt%.

The (polymer) matrix may include a dispersant (e.g., a carboxylic acid group-including binder polymer), a polymerization product (e.g., an insulating polymer) of a polymerizable monomer including (at least one, for example, at least two, at least three, at least four, or at least five) carbon-carbon double bonds, a polymerization product of the polymerizable monomer and a polythiol compound having at least two thiol groups (e.g., at a terminal end), or a combination thereof. The matrix may include a linear polymer, a crosslinked polymer, or a combination thereof. The (polymer) matrix may not include a conjugated polymer (excluding cardo resin). The matrix may include a conjugated polymer.

The crosslinked polymer may include a thiol-ene resin, a crosslinked poly(meth)acrylate, a crosslinked polyurethane, a crosslinked epoxy resin, a crosslinked vinyl polymer, a crosslinked silicone resin, or a combination thereof. In an embodiment, the crosslinked polymer may be a polymerization product of the aforementioned polymerizable monomers and optionally a polythiol compound.

The linear polymer may include a repeating unit derived from a carbon-carbon unsaturated bond (e.g., a carbon-carbon double bond). The repeating unit may include a carboxylic acid group. The linear polymer may include an ethylene repeating unit.

The carboxylic acid group-containing repeating unit may include a unit derived from a monomer including a carboxylic acid group and a carbon-carbon double bond, a unit derived from a monomer having a dianhydride moiety, or a combination thereof.

The (polymer) matrix may include a carboxylic acid group-containing compound (e.g., a binder, a binder polymer, or a dispersant) (e.g., for dispersion of nanoparticles or a binder).

The first composite (or a film or pattern thereof) may have, for example, a thickness of less than or equal to about 30 micrometers (µm), less than or equal to about 25 µm, less than or equal to about 20 µm, less than or equal to about 15 µm, less than or equal to about 10 µm, less than or equal to about 8 µm, or less than or equal to about 7 µm to greater than about 2 µm, for example, greater than or equal to about 3 µm, greater than or equal to about 3.5 µm, greater than or equal to about 4 µm, greater than or equal to about 5 µm, greater than or equal to about 6 µm, greater than or equal to about 7 µm, greater than or equal to about 8 µm, greater than or equal to about 9 µm, or greater than or equal to about 10 µm.

The semiconductor nanoparticle(s), the composite (or pattern thereof) including the semiconductor nanoparticle(s), or a color conversion panel including the same may be included in an electronic device. Such an electronic device may include a display device, a light emitting diode (LED), an organic light emitting diode (OLED), a quantum dot LED, a sensor, a solar cell, an imaging sensor, a photodetector, or a liquid crystal display device, but embodiments are not limited thereto. The aforementioned quantum dot (or the semiconductor nanoparticle) in an embodiment may be included in an electronic apparatus. Such an electronic apparatus may include, but is not limited to, a virtual reality device, an augmented reality device, a portable terminal device, a monitor, a notebook personal computer (PC), a television, an electric sign board, an electronic display board, a camera, a vehicle (e.g., a car), or the like, but embodiments are not limited thereto. The electronic apparatus may be a portable terminal device, a monitor, a laptop personal computer, or a television including a display device (or a light emitting device) including quantum dots. The electronic apparatus may be a camera or a mobile terminal device including an image sensor including quantum dots. The electronic apparatus may be a camera or a vehicle including a photodetector including quantum dots.

An embodiment provides a color conversion layer (e.g., a color conversion structure or a color conversion panel) including a color conversion region including the semiconductor nanoparticle described herein. The color conversion panel may include a color conversion layer including a color conversion region and optionally a partition wall defining each region of the color conversion layer. The color conversion region may include a first region corresponding to a first pixel, and the first region may include the semiconductor nanoparticles or the semiconductor nanoparticle composite. In the color conversion panel of an embodiment, the semiconductor nanoparticle composite may be in the form of a patterned film. In another embodiment, the semiconductor nanoparticle composite may have a sheet form.

The first region may include a first composite, and the first composite may include a matrix and semiconductor nanoparticles dispersed in the matrix and may be configured to emit first light. An embodiment provides the semiconductor nanoparticles or a population thereof.

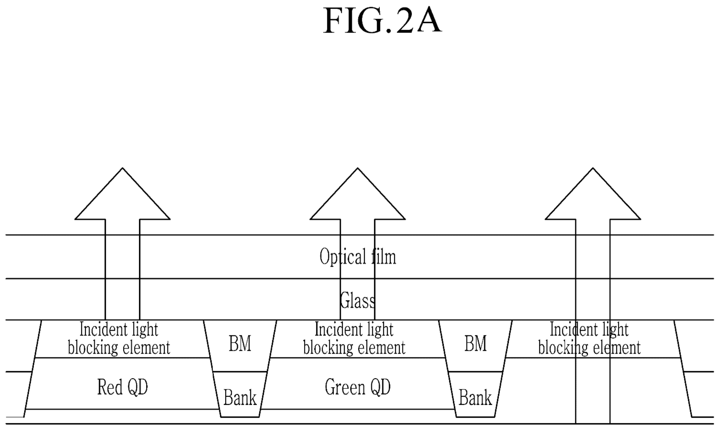

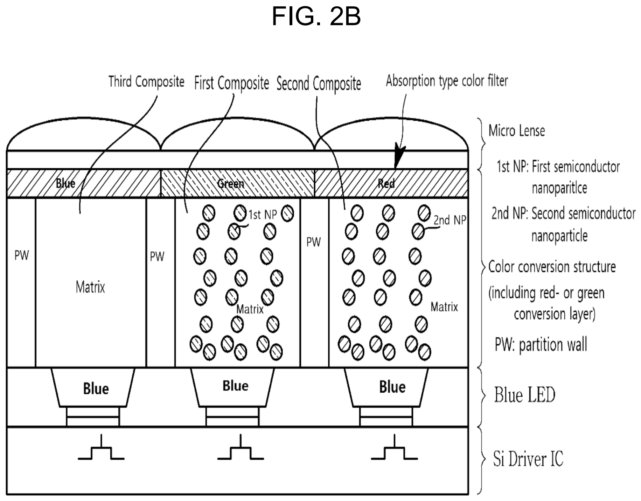

The color conversion layer (e.g., a color conversion structure) may include the semiconductor nanoparticle composite or a patterned film thereof according to an embodiment. FIG. 2A is a schematic cross-sectional representation of a color conversion panel according to an embodiment. Referring to FIG. 2A, the color conversion panel may optionally further include a partition wall (e.g., a black matrix (BM), a bank, or a combination thereof) that defines each region of the color conversion layer (e.g., a color conversion structure). FIG. 2B illustrates an electronic device (or a display device) including a color conversion panel and a light source according to another embodiment. In the electronic device of an embodiment, a color conversion panel including a color conversion layer or a color conversion structure may be disposed on an LED on a chip (e.g., a micro LED on a chip). Referring to FIG. 2B, a circuit (e.g., Si driver integrated circuit (IC)) configured to drive the light source may be disposed under a light source (e.g., blue LED) configured to emit incident light (e.g., a blue light). The color conversion layer may include a first composite including a semiconductor nanoparticle emitting a first light (e.g., a green light), and a second composite including a semiconductor nanoparticle emitting a second light (e.g., a red light), or a third composite that emits or passes a third light (e.g., incident light or a blue light). A partition wall (PW) (e.g., including an inorganic material, such as silicon or silicon oxide, or based on an organic material), may be disposed between respective composites. The partition wall may include a trench hole, a via hole, or a combination thereof. A first optical element (e.g., an absorption type color filter) may be disposed on a light extraction surface of a color conversion layer. An additional optical element, such as a micro lens, may be further disposed on the first optical element.

The color conversion region may include a first region configured to emit the aforementioned first light (or green light) (e.g., by irradiation with an incident light). In an embodiment, the first region may correspond to a green pixel. The first region may include a first composite (e.g., a luminescence type composite). The first light may have a peak emission wavelength within a wavelength range to be described later. The first light will be described in more detail for the semiconductor nanoparticles described herein. The peak emission wavelength of the first light (or the green light) may be greater than or equal to about 500 nm, greater than or equal to about 501 nm, greater than or equal to about 504 nm, greater than or equal to about 505 nm, or greater than or equal to about 520 nm. The peak emission wavelength of the first light (or the green light) may be less than or equal to about 580 nm, less than or equal to about 560 nm, less than or equal to about 550 nm, less than or equal to about 530 nm, less than or equal to about 525 nm, less than or equal to about 520 nm, less than or equal to about 515 nm, or less than or equal to about 510 nm.

The color conversion region may further include a (e.g., one or more) second region that is configured to emit a second light (e.g., a red light) different from the first light (e.g., by irradiation with excitation light). The second region may include a second composite. The semiconductor nanoparticle composite in the second region may include a semiconductor nanoparticle (e.g., a quantum dot) being configured to emit a light of a different wavelength (e.g., a different color) from the semiconductor nanoparticle composite disposed in the first region.

The second light may be a red light having a peak emission wavelength of about 600 nm to about 650 nm (e.g., about 620 nm to about 650 nm). The color conversion panel may further include (one or more) third regions that emit or pass a third light (e.g., a blue light) different from the first light and the second light. An incident light may include the third light (e.g., a blue light and optionally a green light). The third light may include a blue light having a peak emission wavelength of greater than or equal to about 380 nm (e.g., greater than or equal to about 440 nm, greater than or equal to about 445 nm, greater than or equal to about 450 nm, or greater than or equal to about 455 nm) to less than or equal to about 480 nm (e.g., less than or equal to about 475 nm, less than or equal to about 470 nm, less than or equal to about 465 nm, or less than or equal to about 460 nm).

In an embodiment, the color conversion panel or the color conversion layer may include a plurality of first regions, and the semiconductor nanoparticle composite may constitute a predetermined pattern to be respectively disposed in the first regions of the color conversion panel. The semiconductor nanoparticle composite (or a pattern thereof) may be prepared from the (ink) composition by any method, for example, in a photolithography manner or in an inkjet printing manner. Accordingly, an embodiment may relate to a composition including a semiconductor nanoparticle, which was described herein in further detail.

In an embodiment, the electronic device or the display device (e.g., display panel) may further include a color conversion layer (or a color conversion panel) and optionally, a light source. The light source may provide incident light to the color conversion layer or the color conversion panel. In an embodiment, the display panel may include a light emitting panel (or a light source), the aforementioned color conversion panel, and a light transmitting layer located between the aforementioned light emitting panel and the aforementioned color conversion panel. The color conversion panel may include a substrate, and the color conversion layer may be disposed on the substrate.

When present, the light source or the light emitting panel may provide an incident light to the color conversion layer or the color conversion panel. The incident light may have a peak emission wavelength of greater than or equal to about 440 nm, for example, greater than or equal to about 450 nm, and less than or equal to about 580 nm, for example, less than or equal to about 480 nm, less than or equal to about 470 nm, or less than or equal to about 460 nm.

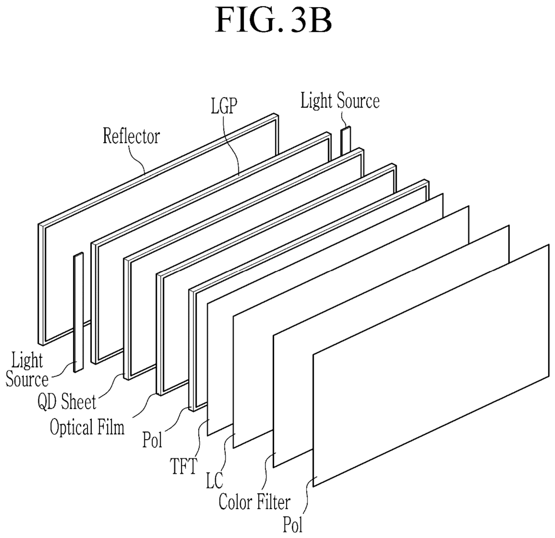

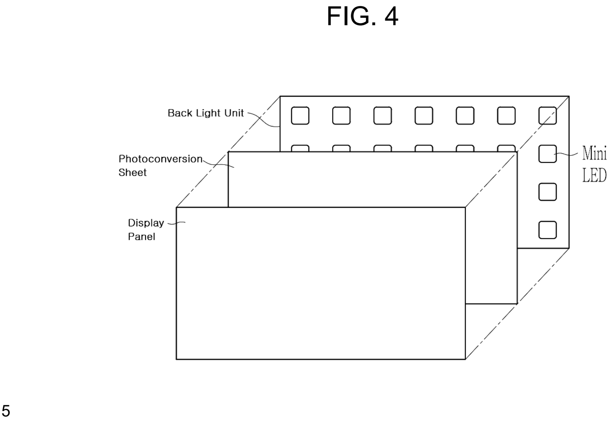

In an embodiment, the electronic device (e.g., a photoluminescent device) may further include a sheet of the nanoparticle composite. The device may include a backlight unit and a liquid crystal panel, optionally wherein the backlight unit may include a quantum dot polymer composite sheet (QD sheet), See, FIG. 3B. For example, the backlight unit may have a structure that a reflector, a light guide plate (LGP), a light source (a blue LED or the like), the quantum dot polymer composite sheet (QD sheet), and an optical film (a prism, a double brightness enhance film (DBEF, or the like) may be stacked. The liquid crystal panel may be disposed on the backlight unit and have a structure where a thin film transistor (TFT), liquid crystals (LC), and a color filter are included between two polarizers (Pol). The quantum dot polymer composite sheet (QD sheet) may include semiconductor nanoparticles (e.g., quantum dots) emitting a red light and a green light after absorbing light from the light source. A blue light provided from the light source may be combined with the red light and the green light emitted from the respective semiconductor nanoparticles, while passing the quantum dot polymer composite sheet, and converted into a white light. The white light may be separated into a blue light, a green light, and a red light by a color filter in the liquid crystal panel, and then emitted to the outside for each pixel. Referring to Fig. 4, the backlight unit (BLU) may be a direct type of a BLU without a light guide plate, and may include a plurality of LEDs (e.g., mini LEDs) and a photoconversion sheet or a QD sheet may be disposed on the BLU.

The color conversion panel may include a substrate, and the color conversion layer may be disposed on the substrate. The color conversion layer or the color conversion panel may include a patterned film of the nanoparticle composite. The patterned film may include a repeating section that is configured to emit light of a desired wavelength. The repeating section may include a second region. The second region may be a red light-emitting section. The repeating section may include a first region. The first region may be a green light-emitting section. The repeating section may include a third region. The third region may include a section that emits or transmits a blue light. Details of the first, second, and third regions are as described herein.

The light emitting panel or the light source may be an element emitting an incident light (e.g., an excitation light). The incident light may include a blue light, and, optionally, a green light. The light source may include an LED. The light source may include an organic LED (OLED). The light source may include a micro LED. On the front surface (light emitting surface) of the first region and the second region, an optical element to block (e.g., reflect or absorb) a blue light (and optionally a green light) for example, a blue light (and optionally a green light) blocking layer or a first optical filter that will be described herein may be disposed. In an embodiment, the light source may include an organic light emitting diode to emit a blue light and an organic light emitting diode to emit a green light, and a green light removing filter may be further disposed on a third region through which a blue light is transmitted.

The light emitting panel or the light source may include a plurality of light emitting units respectively corresponding to the first region and the second region, and the light emitting units may include a first electrode and a second electrode facing each other, and an (organic) electroluminescent layer located between the first electrode and the second electrode. The electroluminescent layer may include an organic light emitting material. For example, each light emitting unit of the light source may include an electroluminescent device (e.g., an organic light emitting diode (OLED)) structured to emit light of a predetermined wavelength (e.g., a blue light, a green light, or a combination thereof). Structures and materials of the electroluminescent device and the organic light emitting diode (OLED) are not particularly limited.

Hereinafter, the display panel and the color conversion panel will be described in further detail with reference to the drawings.

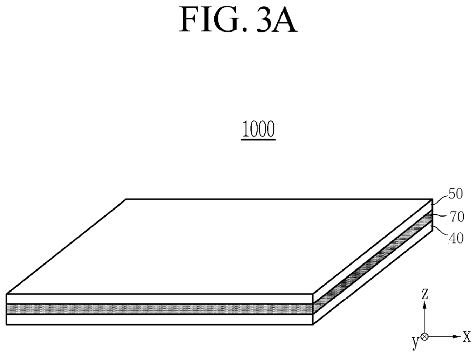

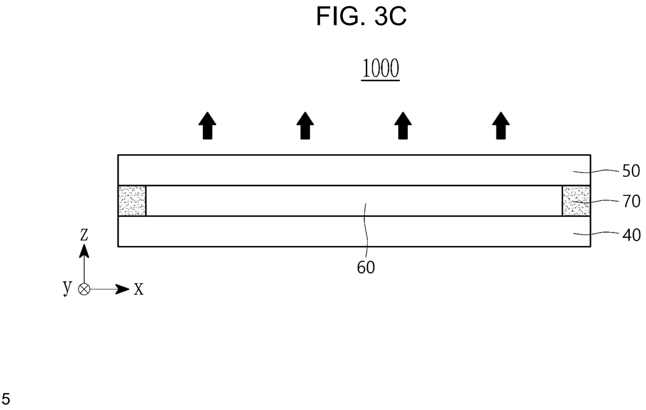

Referring to FIGS. 3A and 3C, the display panel 1000 according to an embodiment may include a light emitting panel 40 and a color conversion panel 50. The display panel or the electronic device may further include a light transmitting layer 60 disposed between the light emitting panel 40 and the color conversion panel 50, and a binding material 70 binding the light emitting panel 40 and the color conversion panel 50. The light transmitting layer may include a passivation layer, a filling material, an encapsulation layer, or a combination thereof (not shown). A material for the light transmitting layer may be appropriately selected without particular limitation. The material for the light transmitting layer may be an inorganic material, an organic material, an organic/inorganic hybrid material, or a combination thereof.

The light emitting panel 40 and the color conversion panel 50 each may have a surface opposite the other, i.e., the two respective panels may face each other, with the light transmitting layer (or the light transmitting panel) 60 disposed between the two panels. The color conversion panel 50 may be disposed in a direction such that for example, light emitting from the light emitting panel 40 may irradiate the light transmitting layer 60. The binding material 70 may be disposed along edges of the light emitting panel 40 and the color conversion panel 50, and may be, for example, a sealing material.

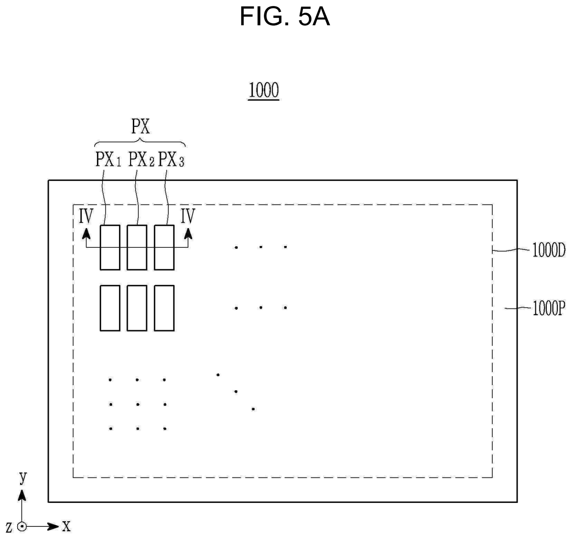

FIG. 5A is a plan view of an embodiment of a pixel arrangement of a display panel. Referring to FIG. 5A, the display panel 1000 may include a display area 1000D displaying an image and a non-display area 1000P positioned in a peripheral area of the display area 1000D and disposed with a binding material.

The display area 1000D may include a plurality of pixels PX arranged along a row (e.g., an x direction), and a column (e.g., a y direction), and each representative pixel PX may include a plurality of sub-pixels PX₁, PX₂, and PX₃ expressing, e.g., displaying, different colors from each other. An embodiment may be idealized with a structure in which three sub-pixels PX₁, PX₂, and PX₃ are configured to provide a pixel. An embodiment may further include an additional sub-pixel, such as a white sub-pixel, and may further include, e.g., at least one, sub-pixel expressing, e.g., displaying the same colors. The plurality of pixels PX may be aligned, for example, in a Bayer matrix, a matrix sold under the trade designation PenTile, a diamond matrix, or the like, or a combination thereof.

The sub-pixels PX₁, PX₂, and PX₃ may express, e.g., display, three primary colors or a color of a combination of three primary colors, for example, may express, e.g., display, a color of red, green, blue, or a combination thereof. For example, the first sub-pixel PX₁ may express, e.g., display, a red color, and the second sub-pixel PX₂ may express, e.g., display, a green color, and the third sub-pixel PX₃ may express, e.g., display, a blue color.

In the drawing, all sub-pixels are idealized to have the same size, but these are not limited thereto, and at least one of the sub-pixels may be larger or smaller than other sub-pixels. In the drawing, all sub-pixels are idealized to have the same shape, but it is not limited thereto and at least one of the sub-pixels may have different shape from the other sub-pixels.

In the display panel or electronic device according to an embodiment, the light emitting panel may include a substrate and a TFT (e.g., an oxide-containing TFT, or the like) disposed on the substrate. A light emitting device (e.g., having a tandem structure, or the like) may be disposed on the TFT.

The light emitting device may include a light emitting layer (e.g., a blue light emitting layer, a green light emitting layer, or a combination thereof) located between the first electrode and the second electrode facing each other. A charge generation layer may be disposed between each of the light emitting layers. Each of the first electrode and the second electrode may be patterned with a plurality of electrode elements to correspond to the pixel. The first electrode may be an anode or a cathode. The second electrode may be a cathode or an anode.

The light emitting device may include an organic LED, a nanorod LED, a mini LED, a micro LED, or a combination thereof.

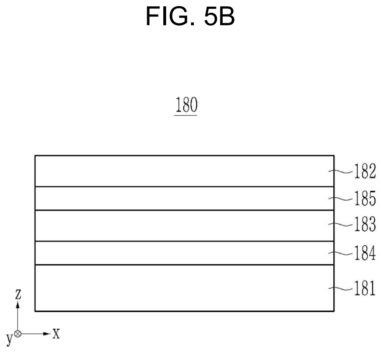

FIGS. 5B to 5E are cross-sectional views showing light emitting devices of an embodiment, respectively. In an embodiment, "a mini LED" may have a size of greater than or equal to about 100 micrometers, greater than or equal to about 150 micrometers, or greater than or equal to about 200 micrometers and less than or equal to about 1 millimeter, less than or equal to about 0.5 millimeters, less than or equal to about 0.15 millimeters, or less than or equal to about 0.12 millimeters, but is not limited thereto. In an embodiment, "a micro LED" may have a size of less than about 100 micrometers, less than or equal to about 50 micrometers, or less than or equal to about 10 micrometers. The size of the micro LED may be greater than or equal to about 0.1 micrometers, greater than or equal to about 0.5 micrometers, greater than or equal to about 1 micrometer, or greater than or equal to about 5 micrometers, but is not limited thereto.

Referring to FIG. 5B, the light emitting device 180 may include a first electrode 181 and a second electrode 182 facing each other; a light emitting layer 183 located between the first electrode 181 and the second electrode 182; and optionally auxiliary layers 184 and 185 located between the first electrode 181 and the light emitting layer 183, and located between the second electrode 182 and the light emitting layer 183, respectively.

The first electrode 181 and the second electrode 182 may be disposed to face each other along a thickness direction (for example, a z direction), and any one of the first electrode 181 and the second electrode 182 may be an anode and the other may be a cathode. The first electrode 181 may be a light transmitting electrode, a semi-transparent electrode, or a reflective electrode, and the second electrode 182 may be a light transmitting electrode or a semi-transparent electrode. The light transmitting electrode or semi-transparent electrode may be, for example, made of a thin single layer or multiple layers of a metal thin film including conductive metal oxides, such as indium tin oxide (ITO), indium zinc oxide (IZO), zinc oxide (ZnO), tin oxide (SnO), aluminum tin oxide (AlTO), fluorine-doped tin oxide (FTO), or the like; or silver (Ag), copper (Cu), aluminum (Al), magnesium (Mg), magnesium-silver (Mg-Ag), magnesium-aluminum (Mg-Al), or a combination thereof. The reflective electrode may include a metal, a metal nitride, or a combination thereof, for example, silver (Ag), copper (Cu), aluminum (Al), gold (Au), titanium (Ti), chromium (Cr), nickel (Ni), an alloy thereof, a nitride thereof (e.g., TiN), or a combination thereof, but embodiments are not limited thereto.

The light emitting layer(s) 183 may include a first light emitting body emitting light with a blue emission spectrum, a second light emitting body emitting light with a green emission spectrum, or a combination thereof.

The blue emission spectrum may have a peak emission wavelength in a wavelength region of greater than or equal to about 400 nm to less than about 500 nm and within the range, in a wavelength region of about 410 nm to about 490 nm, about 420 nm to about 480 nm, about 430 nm to about 470 nm, about 440 nm to about 465 nm, about 445 nm to about 460 nm, or about 450 nm to about 458 nm.

The green emission spectrum may have a peak emission wavelength in a wavelength region of greater than or equal to about 500 nm to less than about 590 nm and within the range, in a wavelength region of about 510 nm to about 580 nm, about 515 nm to about 570 nm, about 520 nm to about 560 nm, about 525 nm to about 555 nm, about 530 nm to about 550 nm, or about 535 nm to about 545 nm.

For example, the light emitting layers 183 or the light emitting body included therein may include a phosphorescent material, a fluorescent material, or a combination thereof. For example, the light emitting body may include an organic light emitting body, wherein the organic light emitting body may be a low molecular compound, a polymer compound, or a combination thereof. Specific types of the phosphorescent material and the fluorescent material are not particularly limited but may be appropriately selected from known materials. For example, the light emitting body may include an inorganic light emitting body, and the inorganic light emitting body may be an inorganic semiconductor, a quantum dot, a perovskite, or a combination thereof. The inorganic semiconductor may include metal nitride, metal oxide, or a combination thereof. The metal nitride, the metal oxide, or the combination thereof may include a Group III metal, such as aluminum, gallium, indium, thallium, or the like, a Group IV metal such as silicon, germanium, tin, or a combination thereof. In an embodiment, the light emitting body may include an inorganic light emitting body, and the light emitting device 180 may be a quantum dot light emitting diode, a perovskite light emitting diode, or a micro light emitting diode (µLED). Materials usable as the inorganic light emitting body may be selected appropriately.

In an embodiment, the light emitting device 180 may further include an auxiliary layer 184 and 185. The auxiliary layer 184 and 185 may be disposed between a first electrode 181 and a light emitting layer 183, and between a second electrode 182 and a light emitting layer 183, respectively. The auxiliary layer 184 and 185 may be a charge auxiliary layer for controlling injection and/or mobility of charges. The auxiliary layers 184 and 185 may include at least one layer or two layers, and for example, may include a hole injection layer, a hole transport layer, an electron blocking layer, an electron injection layer, an electron transport layer, a hole blocking layer, or a combination thereof. At least one of the auxiliary layers 184 and 185 may be omitted, if desired. The auxiliary layer may be formed of a material appropriately selected from materials known for an organic electroluminescent device, or the like.

The light emitting devices 180 disposed in each of the subpixels PX₁, PX₂, and PX₃ may be the same or different from each other. The light emitting devices 180 in each of the subpixels PX₁, PX₂, and PX₃ may emit a light having the same or different emission spectra. The light emitting devices 180 in each of the subpixels PX₁, PX₂, and PX₃ may emit, for example, light having a blue emission spectrum, light having a green emission spectrum, or a combination thereof. The light emitting devices 180 in each of the subpixels PX₁, PX₂, and PX₃ may be separated by a pixel defining layer (not shown).

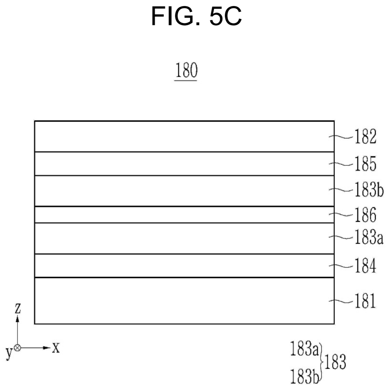

Referring to FIG. 5C, the light emitting device 180 may be a light emitting device having a tandem structure, and may include a first electrode 181 and a second electrode 182 facing each other; a first light emitting layer 183a and a second light emitting layer 183b located between the first electrode 181 and the second electrode 182; a charge generation layer 186 located between the first light emitting layer 183a and the second light emitting layer 183b; and optionally auxiliary layers 184 and/or 185 located between the first electrode 181 and the first light emitting layer 183a, and/or between the second electrode 182 and the second light emitting layer 183b, respectively.

Details of the first electrode 181, the second electrode 182, and the auxiliary layers 184 and 185 are as described herein.

The first light emitting layer 183a and the second light emitting layer 183b may emit a light having the same or different emission spectra. In an embodiment, the first light emitting layer 183a or the second light emitting layer 183b may emit light having a blue emission spectrum or light having a green emission spectrum, respectively. The charge generation layer 186 may inject an electric charge into the first light emitting layer 183a and/or the second light emitting layer 183b, and may control a charge balance between the first light emitting layer 183a and the second light emitting layer 183b. The charge generation layer 186 may include, for example, an n-type layer and a p-type layer, and may include, for example, an electron transport material and/or a hole transport material including an n-type dopant and/or a p-type dopant. The charge generation layer 186 may include one layer or two or more layers.

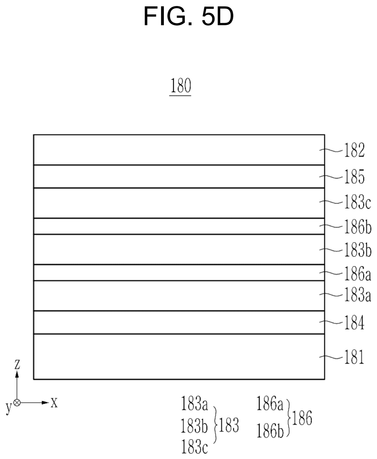

Referring to FIG. 5D, a light emitting device (having a tandem structure) may include a first electrode 181 and a second electrode 182 facing each other; a first light emitting layer 183a, a second light emitting layer 183b, and a third light emitting layer 183c located between the first electrode 181 and the second electrode 182; a first charge generation layer 186a located between the first light emitting layer 183a and the second light emitting layer 183b; a second charge generation layer 186b located between the second light emitting layer 183b and the third light emitting layer 183c; and optionally, auxiliary layers 184 and/or 185 located between the first electrode 181 and the first light emitting layer 183a, and/or between the second electrode 182 and the third light emitting layer 183c, respectively.

Details of the first electrode 181, the second electrode 182, and the auxiliary layers 184 and 185 are as described herein.

The first light emitting layer 183a, the second light emitting layer 183b, and the third light emitting layer 183c may emit a light having the same or different emission spectra. The first light emitting layer 183a, the second light emitting layer 183b, and the third light emitting layer 183c may emit a blue light. In an embodiment, the first light emitting layer 183a and the third light emitting layer 183c may emit light of a blue emission spectrum, and the second light emitting layer 183b may emit light of a green emission spectrum. In another embodiment, the first light emitting layer 183a and the third light emitting layer 183c may emit light of a green emission spectrum, and the second light emitting layer 183b may emit light of a blue emission spectrum.

The first charge generation layer 186a may inject an electric charge into the first light emitting layer 183a and/or the second light emitting layer 183b, and may control charge balances between the first light emitting layer 183a and the second light emitting layer 183b. The second charge generation layer 186b may inject an electric charge into the second light emitting layer 183b and/or the third light emitting layer 183c, and may control charge balances between the second light emitting layer 183b and the third light emitting layer 183c. Each of the first and second charge generation layers 186a and 186b may include one layer or two or more layers, respectively.

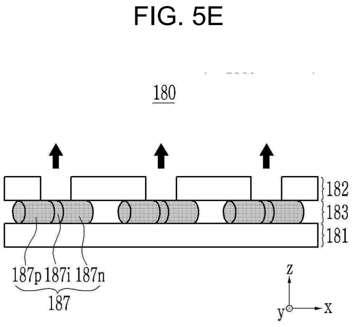

Referring to FIG. 5E, in an embodiment, the light emitting device 180 may include a light emitting layer 183, a first electrode 181, a second electrode 182, and a plurality of nanostructures 187 arranged in the light emitting layer 183.

One of the first electrode 181 and the second electrode 182 may be an anode and the other may be a cathode. The first electrode 181 and the second electrode 182 may be an electrode patterned according to a direction of an arrangement of the plurality of nanostructures 187, and may include, for example, a conductive oxide such as indium tin oxide (ITO), indium zinc oxide (IZO), zinc oxide (ZnO), tin oxide (SnO), aluminum tin oxide (AlTO), fluorine-doped tin oxide (FTO), or the like; or silver (Ag), copper (Cu), aluminum (Al), gold (Au), titanium (Ti), chromium (Cr), nickel (Ni), an alloy thereof, a nitride thereof (e.g., TiN); or a combination thereof, but embodiments are not limited thereto.

The light emitting layer 183 may include a plurality of nanostructures 187, and each of the subpixels PX₁, PX₂, and PX₃ may include a plurality of nanostructures 187. In an embodiment, the plurality of nanostructures 187 may be arranged in one direction, but embodiments are not limited thereto. The nanostructures 187 may be a compound-containing semiconductor that is configured to emit light of a predetermined wavelength for example with an application of an electric current, and may be, for example, a linear nanostructure, such as a nanorod or a nanoneedle. A diameter or a long diameter of the nanostructures 187 may be, for example, several nanometers to several hundreds of nanometers, and aspect ratios of the nanostructures 187 may be greater than about 1, greater than or equal to about 1.5, greater than or equal to about 2.0, greater than or equal to about 3.0, greater than or equal to about 4.0, greater than or equal to about 4.5 or greater than or equal to about 5.0 to less than or equal to about 20, for example, greater than about 1 to about 20, greater than or equal to about 1.5 to about 20, greater than or equal to about 2.0 to about 20, greater than or equal to about 3.0 to about 20, greater than or equal to about 4.0 to about 20, greater than or equal to about 4.5 to about 20, or greater than or equal to about 5.0 to about 20.

Each of the nanostructures 187 may include a p-type region 187p, an n-type region 187n, and a multiple quantum well region 187i, and may be configured to emit light from the multiple quantum well region 187i. The nanostructure 187 may include, for example, gallium nitride (GaN), indium gallium nitride (InGaN), aluminum gallium nitride (AlGaN), or a combination thereof, and may have, for example, a core-shell structure.

The plurality of nanostructures 187 may each emit light having the same or different emission spectra. In an embodiment, the nanostructure may emit light of a blue emission spectrum, for example, light of a blue emission spectrum having a peak emission wavelength in a wavelength region of greater than or equal to about 400 nm to less than 500 nm, about 410 nm to about 490 nm, or about 420 nm to about 480 nm.

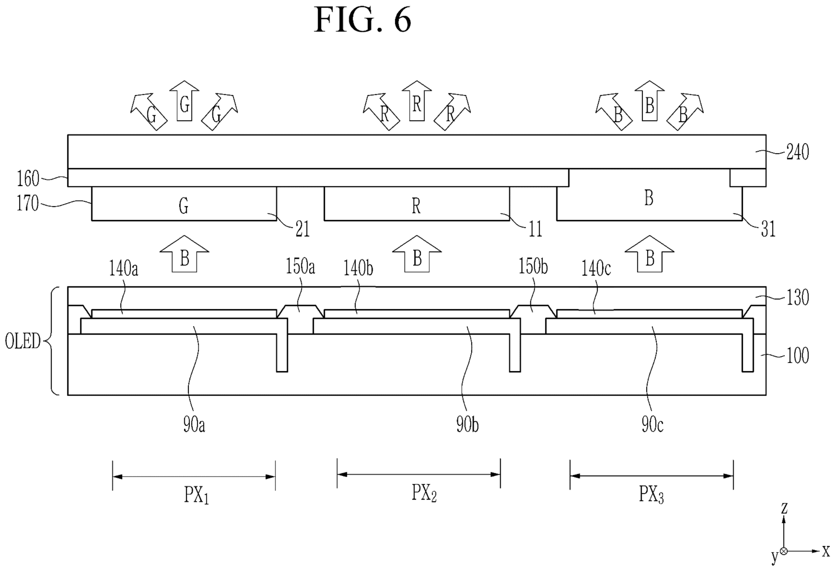

FIG. 6 is a schematic cross-sectional representation of a device (or a display panel) according to an embodiment. Referring to FIG. 6, the light source (or the light emitting panel) may include an organic light emitting diode that emits a blue light (B) (and optionally a green light (G)). The organic light emitting diode (OLED) may include at least two pixel electrodes 90a, 90b, 90c formed on the substrate 100, pixel defining layers 150a, 150b formed between the adjacent pixel electrodes 90a, 90b, 90c, organic light emitting layers 140a, 140b, 140c formed on each pixel electrode 90a, 90b, 90c, and a common electrode layer 130 formed on the organic light emitting layer 140a, 140b, 140c. A thin film transistor (TFT) and a substrate may be disposed under the organic light emitting diode (OLED), which are not shown. Pixel areas of the OLED may be disposed corresponding to the first, second, and third regions described herein. In an embodiment, the color conversion panel and the light emitting panel may be separated as shown in FIG. 6. In an embodiment, the color conversion panel may be stacked directly on the light emitting panel.

A laminated structure including the semiconductor nanoparticle composite pattern 170 (e.g., a first region 11 or R including red light emitting semiconductor nanoparticle, a second region 21 or G including green light emitting semiconductor nanoparticle, and a third region 31 or B including or not including a semiconductor nanoparticle, e.g., a blue light emitting semiconductor nanoparticle) and the substrate 240 may be disposed on the light source. The blue light emitted from the light source may enter the first region and second region and may emit a red light and a green light, respectively. The blue light emitted from the light source may pass through the third region. An element (first optical filter 160 or excitation light blocking layer) configured to block the excitation light may be disposed between the semiconductor nanoparticle composite layers R and G and the substrate, if desired. In an embodiment, the excitation light may include a blue light and a green light, and a green light blocking filter (not shown) may be added to the third region. The first optical filter or the excitation light blocking layer will be described in more detail herein.

Such a (display) device may be produced by separately producing the aforementioned laminated structure and LED or OLED (e.g., emitting a blue light) and then combining the laminated structure and LED or OLED. The (display) device may be produced by directly forming the semiconductor nanoparticle composite pattern on the LED or OLED.

In the color conversion panel or a display device, a substrate may be a substrate including an insulation material. The substrate may include glass; a polymer, such as a polyester of poly(ethylene terephthalate) (PET), poly(ethylene naphthalate) (PEN), or the like, a polycarbonate, or a polyacrylate; a polysiloxane (e.g. polydimethylsiloxane (PDMS), or the like); an inorganic material such as Al₂O₃, ZnO, or the like; or a combination thereof, but embodiments are not limited thereto. A thickness of the substrate may be appropriately selected taking into consideration a substrate material but is not particularly limited. The substrate may have flexibility. The substrate may have a transmittance of greater than or equal to about 50%, greater than or equal to about 60%, greater than or equal to about 70%, greater than or equal to about 80%, or greater than or equal to about 90% for light emitted from the semiconductor nanoparticle.

A wire layer including a thin film transistor or the like may be formed on the substrate. The wire layer may further include a gate line, a sustain voltage line, a gate insulating film, a data line, a source electrode, a drain electrode, a semiconductor layer, a protective layer, or the like. The detailed structure of the wire layer may vary depending on an embodiment. The gate line and the sustain voltage line may be electrically separated from each other, and the data line may be insulated, crossing the gate line and the sustain voltage line. The gate electrode, the source electrode, and the drain electrode may form a control terminal, an input terminal, and an output terminal of the thin film transistor, respectively. The drain electrode may be electrically connected to the pixel electrode that will be described herein.

The pixel electrode may function as an electrode (e.g., anode) of the display device. The pixel electrode may be formed of a transparent conductive material, such as indium tin oxide (ITO) or indium zinc oxide (IZO). The pixel electrode may be formed of a material having a light blocking property, such as gold (Au), platinum (Pt), nickel (Ni), tungsten (W), chromium (Cr), molybdenum (Mo), iron (Fe), cobalt (Co), copper (Cu), palladium (Pd), or titanium (Ti). The pixel electrode may have a two-layered structure where the transparent conductive material and the material having light blocking properties are stacked sequentially.

Between two adjacent pixel electrodes, a pixel define layer (PDL) may overlap with a terminal end of the pixel electrode to divide the pixel electrode into a pixel unit. The pixel define layer is an insulating layer which may electrically block the at least two pixel electrodes.

The pixel define layer may cover a portion of the upper surface of the pixel electrode, and the remaining region of the pixel electrode where it is not covered by the pixel define layer may provide an opening. An organic light emitting layer that will be described herein may be formed on the region defined by the opening.

The organic light emitting layer may define each pixel area by the aforementioned pixel electrode and the pixel define layer. In other words, one pixel area may be defined as an area where it is formed with one organic light emitting unit layer which is contacted with one pixel electrode divided by the pixel define layer. In the display device according to an embodiment, the organic light emitting layer may be defined as a first pixel area, a second pixel area, and a third pixel area, and each pixel area may be spaced apart from each other leaving a predetermined interval by the pixel define layer.

In an embodiment, the organic light emitting layer may emit a third light belonging to a visible light region or belonging to an ultraviolet (UV) region. Each of the first to the third pixel areas of the organic light emitting layer may emit a third light. In an embodiment, the third light may be a light having a higher energy in a visible light region, and for example, may be a blue light (and optionally a green light). In an embodiment, all pixel areas of the organic light emitting layer may be designed to emit the same light, and each pixel area of the organic light emitting layer may be formed of materials that are the same or similar or may show the same or similar properties. Thus, a process of forming the organic light emitting layer may be simplified, and the display device may be easily applied for, e.g., made by, a large scale/large area process. However, the organic light emitting layer according to an embodiment is not necessarily limited thereto, but the organic light emitting layer may be designed to emit at least two different lights, e.g., at least two different colored lights.

The organic light emitting layer may include an organic light emitting unit layer in each pixel area, and each organic light emitting unit layer may further include an auxiliary layer (e.g., a hole injection layer, a hole transport layer, an electron transport layer, or the like) besides the light emitting layer.

The common electrode may function as a cathode of the display device. The common electrode may be formed of a transparent conductive material, such as indium tin oxide (ITO) or indium zinc oxide (IZO). The common electrode may be formed on the organic light emitting layer and may be integrated therewith.

A planarization layer or a passivation layer (not shown) may be formed on the common electrode. The planarization layer may include a (e.g., transparent) insulating material for ensuring electrical insulation with the common electrode.

In an embodiment, the display device may further include a lower substrate, a polarizing plate disposed under the lower substrate, and a liquid crystal layer disposed between the laminated structure and the lower substrate, and in the laminated structure, the photoluminescence layer (i.e., light emitting layer) may be disposed to face the liquid crystal layer. The display device may further include a polarizing plate located between the liquid crystal layer and the light emitting layer. The light source may further include LED, and, if desired, a light guide plate.

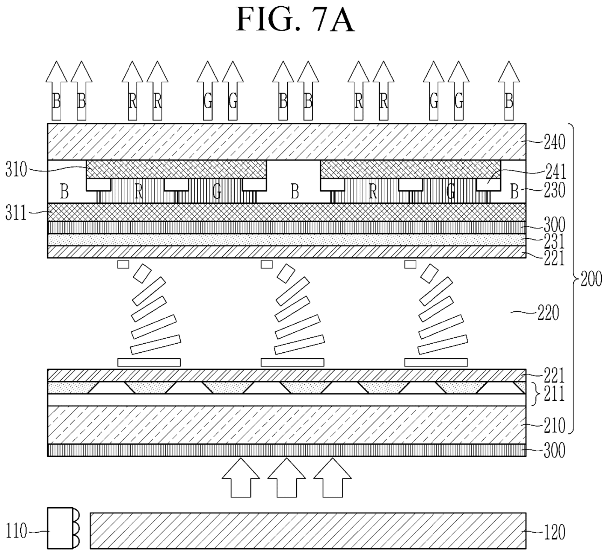

In an embodiment, the display device (e.g., a liquid crystal display device) are illustrated with a reference to a drawing. FIG. 7A is a schematic cross-sectional view showing a liquid crystal display device according to an embodiment. Referring to FIG. 7A, the display device of an embodiment may include a liquid crystal panel 200, a polarizing plate 300 disposed under the liquid crystal panel 200, and a backlight unit disposed under the polarizing plate 300.

The liquid crystal panel 200 may include a lower substrate 210, a stacked structure, and a liquid crystal layer 220 disposed between the stack structure and the lower substrate. The stack structure may include a transparent substrate 240, a first optical filter layer 310, a photoluminescent layer 230 including a pattern of a semiconductor nanoparticle polymer composite, and a second optical filter layer 311.

The lower substrate 210, also referred to as an array substrate, may be a transparent insulating material substrate. The substrate may be as described herein. A wire plate 211 may be provided on an upper surface of the lower substrate 210. The wire plate 211 may include a plurality of gate wires (not shown) and data wires (not shown) that define a pixel area, a thin film transistor disposed adjacent to a crossing region of gate wires and data wires, and a pixel electrode for each pixel area, but embodiments are not limited thereto. Details of such a wire plate are not particularly limited.

A liquid crystal layer 220 may be provided on the wire plate 211. The liquid crystal panel 200 may include an alignment layer 221 on and under the liquid crystal layer 220 to initially align the liquid crystal material included therein. Details (e.g., a liquid crystal material, an alignment layer material, a method of forming liquid crystal layer, a thickness of liquid crystal layer, or the like) of the liquid crystal layer and the alignment layer are not particularly limited.

A lower polarizing plate (or a polarizing plate) 300 may be provided under the lower substrate. Materials and structures of the polarizing plate 300 are not particularly limited. A backlight unit (e.g., emitting a blue light) may be disposed under the polarizing plate 300. An upper optical element or the polarizing plate 300 may be provided between the liquid crystal layer 220 and the transparent substrate 240, but is not limited thereto. For example, the upper polarizing plate may be disposed between the liquid crystal layer 220 and the photoluminescent layer 230. The polarizing plate may be any polarizer that can be used in a liquid crystal display device. The polarizing plate may be triacetyl cellulose (TAC) having a thickness of less than or equal to about 200 µm, but is not limited thereto. In another embodiment, the upper optical element may be a coating that controls a refractive index without a polarization function.

The backlight unit may include a light source 110. The light source may emit a blue light or a white light. The light source may include, but is not limited to, a blue LED, a white LED, a white OLED, or a combination thereof.

The backlight unit may further include a light guide plate 120. In an embodiment, the backlight unit may be of an edge type. For example, the backlight unit may include a reflector (not shown), a light guide plate (not shown) provided on the reflector and providing a planar light source to the liquid crystal panel 200, and/or at least one optical sheet (not shown) on the light guide plate, for example, a diffusion plate, a prism sheet, and the like, but the present disclosure is not limited thereto. The backlight unit may not include a light guide plate. In an embodiment, the backlight unit may be direct lighting. For example, the backlight unit may have a reflector (not shown) and a plurality of fluorescent lamps on the reflector at regular intervals, or may have an LED operating substrate on which a plurality of light emitting diodes, a diffusion plate thereon, and optionally at least one optical sheet may be disposed. Details (e.g., each component of a light emitting diode, a fluorescent lamp, a light guide plate, various optical sheets, and a reflector) of such a backlight unit are known and are not particularly limited.

A black matrix 241 may be provided under the transparent substrate 240 and may have openings and hide a gate line, a data line, and a thin film transistor of the wire plate on the lower substrate. For example, the black matrix 241 may have a grid shape. The photoluminescent layer 230 may be provided in the opening of the black matrix 241 and has a nanoparticle-polymer composite pattern including a first region R configured to emit a first light (e.g., a red light), a second region G configured to emit a second light (e.g., a green light), and a third region B configured to emit/transmit a third light, for example a blue light. If desired, the photoluminescent layer may further include at least a fourth region. The fourth region may include a quantum dot that emits light of a different color from the light emitted from the first to third regions (e.g., cyan, magenta, and yellow light).

In the photoluminescent layer 230, sections forming the pattern may be repeated corresponding to pixel areas formed on the lower substrate. A transparent common electrode 231 may be provided on the photoluminescent layer 230.

The third region (B) configured to emit/transmit a blue light may be a transparent color filter that does not change the emission spectrum of the light source. In this case, the blue light emitted from the backlight unit may enter in a polarized state and may be emitted through the polarizing plate and the liquid crystal layer as is. If needed, the third region may include a quantum dot emitting a blue light.

As described herein, if desired, the display device or light emitting device according to an embodiment may further include an excitation light blocking layer or a first optical filter layer (hereinafter, referred to as a first optical filter layer). The first optical filter layer may be disposed between the bottom surface of the first region (R) and the second region (G) and the substrate (e.g., the upper substrate 240) or on the upper surface of the substrate. The first optical filter layer may be a sheet having an opening in a portion corresponding to a pixel area (third region) displaying blue, and thus may be formed in portions corresponding to the first and second regions. That is, the first optical filter layer may be integrally formed at positions other than the position overlapped with the third region as shown in FIGS. 3A, 3B, 6 and/or 7A, but is not limited thereto. Two or more first optical filter layers may be spaced apart from each other at positions overlapped with the first and second regions, and optionally, the third region. When the light source includes a green light emitting device, a green light blocking layer may be disposed on the third region.

The first optical filter layer may block light, for example, in a predetermined wavelength region in the visible light region and may transmit light in the other wavelength regions, and for example, it may block a blue light (or a green light) and may transmit light except the blue light (or the green light). The first optical filter layer may transmit, for example, a green light, a red light, and/or a yellow light that is a mixed color thereof. The first optical filter layer may transmit a blue light and block a green light, and may be disposed on the blue light emitting pixel.

The first optical filter layer may substantially block excitation light and transmit light in a desired wavelength region. The transmittance of the first optical filter layer for the light in a desired wavelength range may be greater than or equal to about 70%, greater than or equal to about 80%, greater than or equal to about 90%, or even about 100%.

The first optical filter layer configured to selectively transmit a red light may be disposed at a position overlapped with the red light emitting section, and the first optical filter layer configured to selectively transmit a green light may be disposed at a position overlapped with the green light emitting section. The first optical filter layer may include a first filter region that blocks (e.g., absorbs) the blue light and the red light and selectively transmits light of a predetermined range (e.g., greater than or equal to about 500 nm, greater than or equal to about 510 nm, or greater than or equal to about 515 nm to less than or equal to about 550 nm, less than or equal to about 545 nm, less than or equal to about 540 nm, less than or equal to about 535 nm, less than or equal to about 530 nm, less than or equal to about 525 nm, or less than or equal to about 520 nm); a second filter region that blocks (e.g., absorbs) a blue light and a green light and selectively transmits light of a predetermined range (e.g., greater than or equal to about 600 nm, greater than or equal to about 610 nm, or greater than or equal to about 615 nm to less than or equal to about 650 nm, less than or equal to about 645 nm, less than or equal to about 640 nm, less than or equal to about 635 nm, less than or equal to about 630 nm, less than or equal to about 625 nm, or less than or equal to about 620 nm); or the first filter region and the second filter region. In an embodiment, the light source may emit a blue and a green mixed light, and the first optical filter layer may further include a third filter region that selectively transmits a blue light and blocks a green light.

The first filter region may be disposed at a position overlapped with the green light emitting section. The second filter region may be disposed at a position overlapped with the red light emitting section. The third filter region may be disposed at a position overlapped with the blue light emitting section.

The first filter region, the second filter region, and, optionally, the third filter region may be optically isolated. Such a first optical filter layer may contribute to improvement of color purity of the display device.

The display device may further include a second optical filter layer (e.g., a recycling layer of red/green light or yellow light) that is disposed between the photoluminescent layer and the liquid crystal layer (e.g., between the photoluminescent layer and the upper polarizing plate), transmits at least a portion of the third light (excitation light), and reflects at least a portion of the first light and/or the second light. The first light may be a red light, the second light may be a green light, and the third light may be a blue light. The second optical filter layer may transmit only the third light (B) in a blue light wavelength region having a wavelength region of less than or equal to about 500 nm and light in a wavelength region of greater than about 500 nm, which is green light (G), yellow light, red light (R), or the like, may be not passed through the second optical filter layer and reflected. The reflected green light and red light may pass through the first and second regions to be emitted to the outside of the display device.

The second optical filter layer or the first optical filter layer may be formed as an integrated layer having a relatively planar surface.

The first optical filter layer may include a polymer thin film including a dye and/or a pigment absorbing light in a wavelength which is to be blocked. The second optical filter layer or the first optical filter layer may include a single layer having a low refractive index, and may be, for example, a transparent thin film having a refractive index of less than or equal to about 1.4:1, less than or equal to about 1.3, or less than or equal to about 1.2. The second optical filter layer or the first optical filter layer having a low refractive index may include, for example, a porous silicon oxide, a porous organic material, a porous organic-inorganic composite, or the like, or a combination thereof.

The first optical filter layer or the second optical filter layer may include a plurality of layers having different refractive indexes. The first optical filter layer or the second optical filter layer may be formed by laminating two layers having different refractive indexes. For example, the first/second optical filter layer may be formed by alternately laminating a material having a high refractive index and a material having a low refractive index.

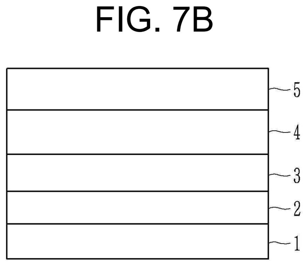

**In** an embodiment, the electronic device may include a light emitting device (e.g., an electroluminescent device) including the nanoparticles described above. FIG. 7B is a schematic cross-sectional view of a light emitting device (electroluminescent device) according to an embodiment. Referring to FIG. 7B, the light emitting device may include an anode 1 and a cathode 5 facing each other; a quantum dot light emitting layer 3 disposed between the anode and the cathode, including a plurality of quantum dots; and a hole auxiliary layer 2 located between the anode and the quantum dot light emitting layer. The hole auxiliary layer may further include a hole injecting layer (HIL), a hole transporting layer (HTL), an electron blocking layer (EBL), or a combination thereof. The hole auxiliary layer may include any organic/inorganic material having hole characteristics. The quantum dot light emitting device may further include an electron auxiliary layer 4 located between the cathode and the quantum dot light emitting layer. The electron auxiliary layer may include an electron injecting layer (EIL), an electron transporting layer (ETL), a hole blocking layer (HBL), or a combination thereof. The electron auxiliary layer may include any organic/inorganic material having electronic properties.

Hereinafter, the exemplary embodiments are illustrated in further detail with reference to examples. However, embodiments of the present disclosure are not limited to the examples.

### EXAMPLES

### Analysis Methods

### Photoluminescence Analysis

[1] A photoluminescence (PL) spectrum of the nanoparticles and a composite including the nanoparticles was obtained using a Hitachi F-7000 spectrophotometer at an excitation wavelength of 450 nm.

### ICP-AES Analysis

[2] Inductively coupled plasma atomic emission spectroscopy (ICP-AES) analysis was performed using a Shimadzu ICPS-8100.

### APT analysis

[3] A sample for APT analysis was prepared from a powder of aggregated semiconductor nanoparticles in a dried state. A needle-shaped specimen (diameter of about 50 nm) was fabricated by a FIB (Focused Ion Beam) lift-out method. The APT analysis was performed using INVIZO 6000 (CAMECA) in a UV-laser mode (laser wavelength = 257.5 nm, dual beam). A pulsed laser was irradiated onto a sample and a voltage was increased until a detection rate reached 0.01 (a magnitude of the voltage was adjusted according to a geometry of the sample). Experimental conditions were as follows: laser pulse energy = 100 to 300 pJ, temperature = 50 K, pulse repetition rate = 200 kHz, and detection rate = 0.01. For analysis of measured data, AP Suite 6.3 S/W was used. Mass peaks of constituent materials were detected to match isotope ratios. After identification (range setting) of mass peaks of constituent materials, three-dimensional reconstruction was performed.

### EELS analysis

[4] EELS analysis was performed using Gatan Quantum 966 ERS and Gatan Microscopy Suite (GMS) 3.2 operating system. A specimen was prepared by dispersing semiconductor nanoparticles in hexane to obtain a dispersion, drop-casting the dispersion onto a TEM grid having a carbon support film, and drying. HAADF-STEM imaging conditions were set to an acceleration voltage of 300 kV, a beam current of 0.1 nA, a convergence angle of 19 mrad, and a collection inner angle of 70 mrad. On the obtained specimen, an irradiation region (64×64 pixels) was selected, the specimen was scanned with an electron probe at a rate of 0.01 msec/pixel, a total of 20 frames were acquired, and data were accumulated to complete spectrum imaging. From spectrum image data, a characteristic ionization edge or characteristic X-ray peak of a specific element was extracted, reconstructed into a spatial distribution (elemental map) for each element, and quantitative analysis was performed using signal intensity.

### XPS analysis

[5] XPS analysis was performed using synchrotron-based XPS (10A2 XPS beamline). In order to control information depth, an X-ray energy was adjusted to 460 eV, 610 eV, 750 eV, 900 eV, and 1050 eV. Base pressure: UHV (ultrahigh vacuum) of 10E-9 Torr. Pass energy: 20 eV.

An X-ray of a predetermined energy was irradiated onto a sample to obtain an electronic structure spectrum corresponding to a major orbital of each element. The electronic structure spectrum for each element appears as a peak intensity (Y-axis) value at a specific binding energy (X-axis) depending on a state in the sample. Through comprehensive analysis of a position, a size, and a ratio of each elemental peak, information on chemical bonding/composition and a distribution state of components in the sample may be extracted.

### Example 1:

### Formation of a first semiconductor nanocrystal (or core)

[1] Sulfur was dissolved in oleylamine to prepare a 1 molar (M) sulfur precursor solution (hereinafter, abbreviated as "sulfur precursor"). In a 100 milliliters (mL) reaction flask, octadecene (ODE), oleylamine, silver acetate, indium acetate, and gallium acetylacetonate were added and vacuum-treated at room temperature for 10 minutes. Nitrogen gas is introduced into the reaction flask, and the sulfur precursor and dodecanethiol were added to the flask. The flask was heated to a reaction temperature of 210°C, and a reaction proceeds for 60 minutes. After decreasing the temperature of the flask to 180°C, trioctylphosphine (TOP) was added to the flask. Afterward, the mixture was cooled to room temperature and ethanol (a non-solvent) were added to facilitate precipitation. The obtained first semiconductor nanocrystals (or core) were separated and recovered by centrifugation and re-dispersed in toluene.

The molar ratio of the silver precursor, the indium precursor, the gallium precursor, and the sulfur precursor used was 0.8:0.9:1.25:4.

### Formation of Second semiconductor nanocrystal

[2] Gallium bromide (hereinafter referred to as a first gallium halide) was dissolved in trioctylphosphine to prepare a 1 molar (M) gallium precursor solution. A dispersion of a silver compound was prepared by dispersing a silver compound (silver acetate, 0.06 M) in oleylamine.

In a flask, dimethylthiourea (DMTU) as a first sulfur precursor, oleylamine, and octadecene were added, and vacuum-treated at 120°C for 10 minutes. After the introduction of nitrogen into the reaction flask, the mixture was heated to 240°C (first injection temperature), followed by an addition of the first gallium halide. After 10 minutes, a first semiconductor nanocrystal and the dispersion of the silver compound were added, and then, the reaction mixture was heated to 260°C (reaction temperature) and reacted for 70 minutes (first reaction time). A temperature of the reaction solution was lowered to 180 °C, trioctylphosphine was added, and then the reaction solution was cooled to room temperature. A non-solvent (ethanol) was added to the reaction solution at room temperature to promote precipitation of the produced semiconductor nanoparticle, and the obtained semiconductor nanoparticle was recovered by centrifugation and dispersed in toluene.

The silver compound was used in an amount of 3.45 mole percent relative to the gallium precursor, that is, a mole ratio of Ag:Ga of 0.0345:1. A mole ratio of the gallium precursor to the sulfur precursor used was 0.75:1 (gallium precursor:sulfur precursor).

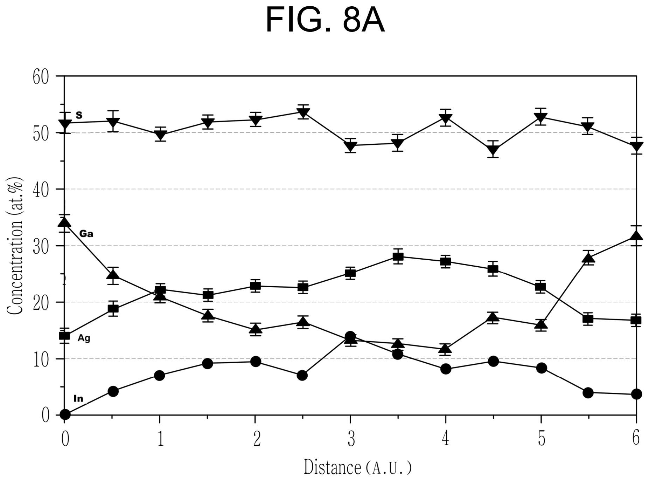

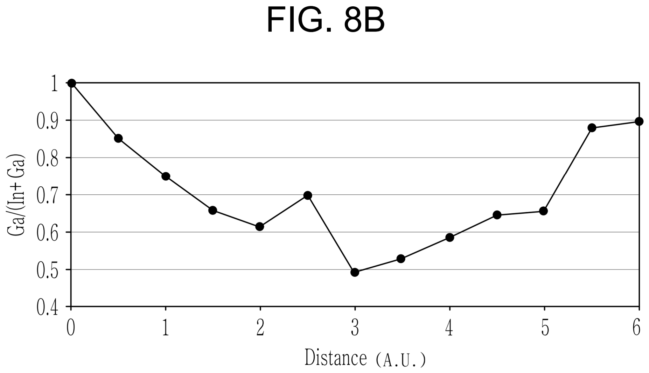

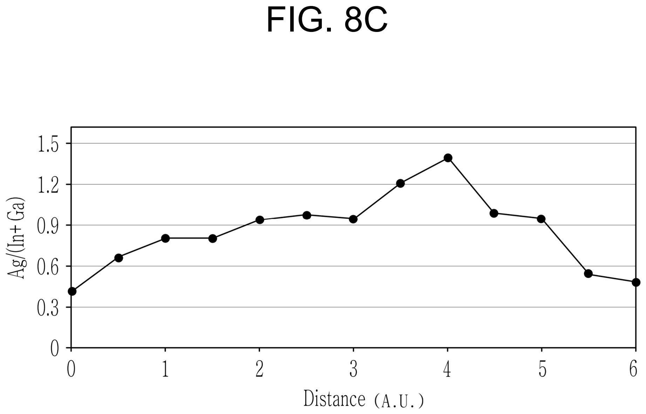

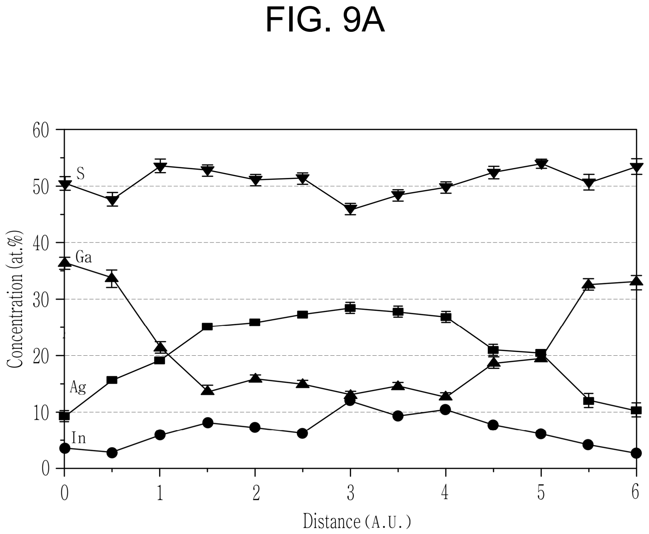

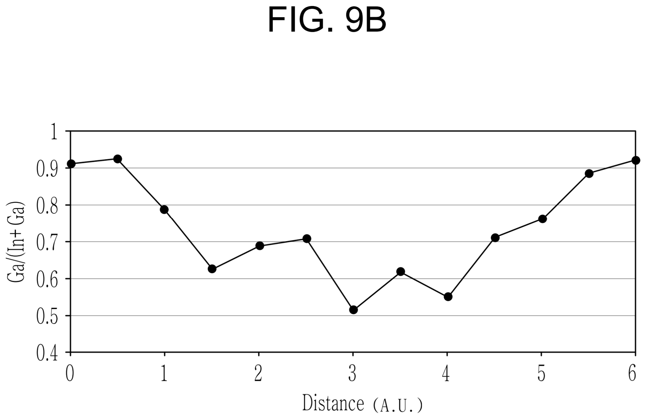

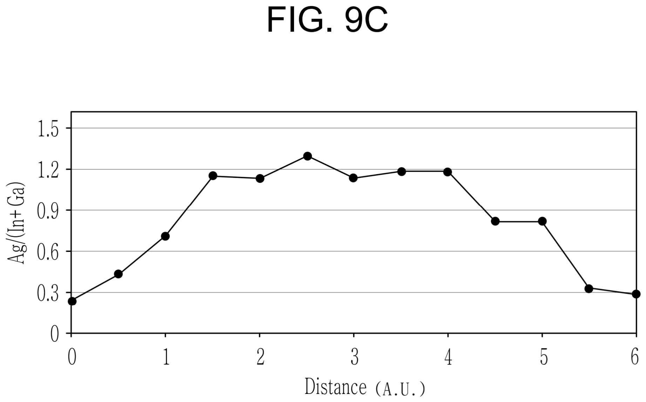

[3] APT analysis and EELS analysis were performed on the prepared semiconductor nanoparticles, and the results are shown in FIG. 8A, FIG. 8B, and FIG. 8C, FIG. 9A, FIG. 9B, and FIG. 9C, and FIG. 10A. In the figures, the x-axis represents a relative distance (a.u., arbitrary units) along a line extending from one surface of a nanoparticle to an opposite surface thereof, passing through a center region of the nanoparticle.

From the plotted elemental concentration data, it may be confirmed that in the semiconductor nanoparticle of the Example, a mole ratio of gallium to a total of indium and gallium has a maximum value in a first zone spaced apart from a center of the nanoparticle, and in the first zone, a mole ratio of silver to a total of indium and gallium is greater than or equal to about 0.18:1.

[4] Quantum energy of the prepared first semiconductor nanocrystal and the prepared semiconductor nanoparticle was analyzed by XPS analysis, and the results are summarized in Table 1 and Table 2, respectively.

**Table 1: first semiconductor nanocrystal**

| Photon energy (eV) | Ga/(In+Ga) | Ag/(In+Ga) |
|---|---|---|
| 460 | 0.563 | 0.50 |
| 610 | 0.522 | 0.50 |
| 750 | 0.465 | 0.48 |
| 900 | 0.457 | 0.51 |
| 1050 | 0.444 | 0.56 |

**Table 2: semiconductor nanoparticle**

| Photon energy (eV) | Ga/(In+Ga) | Ag/(In+Ga) |
|---|---|---|
| 460 | 0.887 | 0.44 |
| 610 | 0.870 | 0.61 |
| 750 | 0.850 | 0.64 |
| 900 | 0.840 | 0.69 |
| 1050 | 0.818 | 0.79 |

### Example 2:

### Formation of a first semiconductor nanocrystal (or core)

[1] A first semiconductor nanocrystal was prepared in the same manner as in Example 1.

### Formation of a second semiconductor nanocrystal

[2] Gallium bromide (hereinafter, a first gallium halide) was dissolved in a trioctylphosphine solution to prepare a 1 M solution. A silver compound (silver acetate 0.06 M) was dispersed in oleylamine to prepare a dispersion of the silver compound.

Dimethylthiourea (DMTU) as a sulfur precursor, oleylamine, and octadecene were placed in a flask and vacuum-treated at 120 °C for 10 minutes. After the introduction of nitrogen into the reaction flask, the temperature was raised to 240 °C (a first temperature), a first gallium halide was added and maintained for 10 minutes. Subsequently, the first semiconductor nanocrystal and the dispersion of the silver compound were added, the reactor was heated to a reaction temperature (greater than or equal to about 260 °C), and reacted for 170 minutes. The temperature of the reaction solution was cooled to room temperature, a non-solvent (ethanol) was added to the reaction solution to promote precipitation of the produced intermediate particle, and the obtained intermediate particle was recovered by centrifugation and dispersed in toluene.

[3] Gallium bromide (hereinafter, a second gallium halide) was dissolved in a trioctylphosphine solution to prepare a 1 M solution. A silver compound (silver acetate 0.06 M) was dispersed in oleylamine to prepare a dispersion of the silver compound.

Dimethylthiourea (DMTU) as a sulfur precursor, oleylamine, and octadecene were placed in a flask and vacuum-treated at 120 °C for 10 minutes. After the introduction of nitrogen into the reaction flask, the temperature was raised to 280 °C (reaction temperature), the second gallium halide, the intermediate particle, and the dispersion of the silver compound were added, and reacted for 95 minutes. The temperature of the reaction solution was lowered to 180 °C, trioctylphosphine was added, and then cooled to room temperature. A non-solvent (ethanol) was added to the reaction solution to promote precipitation of the produced semiconductor nanoparticle, and the obtained semiconductor nanoparticle was recovered by centrifugation and dispersed in toluene.

The silver compound was used in an amount of 5.2 mole percent (or Ag:Ga of 0.052:1) relative to the second gallium halide. A mole ratio of the second gallium halide to the second sulfur precursor used was 0.75:1 (second gallium halide:sulfur precursor).

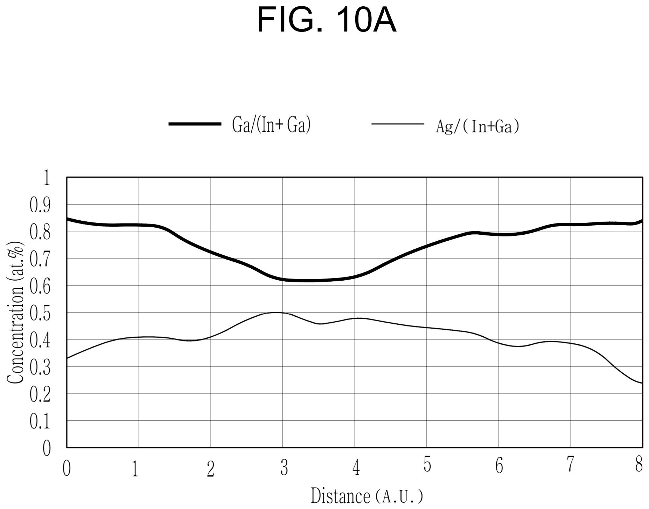

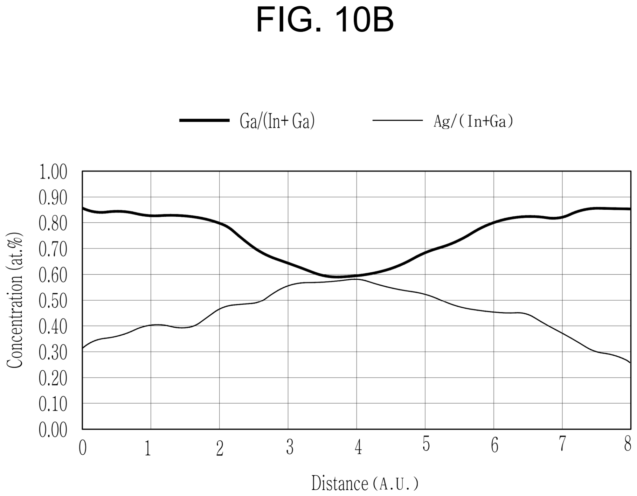

[4] EELS analysis was performed on the prepared semiconductor nanoparticle, and the results are summarized in FIG. 10B. In the figure, the x-axis represents a relative distance (a.u.) along a line extending from one surface of a nanoparticle to an opposite surface thereof, passing through a center region of the nanoparticle. From the results of FIG. 10B, it may be confirmed that, in the semiconductor nanoparticle of Example 2, a mole ratio of gallium to a total of indium and gallium has a maximum value in a first zone spaced apart from a center of the nanoparticle, and in the first zone, a mole ratio of silver to the total of indium and gallium is greater than or equal to about 0.18:1.

### Comparative Example 1

### Formation of a first semiconductor nanocrystal (or core)

[1] A first semiconductor nanocrystal was prepared in the same manner as in Example 1.

### Formation of a second semiconductor nanocrystal

[2] A semiconductor nanoparticle was prepared in the same manner as in Example 1, except that injection of precursors was performed as follows:
Dimethylthiourea (DMTU) as a sulfur precursor, oleylamine, and octadecene were placed in a flask and vacuum-treated at 120 °C for 10 minutes. After the introduction of nitrogen into the reaction flask, the temperature was raised to 240 °C (a first temperature), the first semiconductor nanocrystal and the first gallium halide were added, the reactor was heated to 260 °C (reaction temperature), and reacted for 70 minutes.

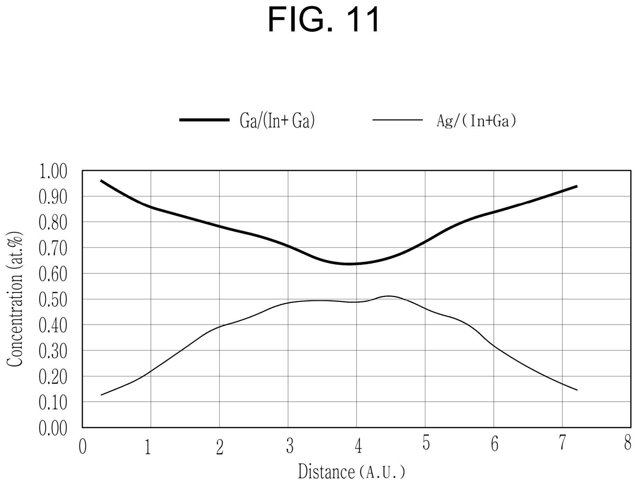

[3] EELS analysis was performed on the prepared semiconductor nanoparticle, and the results are shown in FIG. 11. In the figure, the x-axis represents a relative distance (a.u.) along a line extending from one surface of a nanoparticle to an opposite surface thereof, passing through a center region of the nanoparticle. From the results, it may be confirmed that, in the semiconductor nanoparticle of the Comparative Example 1, a mole ratio of gallium to a total of indium and gallium has a maximum value in a first zone spaced apart from a center of the nanoparticle, but in the first zone, a mole ratio of silver to the total of indium and gallium is less than about 0.18:1.

### Experimental Example 1

ICP-AES analysis and photoluminescence analysis were performed on the semiconductor nanoparticles prepared from Example 1, Example 2, and Comparative Example 1, and the results are summarized in Table 3 and Table 4.

**Table 3**

| | ICP mole ratio | | | | | |
|---|---|---|---|---|---|---|
| | S:In | Ag:In | Ga:In | Ag:(In+Ga) | Ga:(Ga+In) | Ag:(Ag+In+Ga) |
| Example 1 | 8.77:1 | 3.26:1 | 3.88:1 | 0.67:1 | 0.80:1 | 0.400:1 |
| Example 2 | 37.94:1 | 14.75:1 | 19.10:1 | 0.78:1 | 0.95:1 | 0.423:1 |
| Comparative Example 1 | 14.55:1 | 5.12:1 | 6.85:1 | 0.65:1 | 0.87:1 | 0.395:1 |

**Table 4**

| | PL peak (nm) | PLQY |
|---|---|---|
| Example 1 | 527 | 85.1% |
| Example 2 | 530 | 89.7% |
| Comparative Example 1 | 528 | 81.9% |

| | | |
|---|---|---|
| PLQY: quantum yield | | |

From the results of Table 4, it may be confirmed that the semiconductor nanoparticles of Examples 1 and 2 have improved greater quantum yields compared to those of Comparative Example 1.

In an embodiment, a semiconductor nanoparticle includes silver, indium, gallium, and sulfur, and as a radial concentration distribution of individual elements (e.g., the silver, indium, and gallium) in the semiconductor nanoparticle is measured, thesemiconductor nanoparticle exhibits a maximum value of a mole ratio of gallium to a total of indium and gallium (hereinafter, also referred to as Ga:(In+Ga)) in a first zone (e.g., spaced apart from a center thereof), and in the first zone, a mole ratio of silver to the total of indium and gallium (hereinafter, also referred to as Ag:(In+Ga)) is greater than or equal to about 0.18:1. The mole ratio of silver to the total of indium and gallium may be less than or equal to about 1.5:1. The semiconductor nanoparticle exhibits a quantum yield of greater than or equal to about 85%.

In the first zone, the maximum value of the mole ratio of gallium to the total of indium and gallium (Ga:(In+Ga)) may be greater than or equal to about 0.75:1, greater than or equal to about 0.8:1, or greater than or equal to about 0.82:1. The maximum value of the mole ratio of gallium to the total of indium and gallium may be less than or equal to about 0.99:1 or less than or equal to about 0.95:1. The maximum value of the mole ratio of gallium to the total of indium and gallium (Ga:(In+Ga)) may be greater than or equal to about 0.8:1, greater than or equal to about 0.82:1, and less than about 1:1, or less than or equal to about 0.98:1.

In the first zone, the mole ratio of silver to the total of indium and gallium may be greater than or equal to about 0.19:1. In the first zone, the mole ratio of silver to the total of indium and gallium may be greater than or equal to about 0.2:1 or greater than or equal to about 0.25:1. The mole ratio of silver to the total of indium and gallium may be less than or equal to about 1.5:1, less than or equal to about 1.4:1, less than or equal to about 1.3:1, less than or equal to about 1.2:1, less than or equal to about 1:1, less than or equal to about 0.9:1, or less than or equal to about 0.5:1. In the first zone, the mole ratio of silver to the total of indium and gallium may be greater than or equal to about 0.19:1 and less than or equal to about 1:1. In the first zone, the mole ratio of silver to the total of indium and gallium may be greater than or equal to about 0.2:1 and less than or equal to about 0.9:1.

The mole ratio of silver to the total of indium and gallium in the first zone may be less than the mole ratio of silver to the total of indium and gallium at the center of the semiconductor nanoparticle.

A difference between a maximum value of the mole ratio of silver to the total of indium and gallium in the particle and the mole ratio of silver to the total of indium and gallium in the first zone may be greater than or equal to about 0.05:1, greater than or equal to about 0.1:1, greater than or equal to about 0.3:1, or greater than or equal to about 0.5:1. The difference between the maximum value of the mole ratio of silver to the total of indium and gallium in the particle and the mole ratio of silver to the total of indium and gallium in the first zone may be less than or equal to about 0.9:1, less than or equal to about 0.6:1, less than or equal to about 0.3:1, or less than or equal to about 0.1:1.

In the first zone, a difference between the maximum value of Ga:(In+Ga) and Ag:(In+Ga) may be greater than or equal to about 0.1:1, greater than or equal to about 0.3:1, or greater than or equal to about 0.5:1. In the first zone, the difference between the maximum value of Ga:(In+Ga) and Ag:(In+Ga) may be less than or equal to about 0.9:1, less than or equal to about 0.8:1, or less than or equal to about 0.6:1.

The semiconductor nanoparticle may include a core (e.g., a first semiconductor nanocrystal) including silver, indium, gallium, and sulfur and a semiconductor nanocrystal shell disposed on the core and including silver, gallium, and sulfur (e.g., a second semiconductor nanocrystal including silver, gallium, and sulfur).

The core may have a radius of greater than or equal to about 0.5 nm, or greater than or equal to about 1 nm and less than or equal to about 2.5 nm, less than or equal to about 2 nm, or less than or equal to about 1.75 nm. **In** the core, the mole ratio of gallium to the total of indium and gallium may be greater than or equal to about 0.35:1, or greater than or equal to about 0.4:1 and less than or equal to about 0.8:1, or less than or equal to about 0.6:1.

As a concentration distribution of individual elements (e.g., the silver, indium, and gallium) in a radial direction (e.g., from a center of the core to a surface of the semiconductor nanoparticle), in the core, a minimum value of the mole ratio of gallium to the total of indium and gallium in the core may be greater than or equal to about 0.1:1, greater than or equal to about 0.3:1, greater than or equal to about 0.5:1, or greater than or equal to about 0.6:1. In the core, the minimum value of the mole ratio of gallium to the total of indium and gallium may be less than or equal to about 0.85:1 or less than or equal to about 0.75:1. **In** the core, the minimum value of the mole ratio of gallium to the total of indium and gallium may exist in a portion within a radius of less than or equal to about 1 nm, less than or equal to about 0.5 nm, or less than or equal to about 0.3 nm from the center of the core.

**In** the shell, the mole ratio of gallium to the total of indium and gallium may be greater than or equal to about 0.6:1 or greater than or equal to about 0.7:1. In the shell, the mole ratio of gallium to the total of indium and gallium may be less than or equal to about 1:1 or less than or equal to about 0.99:1.

The shell may have a thickness of greater than or equal to about 0.5 nm and less than or equal to about 4 nm.

The first zone may exist in the shell.

**In** the semiconductor nanoparticle, the mole ratio of gallium to the total of indium and gallium may be greater than or equal to about 0.79:1, or greater than or equal to about 0.85:1 and less than or equal to about 0.99:1, or less than or equal to about 0.95:1.

**In** the semiconductor nanoparticle, the mole ratio of silver to the total of indium and gallium may be greater than or equal to about 0.5:1, greater than or equal to about 0.6:1, greater than or equal to about 0.66:1, and less than or equal to about 1.5:1, less than or equal to about 1:1, or less than or equal to about 0.95:1.

In the semiconductor nanoparticle, the mole ratio of silver to a total of indium, gallium, and silver may be greater than or equal to about 0.4:1 and less than or equal to about 0.5:1.

The semiconductor nanoparticle may exhibit a quantum yield of greater than or equal to about 86% or greater than or equal to about 88%.

The semiconductor nanoparticle may be configured to emit first light, and the first light may have a peak emission wavelength of greater than or equal to about 500 nm and less than or equal to about 560 nm.

An emission spectrum of the first light may have a full width at half maximum of greater than or equal to about 5 nm and less than or equal to about 50 nm, or less than or equal to about 35 nm.

In an embodiment, an ink composition includes the semiconductor nanoparticle and a liquid vehicle. A population of the semiconductor nanoparticles may be dispersed in the liquid vehicle. The liquid vehicle may include a polymerizable monomer, an organic solvent, or a combination thereof. The ink composition may not substantially include a volatile organic solvent. The ink composition may further include a metal oxide nanoparticle.

In an embodiment, a semiconductor nanoparticle polymer composite includes a polymer matrix and the semiconductor nanoparticle dispersed in the polymer matrix. The composite may be a patterned film. The composite may be a sheet in which a first semiconductor nanoparticle configured to emit first light and a second semiconductor nanoparticle configured to emit second light (different from the first light) are mixed.

The semiconductor nanoparticle polymer composite may be configured such that an internal quantum efficiency or an external quantum efficiency defined by the following equation is greater than or equal to about 50%: $Internal quantum efficiency \left(%\right) = \left[A/\left(B-B′\right)\right] \times 100$ $External quantum efficiency \left(%\right) = \left[A/B\right] \times 100$
A: an amount of first light emitted from the semiconductor nanoparticle or composite
B: an amount of incident light provided to the composite
B': an amount of incident light passing through the composite

The semiconductor nanoparticle polymer composite may be configured such that an absorbance defined by the following equation is greater than or equal to about 90%: $Absorbance \left(%\right) = \left[\left(B-B′\right)/B\right] \times 100$
B: an amount of incident light provided to the composite
B': an amount of incident light passing through the composite

The semiconductor nanoparticle polymer composite may have a process retention rate defined by the following equation of greater than or equal to about 75% or greater than or equal to about 80% when heat-treated at 180 °C for 30 minutes under a nitrogen atmosphere: 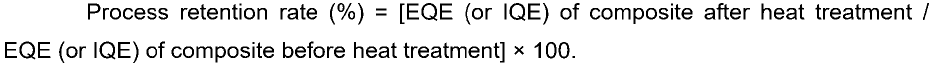 Process retention rate (%) = [EQE (or IQE) of composite after heat treatment / EQE (or IQE) of composite before heat treatment] × 100.

The process retention rate may range from about 77% to about 130%, from about 81% to about 100%, or a combination thereof.

In an embodiment, provided is a color conversion layer or a color conversion structure (hereinafter, abbreviated as a color conversion layer) including the semiconductor nanoparticle or a color conversion region including the semiconductor nanoparticle. In an embodiment, a color conversion panel includes a color conversion layer including a color conversion region, the color conversion region corresponds to a first pixel and includes a first region including the semiconductor nanoparticle, the semiconductor nanoparticle includes silver, indium, gallium, and sulfur, and as a radial concentration distribution of the individual elements (e.g., silver, indium, and gallium) in the semiconductor nanoparticle is measured, the semiconductor nanoparticle exhibits a maximum value of a mole ratio of gallium to a total of indium and gallium (Ga:(In+Ga)) in a first zone (e.g., spaced apart from a center of the nanoparticle), and in the first zone, a mole ratio of silver to the total of indium and gallium (Ag:(In+Ga)) is greater than or equal to about 0.18:1. The semiconductor nanoparticle may exhibit a quantum yield of greater than or equal to about 85%.

A first region may include a first composite configured to emit first light, and the first composite may include a matrix and the semiconductor nanoparticle dispersed in the matrix.

Details of the semiconductor nanoparticle are as described herein.

In an embodiment, a display device (or display panel) includes the semiconductor nanoparticle (or a composite, a color conversion layer, or a color conversion panel including the same). The display device may further include a light source (or a light emitting panel). The display device may further include a light transmitting layer (or an optical element) between the light source (or the light emitting panel) and the color conversion layer (or the color conversion panel).

The light emitting panel (or the light source) may be configured to provide incident light to the color conversion layer (or the color conversion panel). The incident light may include blue light and optionally green light. The blue light may have a peak wavelength in a range of about 440 nm to about 460 nm or about 450 nm to about 455 nm.

The light source may include an organic light emitting diode, a micro LED, a mini LED, a nanorod-including LED, or a combination thereof.

In an embodiment, an electronic device (or display device) includes the color conversion panel or the display panel.

In an embodiment, the electronic device or the display device may include a display device for an augmented reality/virtual reality device, a mobile terminal device, a monitor, a notebook, a television, an electronic board, a camera, or an automotive electronic component.

While this disclosure has been described in connection with what is presently considered to be practical embodiments, it is to be understood that the present subject matter is not limited to the disclosed exemplary embodiments. On the contrary, it is intended to cover various modifications and equivalent arrangements included within the scope of the appended claims.

## Claims

1. A semiconductor nanoparticle comprising silver, indium, gallium, and sulfur,
wherein as a radial concentration distribution of silver, indium, and gallium in the semiconductor nanoparticle is measured, a mole ratio of gallium to a total of indium and gallium exhibits a maximum value in a first zone of the semiconductor nanoparticle, and wherein in the first zone of the semiconductor nanoparticle, a mole ratio of silver to the total of indium and gallium is greater than or equal to 0.18:1 and less than or equal to 1.5:1.

2. The semiconductor nanoparticle of claim 1,
wherein a quantum yield of the semiconductor nanoparticle is greater than or equal to about 85%; and/or
wherein the maximum value of the mole ratio of gallium to the total of indium and gallium is greater than or equal to 0.8:1 and less than 1:1.

3. The semiconductor nanoparticle of claim 1 or claim 2,
wherein, in the first zone, the mole ratio of silver to the total of indium and gallium is greater than or equal to 0.19:1 and less than or equal to 1:1.

4. The semiconductor nanoparticle of any preceding claim,
wherein, in the first zone, the mole ratio of silver to the total of indium and gallium is greater than or equal to 0.2:1 and less than or equal to 0.9:1.

5. The semiconductor nanoparticle of any preceding claim,
wherein the mole ratio of silver to the total of indium and gallium in the first zone is less than a mole ratio of silver to a total of indium and gallium at a center portion of the semiconductor nanoparticle.

6. The semiconductor nanoparticle of any preceding claim,
wherein the semiconductor nanoparticle comprises a core comprising silver, indium, gallium, and sulfur, and a semiconductor nanocrystal shell disposed on the core, the semiconductor nanocrystal shell comprising silver, gallium, and sulfur, and wherein the first zone is present in the semiconductor nanocrystal shell,
and optionally wherein: the core has a radius of greater than or equal to 0.5 nm and less than or equal to 1.75 nm;
and in the core, the mole ratio of gallium to the total of indium and gallium is greater than or equal to 0.4:1 and less than or equal to 0.8:1.

7. The semiconductor nanoparticle of claim 6,
wherein, as an amount of individual elements is measured in a radial direction, in the core, a mole ratio of gallium to the total of indium and gallium exhibits a minimum value at a center portion of the core, and the minimum value is greater than or equal to 0.1:1 and less than or equal to 0.85:1.

8. The semiconductor nanoparticle of claim 6 or 7,
wherein, in the semiconductor nanocrystal shell, a mole ratio of gallium to the total of indium and gallium is greater than or equal to 0.6:1 and less than or equal to 1:1.

9. The semiconductor nanoparticle of any of claims 6 to 8,
wherein in the first zone, the mole ratio of silver to the total of indium and gallium is greater than or equal to 0.2:1.

10. The semiconductor nanoparticle of any preceding claim,
wherein, in the semiconductor nanoparticle, the mole ratio of gallium to the total of indium and gallium is greater than or equal to 0.86:1 and less than or equal to 0.99:1.

11. The semiconductor nanoparticle of any preceding claim,
wherein, in the semiconductor nanoparticle, the mole ratio of silver to the total of indium and gallium is greater than or equal to 0.5:1 and less than or equal to 1.5:1.

12. The semiconductor nanoparticle of any preceding claim,
wherein a quantum yield of the semiconductor nanoparticle is greater than or equal to 88%.

13. The semiconductor nanoparticle of any preceding claim,
wherein the semiconductor nanoparticle is configured to emit first light, and the first light has a peak emission wavelength of greater than or equal to 500 nm and less than or equal to 560 nm,
and optionally wherein an emission spectrum of the first light has a full width at half maximum of greater than or equal to 5 nm and less than or equal to 50 nm.

14. A color conversion panel comprising a color conversion layer comprising a color conversion region,
wherein the color conversion region corresponds to a first pixel and comprises a first region comprising a semiconductor nanoparticle according to any preceding claim.

15. A display device comprising a semiconductor nanoparticle according to any of claims 1 to 13.
